(19) Europäisches Patentamt
European Patent Office
Office européen des brevets

(11) **EP 4 685 207 A1**

(12) **EUROPEAN PATENT APPLICATION**

(43) Date of publication:
**28.01.2026 Bulletin 2026/05**

(21) Application number: **25191015.4**

(22) Date of filing: **22.07.2025**

(51) International Patent Classification (IPC):
***C09K 11/02** (2006.01)* ***C09K 11/08** (2006.01)*
***C09K 11/88** (2006.01)* ***H05B 33/10** (2006.01)*
***H05B 33/18** (2006.01)*

(52) Cooperative Patent Classification (CPC):
**C09K 11/02; C09K 11/0811; C09K 11/883; H05B 33/10; H05B 33/18**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **23.07.2024 KR 20240097312**

(71) Applicants:
- **Samsung Electronics Co., Ltd.**
  **Suwon-si, Gyeonggi-do 16677 (KR)**
- **Samsung Display Co., Ltd.**
  **Yongin-si, Gyeonggi-do 17113 (KR)**

(72) Inventors:
- **CHANG, Hogeun**
  **16678 Suwon-si (KR)**
- **KATO, Fumiaki**
  **16678 Suwon-si (KR)**
- **KIM, Kwang Hee**
  **16678 Suwon-si (KR)**
- **KIM, Ju Hyun**
  **16678 Suwon-si (KR)**
- **MIN, Ji Hyun**
  **16678 Suwon-si (KR)**
- **LEE, Jae Yong**
  **16678 Suwon-si (KR)**
- **HA, Hyundong**
  **16678 Suwon-si (KR)**

(74) Representative: **Elkington and Fife LLP**
**Prospect House**
**8 Pembroke Road**
**Sevenoaks, Kent TN13 1XR (GB)**

(54) **SEMICONDUCTOR NANOPARTICLE, PRODUCTION METHOD THEREOF, ELECTROLUMINESCENT DEVICE, PRODUCTION METHOD THEREOF, AND DISPLAY INCLUDING THE SAME**

(57) A semiconductor nanoparticle, a method for preparing the semiconductor nanoparticle, an ink composition including the semiconductor nanoparticle, an electroluminescent device, and a display device including the semiconductor nanoparticle. The semiconductor nanoparticle is configured to emit light and includes a semiconductor nanocrystal and a semiconductor nanocrystal layer including zinc and sulfur. The semiconductor nanoparticle further includes a first compound and a second compound. The first compound includes a first functional group and an aromatic hydrocarbon group or an aliphatic hydrocarbon group having a terminal double bond. The second compound includes a second functional group and an aliphatic hydrocarbon group. The first functional group and the second functional group each independently include a carboxylic acid or its anion.

FIG. 1

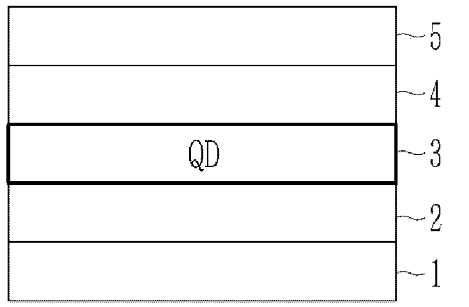


EP 4 685 207 A1

## Description

FIELD OF THE INVENTION

The present disclosure relates to a semiconductor nanoparticle, a method for preparing the semiconductor nanoparticle, an ink composition including the semiconductor nanoparticle, an electroluminescent device including the semiconductor nanoparticle, and a display device including the semiconductor nanoparticle.

BACKGROUND OF THE INVENTION

A semiconductor nanoparticle (e.g., a quantum dot) having a nanoscale size may exhibit a luminescent property. For example, a quantum dot including a semiconductor nanocrystal may exhibit a quantum confinement effect. Light emission of the semiconductor nanoparticle may be generated when electrons in an excited state transition from a conduction band to a valence band by, for example, light excitation or voltage application. The semiconductor nanoparticle may be configured to emit light in a desired wavelength region by controlling a size thereof, a composition thereof, or a combination thereof. The semiconductor nanoparticles may be used in various light emitting devices (e.g., electroluminescent devices) and display devices.

SUMMARY OF THE INVENTION

An embodiment relates to a semiconductor nanoparticle.
An embodiment relates to an ink composition including the semiconductor nanoparticle and a solvent.
An embodiment relates to a method for preparing the semiconductor nanoparticle.
An embodiment relates to a light emitting device (e.g., an electroluminescent device) that emits light by itself when a voltage is applied to the semiconductor nanoparticle (e.g., a quantum dot).
An embodiment relates to a display device (e.g., a quantum dot (QD)-light emitting diode (LED) display) including nanocrystalline particles (e.g., quantum dots) as a light emitting material in a red pixel, a green pixel, a blue pixel, or a combination thereof.
In an embodiment, a semiconductor nanoparticle is configured to emit light (e.g., first light) in response to an external stimulus,

the semiconductor nanoparticle includes a semiconductor nanocrystal including zinc and selenium; and a semiconductor nanocrystal layer including zinc and sulfur on the semiconductor nanocrystal,
the semiconductor nanoparticle further includes a first compound and a second compound,
the first compound includes a first functional group; and an aromatic hydrocarbon group, or an aliphatic hydrocarbon group, the aliphatic hydrocarbon group having a terminal double bond,
the second compound includes a second functional group and an aliphatic hydrocarbon group,
the first functional group and the second functional group each independently include a carboxylic acid or an anion of the carboxylic acid (e.g., a carboxylate),
in gas chromatography-mass spectrometry (GC-MS) of the semiconductor nanoparticle, the first compound and the second compound exhibit a first peak and a second peak, respectively, a retention time of the second peak is greater than a retention time of the first peak,
and a ratio of an area of the first peak to an area of the second peak is greater than or equal to about 0.1:1, or greater than or equal to about 0.15:1 and less than or equal to about 3:1, or less than or equal to about 1.4:1.

The ratio of an area of the first peak to an area of the second peak may be greater than or equal to about 0.2:1, or greater than or equal to about 0.25:1 and less than or equal to about 2:1, or less than or equal to about 0.15:1.
The semiconductor nanocrystal may include a first semiconductor nanocrystal.
The semiconductor nanocrystal (e.g., the first semiconductor nanocrystal) may optionally further include tellurium.
The semiconductor nanoparticle may include or may not include cadmium, lead, or a combination thereof.
The semiconductor nanoparticle may be configured to emit a first light.
The first light may have a red light spectrum, a green light spectrum, or a blue light spectrum.
The semiconductor nanoparticle may be configured to emit blue light. The first light or the blue light may have a peak emission wavelength greater than or equal to about 440 nanometers (nm) and less than or equal to about 480 nm.
The semiconductor nanoparticle may be configured to emit green light. The first light or the green light may have a peak emission wavelength greater than about 480 nm and less than or equal to about 580 nm.
The semiconductor nanoparticle may be configured to emit red light. The first light or the red light may have a peak

emission wavelength greater than or equal to about 600 nm and less than or equal to about 680 nm.

The semiconductor nanoparticle may have a core-shell structure having a core and a shell disposed on the core. The semiconductor nanoparticle or the core may include a first semiconductor nanocrystal. The core or the first semiconductor nanocrystal may include a Group II-VI compound including zinc, selenium, and optionally tellurium, or a Group III-V compound including indium and phosphorus. The semiconductor nanocrystal layer may be disposed on the first semiconductor nanocrystal.

The core or the semiconductor nanocrystal (e.g., the first semiconductor nanocrystal) may include a first semiconductor nanocrystal including a zinc selenide, a zinc tellurium selenide, or a combination thereof. The shell may include the semiconductor nanocrystal layer (or an outer layer).

The semiconductor nanoparticle, the core, or the first semiconductor nanocrystal may include a zinc selenide, a zinc tellurium selenide, an indium phosphide, an indium zinc sulfide, a copper indium sulfide, a silver indium sulfide, a silver indium gallium sulfide, or a combination thereof.

The semiconductor nanoparticle may further include silver, indium, copper, or a combination thereof.

The shell may include a second zinc chalcogenide including zinc, selenium, and optionally sulfur, or a second semiconductor nanocrystal (or an intermediate shell layer) including the second zinc chalcogenide.

In the semiconductor nanoparticle, the second semiconductor nanocrystal (or intermediate shell layer) may be disposed on the first semiconductor nanocrystal (or the core) or between the first semiconductor nanocrystal (e.g., the core) and the semiconductor nanocrystal layer (e.g., the outer layer).

The semiconductor nanocrystal layer may include a third zinc chalcogenide including zinc and sulfur (e.g., zinc sulfide), or a third semiconductor nanocrystal including the third zinc chalcogenide. The shell may include the second semiconductor nanocrystal (or an intermediate shell layer including the second semiconductor nanocrystal) and the third semiconductor nanocrystal (or a semiconductor nanocrystal layer or outer layer including the third semiconductor nanocrystal). The second zinc chalcogenide may have a composition different from that of the third zinc chalcogenide. The second zinc chalcogenide may include or may not include sulfur. The third zinc chalcogenide may further include or may not include selenium.

A molecular weight of the second compound may be greater than a molecular weight of the first compound.

The first compound may have a molecular weight greater than or equal to about 150 grams per mole (g/mol), or greater than or equal to about 160 g/mol and less than or equal to about 500 g/mol. The first compound may have a molecular weight greater than or equal to about 165 g/mol, or greater than or equal to about 190 g/mol and less than or equal to about 400 g/mol.

The second compound may have a molecular weight greater than or equal to about 180 g/mol and less than or equal to about 600 g/mol. The second compound may have a molecular weight greater than or equal to about 260 g/mol and less than or equal to about 550 g/mol.

A difference in molecular weight between the first compound and the second compound may be greater than or equal to about 90 g/mol and less than or equal to about 150 g/mol.

The first compound may further include a linker connecting the first functional group and the aromatic hydrocarbon group. The linker may include a substituted or unsubstituted hydrocarbon group (L) having greater than or equal to about C3, greater than or equal to about C4, greater than or equal to about C6, or greater than or equal to about C8, and less than or equal to about C20, less than or equal to about C19, or less than or equal to about C10. The linker may include a substituted or unsubstituted C5-C10 hydrocarbon group. The hydrocarbon group (L) may be an aliphatic, aromatic, or alicyclic hydrocarbon group. In the hydrocarbon group (L), one or more methylene group may be replaced with CO, O, COO, S, SO, SOO, NH, NHCO, or a combination thereof. The hydrocarbon group (L) may further include a double bond in its chain.

The first compound may include a substituted or unsubstituted phenylhexanoic acid, a substituted or unsubstituted phenylhexanoate, a substituted or unsubstituted phenylpentanoic acid, a substituted or unsubstituted phenylpentanoate, a substituted or unsubstituted phenylbutanoic acid, a substituted or unsubstituted phenylbutanoate, a substituted or unsubstituted phenylisopropanoic acid, a substituted or unsubstituted phenylisopropanoate, a substituted or unsubstituted phenylpropanoic acid, a substituted or unsubstituted phenylpropanoate, a substituted or unsubstituted 9-decenonic acid, a substituted or unsubstituted 9-decenonate, a substituted or unsubstituted 10-undecenonic acid, a substituted or unsubstituted 10-undecenonate, a substituted or unsubstituted 11-dodecenonic acid, a substituted or unsubstituted 11-dodecenonate, or a combination thereof. The first compound may further include a metal ion (e.g., zinc).

The second compound may include an oleic acid, an oleate, a myristic acid, a myristate, a stearic acid, a stearate, a lauric acid, a laurate, or a combination thereof.

A peak area ratio of the second compound to the first compound may be greater than or equal to about 0.2:1, or greater than or equal to about 0.25:1 and less than or equal to about 2:1, or less than or equal to about 0.15:1.

The semiconductor nanoparticle may have an organic content of greater than or equal to about 9.5 wt%, or greater than or equal to about 10 wt% and less than or equal to about 25 wt%, or less than or equal to about 13 wt%, as determined by thermogravimetric analysis.

The semiconductor nanoparticle may have a residue content at 550°C, as determined by thermogravimetric analysis, based on the total weight of the semiconductor nanoparticle, of greater than or equal to about 86%, 86.5%, or 87%, and less than or equal to about 90%, 88.5%, or 88.1%.

In the semiconductor nanoparticle, a chlorine content may be less than or equal to about 1 mol%, based on a total elemental content.

The semiconductor nanoparticle may have a chlorine content, based on a total mole number of sulfur, of less than or equal to about 10%, less than or equal to about 9%, less than or equal to about 8%, less than or equal to about 7%, less than or equal to about 6%, or less than or equal to about 5%.

The semiconductor nanoparticle may have a chlorine content, based on a total mole number of selenium, of less than or equal to about 10%, less than or equal to about 9%, less than or equal to about 8%, less than or equal to about 7%, less than or equal to about 6%, less than or equal to about 5%, less than or equal to about 4%, less than or equal to about 3%, or less than or equal to about 2%.

The semiconductor nanoparticle may have a size (or an average size, hereinafter referred to as size) greater than or equal to about 9 nm, greater than or equal to about 10 nm, greater than or equal to about 10.5 nm, greater than or equal to about 11 nm, greater than or equal to about 11.5 nm, or greater than or equal to about 12 nm and less than or equal to about 50 nm, less than or equal to about 15 nm, less than or equal to about 13 nm, less than or equal to about 12.5 nm, less than or equal to about 12 nm, or less than or equal to about 11.5 nm. The size may be a diameter or an equivalent diameter.

The semiconductor nanoparticles may have an average particle size of less than or equal to about 45 nm, or less than or equal to about 30 nm.

The semiconductor nanoparticle may be configured to exhibit a quantum yield of greater than or equal to about 80%. The semiconductor nanoparticle may be configured to exhibit a full width at half maximum of less than or equal to about 50 nm. The absolute quantum yield of the semiconductor nanoparticle may be greater than or equal to about 82%, or greater than or equal to about 90%. The absolute quantum yield of the semiconductor nanoparticle may be from about 84% to about 100%, from about 90% to about 99%, from about 91% to about 98%, from about 92% to about 97%, or from about 93% to about 96%. The absolute quantum yield of the semiconductor nanoparticle may be greater than or equal to about 80% or greater than or equal to about 88%. The full width at half maximum of the semiconductor nanoparticle may be less than or equal to about 49 nm. The full width at half maximum of the semiconductor nanoparticle may be less than or equal to about 47 nm.

In an embodiment, an ink composition includes a semiconductor nanoparticle and a solvent, and in the semiconductor nanoparticle, a Hansen solubility parameter distance (Ra) of the first compound and the second compound with respect to the solvent that is greater than 0 and less than or equal to about 4, and the Ra satisfies the following equation:

$$Ra^2 = 4\,(\delta D_1 - \delta D_2)^2 + (\delta P_1 - \delta P_2)^2 + (\delta H_1 - \delta H_2)^2$$

Ra: Hansen solubility parameter distance
$\delta D_1$: dispersion solubility parameter of moieties, excluding a COO group, of the first compound and the second compound
$\delta D_2$: the dispersion solubility parameter of the solvent
$\delta P_1$: polar solubility parameter of moieties excluding a COO group of the first compound and the second compound
$\delta P_2$: polar solubility parameter of the solvent
$\delta H_1$: hydrogen bond parameter of moieties, excluding a COO group, of the first compound and the second compound
$\delta H_2$: hydrogen bond parameter of the solvent.

The Hansen solubility parameter distance, Ra, may be greater than or equal to about 1, or from about 1.5 to about 3.

The solvent may include a substituted or unsubstituted C5-C40 cycloaliphatic (or alicyclic) hydrocarbon solvent, a substituted or unsubstituted C1-C40 (or C5-C30) aliphatic hydrocarbon solvent, a substituted or unsubstituted C6-C50 aromatic hydrocarbon solvent, a substituted or unsubstituted C5-C40 aliphatic ester solvent, or a combination thereof.

The solvent may include cyclohexylbenzene, hexadecane, octylbenzene, 1,3,5-triisopropylbenzene, ethyldodecanoate, decylcyclohexane, or a combination thereof.

The solvent may have a boiling point of greater than or equal to about 200°C and less than or equal to about 350°C.

In an embodiment, a method of manufacturing the semiconductor nanoparticle includes:
preparing the semiconductor nanocrystal (or a first particle including the semiconductor nanocrystal); and heating a reaction medium including the semiconductor nanocrystal, a zinc precursor, a sulfur precursor, a first compound, and a second compound in an organic solvent (e.g., to a reaction temperature) to form a semiconductor nanocrystal layer

including zinc and sulfur on the semiconductor nanocrystal (e.g., on at least a portion of a surface of the semiconductor nanocrystal or the first particle).

The forming of the semiconductor nanocrystal layer may include:

heating a first medium including the semiconductor nanocrystal, the zinc precursor, the sulfur precursor, and the second compound to a reaction temperature; and
adding the first compound to the first medium.

In an embodiment, the method may include adding the first particle, a second zinc precursor, and a sulfur precursor to the organic solvent, and the second zinc precursor may include the second compound.

The method may further include adding the first compound to the reaction medium or the organic solvent.

The addition of the first compound may be made at a temperature of greater than or equal to about 180°C and less than the reaction temperature (e.g., a second temperature), for example, greater than or equal to about 190°C to less than or equal to about 300°C, greater than or equal to about 200°C to less than or equal to about 290°C, greater than or equal to about 210°C to less than or equal to about 280°C, or a combination thereof.

The addition of the first compound may be conducted at a temperature of greater than or equal to about a boiling point of the first compound. The second temperature may be greater than or equal to about the boiling point of the first compound.

A used amount of the first compound used may be greater than or equal to about 0.1 mole per 1 mole of the second zinc precursor, or greater than or equal to about 0.2 mole, and less than or equal to about 5 mole, or less than or equal to about 1 mole.

The first compound may further include a metal (e.g., zinc), and the first compound further including the metal may be obtained by a reaction between a metal compound (e.g., a metal acetate) and the first compound in the form of a carboxylic acid.

Details of the first compound and the second compound are the same as set forth herein.

In an embodiment, an electroluminescent device includes an emission layer, and the emission layer includes the semiconductor nanoparticle.

The electroluminescent device may further include a first electrode (e.g., an anode) and a second electrode (e.g., a cathode). The emission layer may be disposed between the first electrode and the second electrode. The electroluminescent device may further include a hole transport layer, an electron transport layer, or both. The emission layer may be disposed between the hole transport layer and the electron transport layer.

The hole transport layer may be disposed between the emission layer and the first electrode. The electron transport layer may be disposed between the emission layer and the second electrode.

A hole auxiliary layer (e.g., hole transport layer) may include poly(9,9-dioctyl-fluorene-co-N-(4)-butylphenyl)-diphenylamine) (TFB), polyarylamine, poly(N-vinylcarbazole), poly(3,4-ethylenedioxythiophene) (PEDOT), poly(3,4-ethylenedioxythiophene) polystyrene sulfonate (PEDOT:PSS), polyaniline, polypyrrole, N,N,N',N'-tetrakis(4-methoxyphenyl)-benzidine (TPD), 4,4'-bis[N-(1-naphthyl)-N-phenyl-amino]biphenyl ($\alpha$-NPD), m-MTDATA (4,4',4"-Tris[phenyl(m-tolyl)amino]triphenylamine), 4,4',4"-tris(N-carbazolyl)-triphenylamine (TCTA), 1,1-bis[(di-4-toylamino)phenylcyclohexane (TAPC), NiO, $WO_3$, $MoO_3$, a graphene, a graphene oxide, or a combination thereof.

An electron auxiliary layer (e.g., the electron transport layer) may include 1,4,5,8-naphthalene-tetracarboxylic dianhydride (NTCDA), bathocuproine (BCP), tris[3-(3-pyridyl)-mesityl]borane (3TPYMB), LiF, tris(8-hydroxyquinoline) aluminum ($Alq_3$), tris(8-hydroxyquinoline)gallium ($Gaq_3$), tris-(8-hydroxyquinoline)indium ($Inq_3$), bis(8-hydroxyquinoline) zinc ($Znq_2$), bis(2-(2-hydroxyphenyl)benzothiazolate)zinc ($Zn(BTZ)_2$), bis(10-hydroxybenzo[h]quinolinato)beryllium ($BeBq_2$), 8-(4-(4,6-di(naphthalen-2-yl)-1,3,5-triazin-2-yl)phenyl)quinolone (ET204), 8-hydroxyquinolinato lithium (Liq), a zinc oxide nanoparticle, a n-type doped zinc metal oxide nanoparticle or zinc oxide nanoparticle, a hafnium oxide nanoparticle, or a combination thereof.

The semiconductor nanoparticle or the emission layer may have a chlorine content less than or equal to about 10% based on the total mole number of sulfur.

An embodiment relates to a method of manufacturing an electroluminescent device, the method comprising: obtaining the ink composition; disposing the emission layer including the semiconductor nanoparticle on the first electrode; and disposing the second electrode on the emission layer.

The method may further include disposing a hole transport layer on the first electrode.

The formation of the emission layer may include applying the ink composition on the first electrode or the hole transport layer to obtain a film, and removing at least a portion of the solvent from the film.

The emission layer may further include or may not include the solvent. The emission layer may further include or may not include octane, cyclohexane, cyclohexylbenzene, hexadecane, octylbenzene, 1,3,5-triisopropylbenzene, ethyldodecanoate, decylcyclohexane, or a combination thereof.

An embodiment relates to an electronic device or a display device including the electroluminescent device or the

semiconductor nanoparticle.

The display device or the electronic device may include a virtual reality display device, an augmented reality display device, a wearable device, a portable terminal device, a monitor, a computer, a sensor, a television, an electronic display board, a camera, or an automotive electronic component.

According to an embodiment, semiconductor nanoparticles having enhanced properties with controlled dispersibility can be manufactured by a relatively simple method. When included in a light emitting device, the semiconductor nanoparticles according to an embodiment may contribute to improvement in the properties of the device (e.g., enhancement of lifetime characteristics).

## BRIEF DESCRIPTION OF THE DRAWINGS

FIG. 1 is a schematic cross-sectional view of a quantum dot light-emitting diode (QD LED) device according to an embodiment.

FIG. 2 is a schematic cross-sectional view of a QD LED device according to another embodiment.

FIG. 3 is a schematic cross-sectional view of a QD LED device according to another embodiment.

FIG. 4 is a schematic cross-sectional view of a QD LED device according to another embodiment.

FIG. 5 is a schematic cross-sectional view of a light emitting device (red-green-blue (RGB) pixel) according to an embodiment.

FIG. 6 is a schematic front view of a display panel according to an embodiment.

FIG. 7 is a schematic cross-sectional view of the display panel of FIG. 6 taken along line IV-IV.

FIG. 8 shows the results of gas chromatography-mass spectrometry analysis illustrating intensity (Counts, %) versus Acquisition Time (i.e., retention time, RT) (minutes, min) of the semiconductor nanoparticle prepared in Preparation Example 3-2.

FIG. 9A is a graph illustrating the change in Hansen solubility parameter distance according to the variation in a mole ratio of the first compound and the second compound included in the semiconductor nanoparticle, in relation to a dispersion including the semiconductor nanoparticle according to an embodiment and a predetermined solvent in Experimental Example 1.

FIG. 9B is a graph illustrating the change in Hansen solubility parameter distance according to the variation in a mole ratio of the first compound and the second compound included in the semiconductor nanoparticle, in relation to a dispersion including the semiconductor nanoparticle according to an embodiment and a predetermined solvent (mixed solvent) in Experimental Example 1.

FIG. 10 is a diagram showing the result of Experimental Example 2 (fabrication and evaluation of HOD device).

## DETAILED DESCRIPTION OF THE EMBODIMENTS

Hereinafter, with reference to the accompanying drawings, various embodiments of the present disclosure will be described in detail so that those of ordinary skill in the art can easily carry out the present disclosure. The present disclosure may be embodied in many different forms and is not limited to the embodiments described herein.

In order to clearly explain the present disclosure, parts irrelevant to the description are omitted, and the same reference numerals are assigned to the same or similar elements throughout the specification.

The size and thickness of each constituent element as shown in the drawings are randomly indicated for better understanding and ease of description, and this disclosure is not necessarily limited to as shown. In the drawings, the thickness of layers, films, panels, regions, or the like, are exaggerated for clarity. And in the drawings, for convenience of description, the thickness of some layers and regions are exaggerated.

In addition, it will be understood that when an element such as a layer, film, region, or substrate is referred to as being "on" another element, it can be directly on the other element or intervening elements may also be present. In contrast, when an element is referred to as being "directly on" another element, there are no intervening elements present. Also, to be disposed "on" the reference portion means to be disposed above or below the reference portion, and does not necessarily mean "above" in an opposite direction of gravity.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to

be limiting. As used herein, the singular forms "a," "an," and "the" are intended to include the plural forms, including "at least one," unless the content clearly indicates otherwise. Therefore, reference to "an" element in a claim followed by reference to "the" element is inclusive of one element as well as a plurality of the elements.

"At least one" is not to be construed as limiting "a" or "an." "Or" means "and/or." As used herein, the term "and/or" includes any and all combinations of one or more of the associated listed items.

It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

In the specification, "cross-section" may mean a cross-section viewed from the side that is cut generally vertically (e.g., substantially vertically to the bottom surface) through the target portion.

Further, the singular includes the plural unless mentioned otherwise.

In the drawings, the thickness of layers, films, panels, regions, or the like, are exaggerated for clarity. Like reference numerals designate like elements throughout the specification.

As used herein, values of a work function, a conduction band, or a lowest unoccupied molecular orbital (LUMO) (or valence band, or highest occupied molecular orbital (HOMO)) energy level is expressed as an absolute value from a vacuum level. In addition, a deep, a high, or large work function or energy level means that the absolute value is large when the vacuum level is set to "0 electron volts (eV)," and a shallow, low, or small work function or energy level means that the absolute value is small when the vacuum level is set to "0 eV."

In an embodiment, the work function may refer to a minimum energy required to remove an electron from a solid metal (e.g., the metal surface) to a vacuum (e.g., the portion just outside the solid surface).

The average may be mean or median. In an embodiment, the average is the mean.

As used herein, the term "peak emission wavelength" is the wavelength at which a given emission spectrum of the light reaches its maximum.

As used herein, when a definition is not otherwise provided, "Group" in the term Group I, Group II, Group III and the like refers to a group of the periodic table of elements.

As used herein, "Group I" may include Group IA and Group IB, and examples may be Li, Na, K, Rb, and Cs, but are not limited thereto.

As used herein, "Group II" may include Group IIA and Group IIB, and examples of Group II metal may be Cd, Zn, Hg, and Mg, but are not limited thereto.

As used herein, "Group III" may include Group IIIA and Group IIIB, examples of Group III metals may be, but are not limited to, Al, In, Ga, and Tl.

As used herein, "Group IV" may include Group IVA and Group IVB, and examples of a Group IV metal may be Si, Ge, and Sn, but are not limited thereto. As used herein, "metal" may include a semi-metal such as Si.

"Group V" may include Group VA and examples may be, but are not limited to, nitrogen, phosphorus, arsenic, antimony, and bismuth.

As used herein, "Group VI" may include Group VIA, and examples may be sulfur, selenium, tellurium, but are not limited thereto.

As used herein, when a definition is not otherwise provided, "substituted" refers to replacement of, e.g., at least one hydrogen of a compound or the corresponding moiety by a substituent that may be a C1 to C30 alkyl group, a C2 to C30 alkenyl group, a C2 to C30 alkynyl group, a C6 to C30 aryl group, a C7 to C30 alkylaryl group, a C1 to C30 alkoxy group, a C1 to C30 heteroalkyl group, a C3 to C30 heteroaryl group, a C3 to C30 cycloalkyl group, a C3 to C15 cycloalkenyl group, a C6 to C30 cycloalkynyl group, a C2 to C30 heterocycloalkyl group, a halogen (-F, -Cl, -Br, or -I), a hydroxy group (-OH), a nitro group ($-NO_2$), a cyano group (-CN), an amino group (-NRR' wherein R and R' are independently hydrogen or a C1 to C6 alkyl group), an azido group ($-N_3$), an amidino group ($-C(=NH)NH_2$), a hydrazino group ($-NHNH_2$), a hydrazono group ($=N(NH_2)$), an aldehyde group (-C(=O)H), a carbamoyl group ($-C(O)NH_2$), a thiol group (-SH), an ester group (-C(=O)OR, wherein R is a C1 to C6 alkyl group or a C6 to C12 aryl group), a carboxyl group (-COOH) or a salt thereof (-C(=O)OM, wherein M is an organic or inorganic cation), a sulfonic acid group ($-SO_3H$) or a salt thereof ($-SO_3M$, wherein M is an organic or inorganic cation), a phosphoric acid group ($-PO_3H_2$) or a salt thereof ($-PO_3MH$ or $-PO_3M_2$, wherein M is an organic or inorganic cation), or a combination thereof.

As used herein, when a definition is not otherwise provided, the hydrocarbon group refers to a group including carbon and hydrogen (e.g., an aliphatic group such as alkyl, alkenyl, or alkynyl group, or an aromatic group such as aryl group). The hydrocarbon group may be a group having a monovalence or more formed by removal of one or more hydrogen atoms from alkane, alkene, alkyne, or arene. In the hydrocarbon group, at least one methylene may be replaced by an oxide moiety, a carbonyl moiety, an ester moiety, -NH-, or a combination thereof. Unless otherwise stated to the contrary, the hydrocarbon (alkyl, alkenyl, alkynyl, or aryl) group may have 1 to 60, 2 to 32, 3 to 24, or 4 to 12 carbon atoms.

As used herein, when a definition is not otherwise provided, "alkyl" refers to a linear or branched saturated monovalent hydrocarbon group (methyl, ethyl hexyl, or the like).

As used herein, when a definition is not otherwise provided, "alkenyl" refers to a linear or branched monovalent hydrocarbon group having one or more carbon-carbon double bond.

As used herein, when a definition is not otherwise provided, "alkynyl" refers to a linear or branched monovalent hydrocarbon group having one or more carbon-carbon triple bond.

As used herein, when a definition is not otherwise provided, "aryl" refers to a group formed by removal of a, e.g., at least one, hydrogen from an aromatic hydrocarbon (e.g., a phenyl or naphthyl group).

As used herein, when a definition is not otherwise provided, "hetero" refers to one including 1 to 3 heteroatoms of N, O, S, Si, P, or a combination thereof.

As used herein, when a definition is not otherwise provided, "alkoxy" means alkyl group linked via an oxygen (i.e., alkyl-O-), such as a methoxy, ethoxy, or sec-butyloxy group.

As used herein, when a definition is not otherwise provided, an "amine group" may be -NRR, wherein Rs are independently hydrogen, a C1 to C12 alkyl group, a C7 to C20 alkylaryl group, a C7 to C20 arylalkyl group, or a C6 to C18 aryl group.

As used herein, the expression "not including cadmium (or other harmful heavy metal)" may refer to the case in which a concentration of cadmium (or another corresponding heavy metal) may be less than or equal to about 100 parts per million by weight (ppmw), less than or equal to about 50 ppmw, less than or equal to about 10 ppmw, less than or equal to about 1 ppmw, less than or equal to about 0.1 ppmw, less than or equal to about 0.01 ppmw, almost zero, or zero (e.g., undetectable by current methods). In an embodiment, substantially no cadmium, its salt (or other heavy metal or its salt) is present or, if present, in an amount or impurity level below the detection limit of a given detection tool (e.g., an inductively coupled plasma atomic emission spectroscopy instrument).

"About" or "substantially" or "approximately" as used herein is inclusive of the stated value and means within an acceptable range of deviation for the particular value as determined by one of ordinary skill in the art, considering the measurement in question and the errors associated with the corresponding measurement of the particular quantity (i.e., the limitations of the measurement system).

For example, "substantially" or "approximately" can mean within $\pm$ 10%, 5%, 3%, or 1% or within standard deviation of the stated value.

As used herein, a nanoparticle refers to a structure having a, e.g., at least one, region or characteristic dimension with a nanoscale dimension. In an embodiment, a dimension (or an average dimension) of the nanostructure is less than or equal to about 500 nm, less than or equal to about 300 nm, less than or equal to about 250 nm, less than or equal to about 150 nm, less than or equal to about 100 nm, less than or equal to about 50 nm, or less than or equal to about 30 nm. Such a nanoparticle may have any shape.

The nanoparticle (e.g., a semiconductor nanoparticle or a metal oxide nanoparticle) may include a nanowire, a nanorod, a nanotube, a branched nanostructure, a nanotetrapod, a nanotripod, a nanobipod, a nanodot, a multi-pod type shape having such as at least two pods, or the like and is not limited thereto. The nanoparticle can be, e.g., substantially crystalline, substantially monocrystalline, polycrystalline, (for example, at least partially) amorphous, or a combination thereof.

For example, a semiconductor nanoparticle such as a quantum dot may exhibit quantum confinement or exciton confinement. In the present specification, the term "nanoparticle or quantum dot" is not limited in its shape unless specifically defined. A semiconductor nanoparticle, such as a quantum dot, may have a size smaller than a diameter of Bohr excitation in the bulk crystal of the same material, and may exhibit a quantum confinement effect. Quantum dots may emit light corresponding to bandgap energies thereof by controlling the size of the nanocrystals as the emission center.

As used herein, the term "T50" is a time (hours, hr) the brightness (e.g., luminance) of a given device decreases to 50% of the initial brightness (100%) as, e.g., when, the given device is started to be driven, e.g., operated, at a predetermined initial brightness (e.g., 650 nit or 146 nit).

As used herein, the term "T90" is a time (hr) the brightness (e.g., luminance) of a given device decreases to 90% of the initial brightness (100%) as the given device is started to be driven at a predetermined initial brightness (e.g., 650 nit or 146 nit).

As used herein, external quantum efficiency (EQE) refers to a ratio of the number of photons emitted from a light emitting diode (LED) to the number of electrons passing through the device. EQE may be criteria of how efficiently the light emitting diode converts the electrons into the photons and allows them to escape. In an embodiment, EQE may be

determined based on the following equation:

$$EQE = [\text{Injection efficiency}] \times [\text{Solid state quantum yield}] \times [\text{Extraction efficiency}]$$

Injection efficiency = proportion of electrons passing through the device that are injected into the active region;
Solid state quantum yield = proportion of all electron-hole recombinations in the active region that are radiative and thus, produce photons; and
Extraction efficiency = proportion of photons generated in the active region that escape from the device.

As used herein, the maximum external quantum efficiency refers to the maximum value of the external quantum efficiency.

As used herein, the maximum luminance refers to a maximum value of luminance that the device can achieve.

As used herein, quantum efficiency is a term used interchangeably with quantum yield. Quantum efficiency (or quantum yield) may be measured either in solution or in the solid state (in a composite). In an embodiment, quantum efficiency (or quantum yield) is the ratio of photons emitted to photons absorbed by the nanostructure or population thereof. In an embodiment, quantum efficiency may be measured by any method. For example, for fluorescence quantum yield or efficiency, there may be two methods: an absolute method and a relative method.

In the absolute method, quantum efficiency is obtained by detecting the fluorescence of all samples through an integrating sphere. In the relative method, the quantum efficiency of the unknown sample is calculated by comparing the fluorescence intensity of a standard dye (standard sample) with the fluorescence intensity of the unknown sample. Coumarin 153, Coumarin 545, Rhodamine 101 inner salt, Anthracene and Rhodamine 6G may be used as standard dyes according to their photoluminescence (PL) wavelengths, but the present disclosure is not limited thereto.

Unless otherwise stated, numerical ranges stated herein are inclusive.

Unless mentioned to the contrary, a numerical range recited herein includes any real number within the endpoints of the stated range and includes the endpoints thereof. In this specification, a numerical endpoint or an upper or lower limit value (e.g., recited either as a "greater than or equal to value" "at least value" or a "less than or equal to value" or recited with "from" or "to") may be used to form a numerical range of a given feature. In other words, the upper and lower endpoints set forth for various numerical values may be independently combined to provide a range. In an embodiment, the "dispersion" may be one in which the dispersed phase is a solid and the continuous medium includes a liquid.

In an embodiment, "dispersion" may refer to a colloidal dispersion wherein the dispersed phase has a dimension of greater than or equal to about 1 nm, for example, greater than or equal to about 2 nm, greater than or equal to about 3 nm, greater than or equal to about 4 nm, greater than or equal to about 5 nm, or greater than or equal to about 10 nm and several micrometers (μm) or less, (e.g., less than or equal to about 2 μm, or less than or equal to about 1 μm, less than or equal to about 900 nm, less than or equal to about 800 nm, less than or equal to about 700 nm, less than or equal to about 600 nm, or less than or equal to about 500 nm).

A bandgap energy of the semiconductor nanoparticle may be changed according to a size, a structure, and a composition of nanocrystal. For example, as the size of the quantum dot increases, the quantum dot may have a narrow bandgap energy and an increased emission wavelength. The semiconductor nanocrystal has drawn attention as light emitting materials in various fields of a display device, an energy device, or a bio light emitting device.

Semiconductor nanoparticles having an electroluminescent property at a practically applicable level may include harmful heavy metals such as cadmium (Cd), lead, mercury, or a combination thereof. It is desirable to provide a semiconductor nanoparticle that emits light of a desired wavelength while being substantially free of the harmful heavy metals. In addition, from an environmental point of view, it is desirable to provide a light emitting device or a display device having a light emitting layer based on the semiconductor nanoparticle that does not include cadmium, a harmful heavy metal.

A semiconductor nanoparticle according to an embodiment is environmentally friendly, can emit blue light of a desired wavelength with improved luminous efficiency, and can exhibit improved stability in the external environment. An electroluminescent device according to an embodiment is a self-emissive light emitting device that includes the semiconductor nanoparticle and is configured to emit desired light by voltage application with or without a separate light source. The light emitting device and display device of an embodiment are desirable from an environmental point of view.

Research is currently underway to explore the utilization of an inkjet printing method for the formation of the emission layer in an electroluminescent device including a semiconductor nanoparticle in the emission layer. An ink composition comprising a semiconductor nanoparticle for application in an inkjet printing method may include a predetermined solvent and the semiconductor nanoparticle. There is a technical demand for an ink composition that can be ejected from a print head of an inkjet printing apparatus and deposited on a desired substrate (e.g., an electrode or a charge transport layer) to form an emission layer of desired quality. A semiconductor nanoparticle of an embodiment and

an ink composition including the semiconductor nanoparticle are applicable to an electroluminescent device or to the manufacture thereof.

In an embodiment, the semiconductor nanoparticle is configured to emit first light. The semiconductor nanoparticle includes a semiconductor nanocrystal layer including zinc and sulfur, and the semiconductor nanoparticle may further include a first compound and a second compound (e.g., bound to the semiconductor nanocrystal layer). The first compound includes a first functional group; and a substituted or unsubstituted aromatic hydrocarbon group or a substituted or unsubstituted aliphatic hydrocarbon group having a terminal double bond, and the second compound includes a second functional group; and a substituted or unsubstituted aliphatic hydrocarbon group. The first functional group may include a carboxylic acid or its anion (e.g., a carboxylate group). The second functional group may include a carboxylic acid or its anion (e.g., a carboxylate group).

The first compound and the second compound (e.g., the first functional group and the second functional group) may be bound to the semiconductor nanoparticle or the semiconductor nanocrystal layer. In gas chromatography-mass spectrometry (GC-MS) of the semiconductor nanoparticle (e.g., with respect to the semiconductor nanoparticle), the first compound and the second compound exhibit a first peak and a second peak, respectively, and a retention time of the second peak is greater than a retention time of the first peak. A ratio of an area of the first peak to an area of the second peak is greater than or equal to about 0.1:1 and less than or equal to about 3:1.

The first light may be blue light, green light, or red light.

In an embodiment, the electroluminescent device includes an emission layer (light emitting layer) 3 including the semiconductor nanoparticle. The electroluminescent device may further include a first electrode 1 and a second electrode 5 that are spaced apart (e.g., facing each other). The electroluminescent device may further include a hole auxiliary layer 2, an electron auxiliary layer 4, or both. The emission layer 3 may be disposed between the first electrode 1 and the second electrode 5. The emission layer 3 may be disposed between the hole auxiliary layer 2 and an electron auxiliary layer 4. The hole auxiliary layer 2 may be disposed between the first electrode (e.g., an anode) 1 and the emission layer 3. The electron auxiliary layer 4 may be disposed between the second electrode (e.g., a cathode) 5 and the emission layer 3 (see FIG. 1). The semiconductor nanoparticle or the emission layer may include or may not include cadmium, mercury, or lead.

The first electrode 1 may include an anode, and the second electrode 5 may include a cathode. Alternatively, the first electrode 1 may include a cathode, and the second electrode 5 may include an anode. The electroluminescent device may further include a hole auxiliary layer 2 between the emission layer 3 and the first electrode 1. The electroluminescent device may further include an electron auxiliary layer 4 between the emission layer 3 and the second electrode 5.

In an embodiment of the electroluminescent device, the first electrode 10 or the second electrode 50 may be disposed on a (transparent) substrate 100. The transparent substrate 100 may be a light extraction surface (see FIGs. 2 and 3).

Referring to FIGS. 2 and 3, the light emitting layer 30 may be disposed between the first electrode (e.g., anode) 10 and the second electrode (e.g., cathode) 50. The second electrode or cathode 50 may include an electron injection conductor. The first electrode or anode 10 may include a hole injection conductor. The work functions of the electron/hole injection conductors included in the second electrode 50 and the first electrode 10 may be appropriately adjusted and are not particularly limited. For example, the second electrode 50 may have a small work function and the first electrode 10 may have a relatively large work function, or vice versa.

The electron/hole injection conductors may include a metal-containing material (e.g., a metal, a metal compound, an alloy, or a combination thereof) (such as aluminum, magnesium, tungsten, nickel, cobalt, platinum, palladium, calcium, LiF, or the like), a metal oxide such as gallium indium oxide or indium tin oxide (ITO), or a conductive polymer (e.g., having a relatively high work function) such as polyethylene dioxythiophene, but are not limited thereto.

At least one of the first electrode and the second electrode may be a light transmitting electrode or a transparent electrode. In an embodiment, both the first electrode and the second electrode may be a light transmitting electrode. The electrode(s) may be patterned. The first electrode and/or the second electrode may be disposed on a (e.g., insulating) substrate 100. The substrate 100 may be optically transparent (e.g., may have a light transmittance of greater than or equal to about 50%, greater than or equal to about 60%, greater than or equal to about 70%, greater than or equal to about 80%, greater than or equal to about 85%, or greater than or equal to about 90% and for example, less than or equal to about 99%, or less than or equal to about 95%). The substrate may further include a region for a blue pixel, a region for a red pixel, a region for a green pixel, or a combination thereof. A thin film transistor may be disposed in each region of the substrate, and one of a source electrode and a drain electrode of the thin film transistor may be electrically connected to the first electrode or the second electrode.

The light transmitting electrode may be disposed on a (e.g., insulating) transparent substrate. The substrate may be rigid or flexible. The substrate may be plastic, glass, or a metal.

The light transmitting electrode can have a light transmittance of greater than or equal to about 50%, greater than or equal to about 60%, greater than or equal to about 70%, greater than or equal to about 80%, or greater than or equal to about 90%, for example, in the range of about 80% to about 100%, about 85% to about 95%, or a combination thereof.

The light transmitting electrode may include, for example, a transparent conductor such as indium tin oxide (ITO)

or indium zinc oxide (IZO), gallium indium tin oxide, zinc indium tin oxide, titanium nitride, polyaniline, LiF/Mg:Ag, or the like, or a metal thin film of a single layer or a plurality of layers, but is not limited thereto. The first electrode, the second electrode, or a combination thereof may include silver, aluminum (Al), a lithium aluminum (Li:Al) alloy, a magnesium-silver alloy (Mg:Ag), lithium fluoride-aluminum (LiF:Al), or the like. In an alloy electrode, a ratio between each material can be appropriately controlled, for example, in the range of about 1:0.1 to about 1:10, about 1:0.2 to about 1:5, about 1:0.3 to about 1:3, or a combination thereof.

In an embodiment, the first electrode or the second electrode may be a multilayer electrode. In an embodiment, the first electrode (or anode) may be a multilayer electrode including two or more layers, three or more layers and ten or fewer layers, or five or fewer layers of electrode material. In an embodiment, the second electrode (or cathode) may be a multilayer electrode including two or more layers, three or more layers and ten or fewer layers, or five or fewer layers of electrode material.

The multilayer electrode may include, for example, a light transmitting conductive material (or a transparent conductive material) such as indium tin oxide, an opaque conductive material (or reflective electrode material) such as aluminum, or a combination thereof. In an embodiment, the electrode (e.g., an anode or a cathode) may have a structure in which an opaque conductive material (or a reflective electrode material layer) is disposed between transparent conductive materials (e.g., layers of transparent conductive materials). In an embodiment, the electrode (anode or cathode) may have a structure in which a light transmitting conductive material (e.g., a light transmitting conductive material layer) is disposed between opaque conductive materials (or reflective electrode materials).

When a voltage is applied between the first electrode and the second electrode, the light emitting layer can emit light up and down by the electric field, and the light traveling to the reflective electrode can be reflected and emitted in the opposite direction.

In an embodiment, light may be emitted toward the cathode. In an embodiment, light may be emitted toward the anode.

The thickness of the electrode (the first electrode and/or the second electrode) is not particularly limited and may be appropriately selected in consideration of device efficiency. For example, the thickness of the electrode may be greater than or equal to about 5 nm, for example, greater than or equal to about 10 nm, greater than or equal to about 20 nm, greater than or equal to about 30 nm, greater than or equal to about 40 nm, or greater than or equal to about 50 nm. For example, the thickness of the electrode may be less than or equal to about 100 micrometers (μm), for example, less than or equal to about 90 μm, less than or equal to about 80 μm, less than or equal to about 70 μm, less than or equal to about 60 μm, less than or equal to about 50 μm, less than or equal to about 40 μm, less than or equal to about 30 μm, less than or equal to about 20 μm, less than or equal to about 10 μm, less than or equal to about 1 μm, less than or equal to about 900 nm, less than or equal to about 500 nm, less than or equal to about 100 nm, less than or equal to about 90 nm, less than or equal to about 80 nm, less than or equal to about 70 nm, or less than or equal to about 60 nm.

The method of forming the electrode is not particularly limited and may be appropriately selected depending on the material. In an embodiment, the electrode may be formed by, but is not limited to, deposition, coating, or a combination thereof.

A light emitting layer (emission layer) 3 or 30 is disposed between the first electrode 1 and the second electrode 5 (e.g., the anode 10 and the cathode 50). The light emitting layer includes semiconductor nanoparticle(s) (e.g., blue light emitting nanoparticle, red light emitting nanoparticle, or green light emitting nanoparticle). The light emitting layer may include one or more (e.g., 2 or more or 3 or more and 10 or less) monolayers of a plurality of semiconductor nanoparticles.

The light emitting layer may be patterned. In an embodiment, the patterned light emitting layer may include a blue light emitting layer (or a blue emitting layer) (e.g., disposed within a blue pixel in a display device to be described later), a red light emitting layer (or a red emitting layer) (e.g., disposed within a red pixel in a display device to be described later), a green light emitting layer (or a green emitting layer) (e.g., disposed within a green pixel in a display device to be described later)), or a combination thereof. Each of the light emitting layers may be (e.g., optically) separated from an adjacent light emitting layer by a partition wall. In an embodiment, a partition wall or bank such as a black matrix or a pixel defining layer (PDL) may be disposed between the red emitting layer(s), the green emitting layer(s), and the blue emitting layer(s) (refer to FIGS. 4 and 5). In an embodiment, the red emitting layer, the green emitting layer, and the blue emitting layer may each be optically substantially isolated.

In an embodiment, the light emitting layer or the semiconductor nanoparticle may not include cadmium. In an embodiment, the light emitting layer or the semiconductor nanoparticle may not include mercury, lead, or a combination thereof. In an embodiment, the semiconductor nanoparticle may not include or may further include copper, manganese, or a combination thereof.

In an embodiment, the semiconductor nanoparticle is configured to emit first light, and the semiconductor nanoparticle includes a semiconductor nanocrystal layer including zinc and sulfur. In an embodiment, the semiconductor nanoparticle may include zinc, selenium, and sulfur. The semiconductor nanoparticle may have a core-shell structure. In an embodiment, the semiconductor nanoparticle or the core-shell structure may include a first semiconductor nanocrystal (or a core including the same); and the semiconductor nanocrystal layer disposed on the first semiconductor nanocrystal

(or a shell including the same).

In an embodiment, the semiconductor nanoparticle or the first semiconductor nanocrystal may include or may not include a Group II-VI compound, a Group III-V compound, a Group III-VI compound, a Group I-III compound, a Group I-III-VI compound, a metal halide perovskite compound, a metal chalcogenide perovskite compound, or a combination thereof. The semiconductor nanoparticle may include or may not include zinc selenide, zinc tellurium selenide, an indium phosphide, an indium zinc phosphide, a silver indium sulfide, a copper indium sulfide, a silver gallium sulfide, a silver indium gallium sulfide, or a combination thereof.

An environmentally friendly Cd-free semiconductor nanoparticle (or quantum dot) may have a structure in which a core having a predetermined composition (e.g., ZnSe, ZnTeSe, InP, AgInGaS, etc.) and a ZnS shell layer disposed on the core are included (e.g., a core/shell/shell structure of core/ZnSe/ZnS). In such a core-shell structured quantum dot, the emission center is the core, and a ZnS shell layer having a wider bandgap than that of the core may be disposed on the core. In such a shell-forming reaction, a portion of a compound used as a precursor, or a compound added to the reaction system, or a portion thereof, may be included in or bound to the semiconductor nanoparticle (e.g., to the semiconductor nanocrystal layer). For example, a fatty acid compound such as an oleic acid or a stearic acid is used in the preparation of a precursor, for example, a zinc precursor, and the resulting semiconductor nanoparticle may further include a moiety derived from the fatty acid compound such as oleic acid.

In the fabrication of quantum dot-based self-emissive display devices, research continues into forming an emission layer (light emitting layer) using an inkjet printing technique. The ink composition for inkjet printing may further include a predetermined solvent along with the semiconductor nanoparticle. The ink composition may be deposited on an electrode or a charge transport layer to form the emission layer. However, the present inventors have found that the ink composition including the semiconductor nanoparticle manufactured by conventional techniques and the predetermined solvent may have difficulty in forming an emission layer with a desired level of quality on the electrode or some of the charge transport layers.

In this regard, there have been attempts to control the composition of organic compounds included in the semiconductor nanoparticle through ligand exchange (LE) performed on the manufactured semiconductor nanoparticle. However, the present inventors have found that the ligand exchange may cause a degradation in the luminescent properties of the semiconductor nanoparticle (e.g., including an organic compound derived from a fatty acid), and may ultimately have a negative effect on the properties of the emission layer. In addition, the present inventors confirmed that it would be difficult to achieve a desired emission film quality on some charge transport layers with the ink composition including the ligand-exchanged semiconductor nanoparticle and the predetermined organic solvent, due to particle aggregation or agglomeration, which may hinder improvement of the properties (e.g., electroluminescent properties and/or lifetime) of the manufactured electroluminescent device. The present inventors also have found that in the case of the ligand-exchanged semiconductor nanoparticle, the luminescence efficiency may be substantially lower (e.g., by about 10 to 30%) than the original luminescence efficiency before the ligand exchange.

The semiconductor nanoparticle of an embodiment is intended to address the problems of the conventional technologies. According to an embodiment, the semiconductor nanoparticle can achieve improved optical properties with a desired organic composition, without a ligand exchange process. The semiconductor nanoparticle of the embodiment may include both a moiety having a double bond or an aromatic moiety with a relatively short chain length and a compound derived from a fatty acid with a relatively long chain length, thereby exhibiting required dispersibility in a wide range of solvents and providing process flexibility in the preparation of an ink composition. In addition, when applied onto a charge transport layer (e.g., a hole auxiliary layer), the ink composition including the semiconductor nanoparticle of the embodiment may form an emission layer of improved quality (e.g., with defects substantially reduced), and the fabricated light emitting device may exhibit enhanced electroluminescent properties and increased lifetime. In an embodiment, the semiconductor nanoparticle or the emission layer further includes a first compound and a second compound. The first compound and the second compound may be, for example, organic materials (e.g., ligands) that the semiconductor nanoparticle has as a result of its fabrication (e.g., bound to the semiconductor nanocrystal layer).

The first compound may include a first functional group (X1); and a substituted or unsubstituted aromatic hydrocarbon group (Ar) (e.g., C6 to C30 or C6-C18) or a substituted or unsubstituted aliphatic hydrocarbon group (AL1) having a double bond at a terminal thereof. The second compound may include a second functional group (X2); and an aliphatic hydrocarbon group (AL2) having C8 to C40. The first functional group and the second functional group may each independently include a carboxylic acid or its anion (e.g., carboxylate). The first compound may have a molecular weight less than that of the second compound. The first compound may have a molecular weight greater than that of the second compound.

The aliphatic hydrocarbon group having a double bond at a terminal thereof may further include one or more double bonds in a middle portion of the chain. The aliphatic hydrocarbon group having a double bond at a terminal thereof may have a carbon number of greater than or equal to about 5, greater than or equal to about 6, greater than or equal to about 7, greater than or equal to about 8, greater than or equal to about 9, greater than or equal to about 10, greater than or equal to about 11, greater than or equal to about 12, greater than or equal to about 13, greater than or equal to about 14,

greater than or equal to about 15, or greater than or equal to about 16. The aliphatic hydrocarbon group having a double bond at a terminal thereof may have a carbon number of less than or equal to about 30, less than or equal to about 27, less than or equal to about 25, less than or equal to about 20, less than or equal to about 18, less than or equal to about 16, less than or equal to about 14, or less than or equal to about 12.

In the first compound, a linker (L) connecting the first functional group and the aromatic hydrocarbon group may be present. The linker may include a substituted or unsubstituted (aliphatic, alicyclic, or aromatic) hydrocarbon group having greater than or equal to about C2, greater than or equal to about C3, greater than or equal to about C4, greater than or equal to about C5, or greater than or equal to about C6 and less than or equal to about C20, less than or equal to about C15, less than or equal to about C10, or less than or equal to about C8. The linker may include a substituted or unsubstituted hydrocarbon group of C5 to C10.

In the aliphatic hydrocarbon group having a double bond at a terminal thereof of the first compound, or in the linker (L), one or more methylene group may be replaced with O, CO, COO, S, SO, SOO, **NH,** NHCO, or a combination thereof. The aliphatic hydrocarbon group having a double bond at a terminal thereof or the linker (L) of the first compound may further include one or more (e.g., two, three, four, or five) double bonds in the chain.

The first compound may further include a metal (e.g., zinc). The first compound including the metal may be obtained by a reaction between a metal compound (e.g., a metal acetate) and the first compound in the form of a carboxylic acid. The metal compound may include zinc acetate.

The first compound may include a compound or a moiety represented by Chemical Formula 1-1, a compound or a moiety represented by Chemical Formula 1-2, or a combination thereof:

Chemical Formula 1-1 X1-L1-Ar

Chemical Formula 1-2 X1-AL1

and in the above formulae,

X1 is COOH or COO*, where * indicates an anionic moiety or a site bonded to a semiconductor nanocrystal or a metal ion;
L1 is a substituted or unsubstituted hydrocarbon group (e.g., an aliphatic hydrocarbon group such as alkylene or alkenylene, or a cycloaliphatic hydrocarbon group) having C1 to C20, C2 to C18, C3 to C16, C4 to C14, C5 to C12, C6 to C10, or C8 to C9;
Ar is a substituted or unsubstituted C6 to C20 aromatic hydrocarbon group (e.g., an aryl group such as a phenyl group or a benzyl group, or a naphthyl group);
AL1 is a group represented by the following Chemical Formula 1-2-1:

Chemical Formula 1-2-1 $*\text{-L2-CR=CR}_2$

and in the above formula, L2 is a substituted or unsubstituted aliphatic hydrocarbon group having C1-C20, C2-C18, C3-C16, C4-C14, C5-C12, C6-C10, or C8-C9.
R is each independently hydrogen, a substituted or unsubstituted C1-C5 alkyl group, or a combination thereof, and
* denotes a site connected to X1.

In L1 and L2, one or more methylene group may be replaced with O, CO, COO, S, SO, SOO, NH, NHCO, or a combination thereof. In an embodiment, L1 and L2 may further include one or more (e.g., two or five) double bonds, an arylene moiety, or a combination thereof in the chain.

In an embodiment, the first compound further includes a metal, and the first compound may be represented by the following formulae:

Chemical Formula 1-1-1 $\text{M-(X1-L1-Ar)}_n$

Chemical Formula 1-2-2 $\text{M-(X1-AL1)}_n$

and in the above formulae, M may be a metal, such as a monovalent metal, a divalent metal, or a trivalent metal, and may include, for example, zinc, and n may correspond to the valency of the metal. X1, L1, Ar, and AL1 are as defined herein.

The first compound may include a substituted or unsubstituted phenylhexanoic acid, a substituted or unsubstituted phenylhexanoate, a substituted or unsubstituted phenylpentanoic acid, a substituted or unsubstituted phenylpentanoate, a substituted or unsubstituted phenylbutanoic acid, a substituted or unsubstituted phenylbutanoate, a substituted or unsubstituted phenylisopropanoic acid, a substituted or unsubstituted phenylisopropanoate, a substituted or unsubstituted phenylpropanoic acid, a substituted or unsubstituted phenylpropanoate, a substituted or unsubstituted 9-decenic acid, a substituted or unsubstituted 9-decenoate, a substituted or unsubstituted 10-undecenoic acid, a substituted or unsubstituted 10-undecenoate, a substituted or unsubstituted 11-dodecenoic acid, a substituted or unsubstituted 11-dodecenoate, or a combination thereof.

The second compound may include a second functional group (X2); and a substituted or unsubstituted aliphatic hydrocarbon group (AL2) having C6-C50, C8-C40, C9-C38, C10-C36, C11-C34, C12-C32, C14-C30, C15-C28, C16-C26, C17-C24, or C18-C22. The second functional group of the second compound may be a carboxylic acid or its anion (carboxylate). The aliphatic hydrocarbon group of the second compound may be an alkyl group, an alkenyl group, or an alkynyl group. The aliphatic hydrocarbon group of the second compound may further include one or more double bonds in the middle of the chain. In the aliphatic hydrocarbon group of the second compound, one or more methylene group may be replaced with O, CO, COO, S, SO, SOO, NH, NHCO, or a combination thereof.

The second compound may be represented by the following Chemical Formula 2:

Chemical Formula 2 X2-AL2

and in the above formula, X2 is COOH or COO*, where * denotes an anion or a site bonded to a semiconductor nanocrystal;

AL2 is a group represented by the following Chemical Formula 2-1:

Chemical Formula 2-1 *-L3-$CR_3$

and in the above formula, L3 is a substituted or unsubstituted aliphatic hydrocarbon group having C6-C50, C8-C40, C10-C36, C12-C32, C14-C28, C16-C26, or C18-C24; * denotes a site connected to X2; and R is each independently hydrogen, a substituted or unsubstituted C1-C5 alkyl group, or a combination thereof.

In L3, one or more methylene groups may be replaced with O, CO, COO, S, SO, SOO, NH, NHCO, or a combination thereof. L3 may further include one or more (e.g., two or five) double bonds in the chain.

The second compound may include an oleic acid, an oleate, a myristic acid, a myristate, a stearic acid, a stearate, a lauric acid, a laurate, or a combination thereof.

In an embodiment, the semiconductor nanoparticle includes the first compound and the second compound. Accordingly, when the semiconductor nanoparticle is analyzed by gas chromatography-mass spectrometry (GC-MS), the gas chromatogram exhibits a first peak for the first compound (that is, assigned to the first compound) and a second peak for the second compound (that is, assigned to the second compound). In the gas chromatography, the retention time of the second peak is greater than that of the first peak, and an area ratio of the first peak to the second peak is greater than or equal to about 0.1:1 and less than or equal to about 3:1.

The retention time of the second peak may be longer than the retention time of the first peak. A ratio of the retention time of the first peak (i.e., the elution time of the first compound) to the retention time of the second peak (i.e., the elution time of the second compound) may be greater than or equal to about 0.1:1, greater than or equal to about 0.2:1, greater than or equal to about 0.3:1, greater than or equal to about 0.4:1, greater than or equal to about 0.5:1, greater than or equal to about 0.6:1, greater than or equal to about 0.7:1, greater than or equal to about 0.75:1, or greater than or equal to about 0.8:1. The ratio of the retention time of the first peak to the retention time of the second peak may be less than 1:1, less than or equal to about 0.9:1, less than or equal to about 0.8:1, less than or equal to about 0.7:1, less than or equal to about 0.6:1, or less than or equal to about 0.5:1.

A difference in retention time between the second peak and the first peak may be greater than or equal to about 2 minutes, greater than or equal to about 3 minutes, greater than or equal to about 4 minutes, greater than or equal to about 5 minutes, greater than or equal to about 6 minutes, greater than or equal to about 8 minutes, greater than or equal to about 9 minutes, or greater than or equal to about 10 minutes. The difference in retention time between the second peak and the first peak may be less than or equal to about 15 minutes, less than or equal to about 13 minutes, less than or equal to about 12 minutes, less than or equal to about 11 minutes, less than or equal to about 10 minutes, less than or equal to about 9 minutes, less than or equal to about 7 minutes, or less than or equal to about 2 minutes.

An area ratio of the first peak to the second peak may be greater than or equal to about 0.1:1, greater than or equal to about 0.13:1, greater than or equal to about 0.15:1, greater than or equal to about 0.17:1, greater than or equal to about 0.19:1, greater than or equal to about 0.2:1, greater than or equal to about 0.23:1, greater than or equal to about 0.25:1, greater than or equal to about 0.27:1, greater than or equal to about 0.3:1, greater than or equal to about 0.32:1, greater than or equal to about 0.33:1, greater than or equal to about 0.35:1, greater than or equal to about 0.4:1, greater than or equal to about 0.42:1, greater than or equal to about 0.44:1, greater than or equal to about 0.46:1, greater than or equal to

about 0.48:1, greater than or equal to about 0.5:1, greater than or equal to about 0.55:1, greater than or equal to about 0.6:1, greater than or equal to about 0.65:1, greater than or equal to about 0.7:1, greater than or equal to about 0.75:1, greater than or equal to about 0.8:1, greater than or equal to about 0.85:1, greater than or equal to about 0.9:1, greater than or equal to about 0.95:1, greater than or equal to about 1:1, greater than or equal to about 1.1:1, greater than or equal to about 1.2:1, greater than or equal to about 1.3:1, greater than or equal to about 1.4:1, greater than or equal to about 1.5:1, greater than or equal to about 1.6:1, greater than or equal to about 1.7:1, greater than or equal to about 1.8:1, greater than or equal to about 1.9:1, greater than or equal to about 2.1:1, greater than or equal to about 2.3:1, greater than or equal to about 2.5:1, greater than or equal to about 2.7:1, greater than or equal to about 2.9:1, or greater than or equal to about 2.95:1. The area ratio of the first peak to the second peak may be less than or equal to about 3:1, less than or equal to about 2.8:1, less than or equal to about 2.6:1, less than or equal to about 2.4:1, less than or equal to about 2.2:1, less than or equal to about 2:1, less than or equal to about 1.85:1, less than or equal to about 1.75:1, less than or equal to about 1.65:1, less than or equal to about 1.55:1, less than or equal to about 1.45:1, less than or equal to about 1.35:1, less than or equal to about 1.25:1, less than or equal to about 1.15:1, less than or equal to about 1:1, less than or equal to about 0.97:1, less than or equal to about 0.93:1, less than or equal to about 0.91:1, less than or equal to about 0.89:1, less than or equal to about 0.84:1, less than or equal to about 0.79:1, less than or equal to about 0.74:1, less than or equal to about 0.72:1, less than or equal to about 0.71:1, less than or equal to about 0.68:1, less than or equal to about 0.64:1, less than or equal to about 0.59:1, less than or equal to about 0.57:1, less than or equal to about 0.53:1, or less than or equal to about 0.49:1.

A gas chromatography (GC) is an analytical technique that may be used to separate, identify, and quantify individual chemical components in complex mixtures. In the GC, a gas carries a sample through the GC instrument. In an embodiment, a carrier gas or a mobile phase is not particularly limited and may be a high-purity helium, hydrogen, or nitrogen. In an embodiment, the gas chromatography analysis apparatus may include an injector (e.g., split/splitless (SSL) injector), a column (e.g., a wall-coated open tubular (WCOT) capillary column including a thin layer of dimethylpolysiloxane stationary phase), and a detector (e.g., flame ionization detector, FID, or mass spectrometry, MS), but is not limited thereto. In an embodiment, the GC column may be a capillary column and may be a fused silica capillary tube including a polymer outer coating. In the chromatogram obtained by GC, the x-axis represents retention time (typically in minutes) and the y-axis represents detector response. In an embodiment, the GC apparatus may be py-GC/MS. In the GC, the temperature of the pyrolyzer may be greater than or equal to about 100°C, greater than or equal to about 150°C, greater than or equal to about 200°C, or greater than or equal to about 250°C, and may be from about 400°C to about 600°C or from about 450°C to about 550°C. The GC apparatus may include a capillary column. The capillary column may include a stationary phase of polysiloxane (e.g., dimethylpolysiloxane, 5% to 65% diphenyldimethylpolysiloxane, polyethylene glycol, etc.), and the polarity may be appropriately selected.

The flow rate of the mobile phase (gas) may be appropriately selected and may be in the range of 0.5 milliliter per minute (mL/min) to 10 mL/min, or 1 mL/min to 5 mL/min, or 1.5 mL/min to 3 mL/min. The inlet temperature of the GC apparatus may be appropriately selected and may be in the range of 100°C to 400°C, 150°C to 300°C, or 200°C to 250°C. The GC oven temperature may be appropriately controlled. The analyzer may be a quadrupole (range: 10 ~ 550 mass-to-charge ratio (m/z)).

For a gas chromatography analysis, a semiconductor nanoparticle having a predetermined weight (e.g., 0.1 milligrams) may be treated with approximately 1 microliter of a base solution (e.g., trimethylammonium hydroxide), and the resulting solution may be subjected to analysis. For a mass spectrometry, a solvent delay may be used to remove data from the extraction solvent.

In the semiconductor nanoparticle, a mole ratio of the first compound to the second compound may be greater than or equal to about 0.1:1, greater than or equal to about 0.15:1, greater than or equal to about 0.19:1, greater than or equal to about 0.2:1, greater than or equal to about 0.25:1, greater than or equal to about 0.3:1, greater than or equal to about 0.31:1, greater than or equal to about 0.32:1, greater than or equal to about 0.35:1, greater than or equal to about 0.4:1, greater than or equal to about 0.45:1, greater than or equal to about 0.5:1, greater than or equal to about 0.55:1, greater than or equal to about 0.6:1, or greater than or equal to about 0.65:1.

In the semiconductor nanoparticle, a mole ratio of the first compound to the second compound may be less than or equal to about 3:1, less than or equal to about 2.7:1, less than or equal to about 2.5:1, less than or equal to about 2.3:1, less than or equal to about 2.2:1, less than or equal to about 2.1:1, less than or equal to about 2:1, less than or equal to about 1.8:1, less than or equal to about 1.7:1, less than or equal to about 1.6:1, less than or equal to about 1.5:1, less than or equal to about 0.95:1, less than or equal to about 0.9:1, less than or equal to about 0.85:1, less than or equal to about 0.8:1, less than or equal to about 0.75:1, less than or equal to about 0.7:1, less than or equal to about 0.65:1, less than or equal to about 0.6:1, less than or equal to about 0.55:1, less than or equal to about 0.5:1, less than or equal to about 0.45:1, less than or equal to about 0.4:1, less than or equal to about 0.35:1, or less than or equal to about 0.33:1.

In an embodiment, the semiconductor nanoparticle may exhibit improved dispersibility in various types of solvents, and may be included in an ink composition for inkjet printing, for example. In order to fabricate an emission layer of an electroluminescent device using an inkjet printing process, the development of a suitable ink composition is required. The organic solvent for inkjet printing includes a predetermined solvent having a relatively high boiling point. The ink

solvent may have a high boiling point and, for discharge stability at the nozzle and pixel uniformity, may be in the form of a mixture including linear aliphatic, cyclic aliphatic, and aromatic hydrocarbons, rather than a single solvent.

The present inventors have found that in the case of semiconductor nanoparticles prepared according to conventional technologies (e.g., including compounds derived from oleic acid), they may exhibit desirable dispersibility or compatibility in some organic solvents, but may not provide a required level of dispersibility or compatibility in the organic solvents used for inkjet printing. For example, if the semiconductor nanoparticle includes ligands with a short chain length, its dispersibility in the ink solvent may decrease, which can be a technical obstacle to forming the emission layer via an inkjet printing method.

Surprisingly, the present inventors have found that the semiconductor nanoparticle of an embodiment, due to the features described herein (e.g., the presence of the first compound and the second compound), can exhibit a desirable level of dispersibility in high-boiling organic solvents (e.g., mixtures of high-boiling organic solvents) that can be used for a inkjet printing process. After being formed into an emission layer, the semiconductor nanoparticle can provide improved charge transport properties (e.g., hole transport properties), initial driving stability, and extended lifetime characteristics, in the device. The semiconductor nanoparticle of an embodiment may exhibit enhanced hole transport properties while including organic materials in the amount specified herein.

Accordingly, in an embodiment, the ink composition includes the semiconductor nanoparticle and a solvent. The semiconductor nanoparticle may be dispersed in the solvent and may be, for example, a colloidal dispersion.

In the semiconductor nanoparticle of an embodiment, the first compound and the second compound have a Hansen solubility parameter distance (Ra), calculated with respect to a predetermined solvent, that is greater than 0, or greater than or equal to about 0.1 and less than or equal to about 4, or less than or equal to about 3.

The Hansen Solubility Parameter (HSP) is known as a factor that predicts whether one substance will dissolve in another to form a solution. For example, a compound having a chemical structure can be used to calculate a dispersion solubility parameter, a polar solubility parameter, and a hydrogen bonding parameter. Among them, the dispersion solubility parameter $\delta D$ relates to the energy arising from dispersion forces between molecules; the polar solubility parameter $\delta P$ relates to the energy from intermolecular dipole-dipole interactions; and the hydrogen bonding parameter $\delta H$ relates to the energy from hydrogen bonding between molecules. These three parameters can be treated as coordinates in a three-dimensional space, referred to as Hansen space, and the Hansen solubility parameter distance Ra in the three-dimensional space may satisfy the following equation:

$$Ra^2 = 4(\delta D_1 - \delta D_2)^2 + (\delta P_1 - \delta P_2)^2 + (\delta H_1 - \delta H_2)^2$$

Ra: Hansen solubility parameter distance
$\delta D_1$: dispersion solubility parameter of moieties, excluding the COO groups, of the first compound and the second compound
$\delta D_2$: the dispersion solubility parameter of the predetermined solvent
$\delta P_1$: polar solubility parameter of the moieties excluding the COO groups of the first compound and the second compound
$\delta P_2$: polar solubility parameter of the predetermined solvent
$\delta H_1$: hydrogen bond parameter of moieties, excluding the COO groups, of the first compound and the second compound
$\delta H_2$: hydrogen bond parameter of the predetermined solvent

The Hansen solubility parameter (i.e., hydrogen bonding parameter, dispersion solubility parameter, and polar solubility parameter) can be readily and reproducibly obtained from the chemical structures of individual compounds using commercially available software. Such software includes, but is not limited to, HSPiP (Hansen Solubility Parameters in Practice), COSMOlogic TURBOMOLE/COSMOtherm, and Solvit. These software tools receive the chemical structure of each compound as input, calculate the Hansen solubility parameters, and based on those, compute the Ra value.

In the semiconductor nanoparticle of an embodiment, the solubility parameter of the first compound and the second compound may be determined in consideration of the mole ratio between the first compound and the second compound included in the semiconductor nanoparticle. For example, the solubility parameter values of the first compound and the second compound can be obtained, and each solubility parameter value can be multiplied by the mole fraction of the corresponding compound in the semiconductor nanoparticle. Then, the mole-fraction-weighted solubility parameter values can be summed to calculate the overall solubility parameters.

The solubility parameter for a predetermined solvent may be calculated based on the chemical structure of the solvent. In the case of a mixed solvent, the solubility parameter of each constituent solvent can be obtained, and each can be multiplied by its mole fraction in the mixed solvent, and the resulting values can be summed to determine the Hansen solubility parameters of the mixed solvent.

In an embodiment, the Hansen solubility parameter distance Ra may be greater than or equal to about 0.3, greater than or equal to about 0.5, greater than or equal to about 0.7, greater than or equal to about 1, greater than or equal to about 1.2, greater than or equal to about 1.4, greater than or equal to about 1.6, greater than or equal to about 1.8, greater than or equal to about 2, greater than or equal to about 2.2, greater than or equal to about 2.4, or greater than or equal to about 2.6. The Hansen solubility parameter distance Ra may be less than or equal to about 3.8, less than or equal to about 3.6, less than or equal to about 3.4, less than or equal to about 3.2, less than or equal to about 3, less than or equal to about 2.9, less than or equal to about 2.7, less than or equal to about 2.5, less than or equal to about 2.3, less than or equal to about 2.1, less than or equal to about 1.9, less than or equal to about 1.7, less than or equal to about 1.5, or less than or equal to about 1.3.

The predetermined solvent may include a substituted or unsubstituted C1 to C40, C5 to C30, or C8 to C12 aliphatic hydrocarbon solvent, a substituted or unsubstituted C3 to C40, C6 to C30, or C8 to C12 cycloaliphatic hydrocarbon solvent, a substituted or unsubstituted C6 to C50, or C8 to C36 aromatic hydrocarbon solvent, a substituted or unsubstituted C6 to C50, C5 to C40, or C8 to C36 aliphatic ester solvent, or a combination thereof (e.g., a mixture of two or more of the listed solvents). The predetermined solvent may include cyclohexylbenzene, hexadecane, octylbenzene, 1,3,5-triisopropylbenzene, ethyldodecanoate, decylcyclohexane, or a combination thereof.

In an embodiment, the predetermined solvent may be a mixed solvent, and a ratio (e.g., a volume ratio) between each solvent may be appropriately selected. In an embodiment, the predetermined solvent may be a mixed solvent including a mixture of a cycloaliphatic solvent and an aliphatic solvent; a mixture of an aliphatic solvent and an aromatic solvent; a mixture of a cycloaliphatic solvent and an aromatic solvent; or a combination thereof.

The predetermined solvent may include a solvent having a relatively high boiling point. In an embodiment, the predetermined solvent may have a boiling point that is greater than or equal to about 200°C, greater than or equal to about 210°C, greater than or equal to about 220°C, greater than or equal to about 225°C, greater than or equal to about 230°C, greater than or equal to about 235°C, greater than or equal to about 240°C, greater than or equal to about 245°C, greater than or equal to about 250°C, greater than or equal to about 255°C, greater than or equal to about 260°C, greater than or equal to about 265°C, greater than or equal to about 270°C, greater than or equal to about 275°C, greater than or equal to about 280°C, or greater than or equal to about 285°C. The boiling point of the predetermined solvent may be less than or equal to about 350°C, less than or equal to about 335°C, less than or equal to about 330°C, less than or equal to about 325°C, less than or equal to about 320°C, less than or equal to about 315°C, less than or equal to about 310°C, less than or equal to about 305°C, less than or equal to about 300°C, less than or equal to about 295°C, less than or equal to about 290°C, less than or equal to about 285°C, less than or equal to about 280°C, less than or equal to about 275°C, less than or equal to about 270°C, less than or equal to about 265°C, less than or equal to about 260°C, less than or equal to about 255°C, less than or equal to about 250°C, less than or equal to about 245°C, less than or equal to about 240°C, or less than or equal to about 235°C.

The emission layer may further include or may not include the predetermined solvent. The emission layer may further include or may not include cyclohexylbenzene, hexadecane, octylbenzene, 1,3,5-triisopropylbenzene, ethyldodecanoate, decylcyclohexane, or a combination thereof (a mixture thereof).

The semiconductor nanoparticle may exhibit improved dispersibility in an organic solvent (e.g., an aliphatic hydrocarbon solvent such as octane or the predetermined solvent). In one embodiment, when the semiconductor nanoparticle is dispersed in octane or the predetermined solvent and measured by dynamic light scattering (DLS) analysis, it may exhibit a DLS (average) particle diameter of less than or equal to about 600 nm, less than or equal to about 300 nm, or less than or equal to about 200 nm. The DLS (average) particle diameter may be less than or equal to about 200 nm, less than or equal to about 100 nm, less than or equal to about 80 nm, less than or equal to about 60 nm, less than or equal to about 50 nm, less than or equal to about 40 nm, less than or equal to about 30 nm, or less than or equal to about 20 nm. The DLS particle diameter may be greater than or equal to about 5 nm, greater than or equal to about 7 nm, greater than or equal to about 10 nm, greater than or equal to about 15 nm, or greater than or equal to about 20 nm.

An embodiment of the semiconductor nanoparticle may exhibit a relatively reduced content of organics in thermogravimetric analysis, while still exhibiting a desirable degree of dispersibility in an organic solvent (or a predetermined organic solvent). In an embodiment, the semiconductor nanoparticle may exhibit a weight loss in the range of 200°C to 550°C, based on the total weight of the semiconductor nanoparticle, that is less than or equal to about 13.5 wt%, less than or equal to about 13 wt%, less than or equal to about 12.5 wt%, less than or equal to about 12 wt%, less than or equal to about 11.5 wt%, less than or equal to about 11 wt%, or less than or equal to about 10.5 wt%. The semiconductor nanoparticle may exhibit, in thermogravimetric analysis, a weight loss in the range of 200°C to 550°C that is greater than or equal to about 1 wt%, greater than or equal to about 3 wt%, greater than or equal to about 5 wt%, greater than or equal to about 7 wt%, greater than or equal to about 8 wt%, greater than or equal to about 9 wt%, greater than or equal to about 9.5 wt%, greater than or equal to about 10 wt%, or greater than or equal to about 10.5 wt% based on the total weight of the semiconductor nanoparticle.

The semiconductor nanoparticle may exhibit, in thermogravimetric analysis, a residue content at temperatures greater than or equal to about 550°C that is greater than or equal to about 80 wt%, greater than or equal to about 83 wt%,

greater than or equal to about 86 wt%, greater than or equal to about 86.5 wt%, greater than or equal to about 87 wt%, greater than or equal to about 88 wt%, greater than or equal to about 90 wt%, or greater than or equal to about 91 wt% and less than or equal to about 99 wt%, less than or equal to about 97 wt%, less than or equal to about 92 wt%, less than or equal to about 90 wt%, less than or equal to about 88.5 wt%, less than or equal to about 88.1 wt%, or less than or equal to about 88 wt%, based on the total weight of the semiconductor nanoparticle.

The semiconductor nanoparticle may include or may not include a halogen. The halogen may be fluorine, chlorine, bromine, iodine, or a combination thereof. In an embodiment, the halogen may be chlorine.

The semiconductor nanoparticle of an embodiment may include a limited amount of halogen (e.g., a halide) derived from a zinc compound (e.g., a zinc halide) added during synthesis. In the semiconductor nanoparticle of an embodiment, the content of the halogen (or chlorine), based on the total amount of all elements contained in the semiconductor nanoparticle, may be less than or equal to about 3 mole percent (mol%), less than or equal to about 2.5 mol%, less than or equal to about 2 mol%, less than or equal to about 1.5 mol%, less than or equal to about 1 mol%, less than or equal to about 0.9 mol%, or less than or equal to about 0.8 mol%.

In the semiconductor nanoparticle, the content (e.g., molar content) of the halogen (or chlorine), based on the total mole number of sulfur, may be less than or equal to about 10%, less than or equal to about 9.5%, less than or equal to about 9%, less than or equal to about 8.5%, less than or equal to about 8%, less than or equal to about 7.5%, less than or equal to about 7%, less than or equal to about 6.5%, less than or equal to about 6%, less than or equal to about 5.5%, less than or equal to about 5%, less than or equal to about 4.5%, less than or equal to about 4%, less than or equal to about 3.5%, less than or equal to about 3%, or less than or equal to about 2.5%. In the semiconductor nanoparticle, the content (e.g., molar content) of the halogen (or chlorine), based on the total mole number of sulfur, may be greater than or equal to about 0.1%, greater than or equal to about 0.5%, greater than or equal to about 0.9%, greater than or equal to about 1.1%, greater than or equal to about 1.3%, greater than or equal to about 1.8%, greater than or equal to about 2%, greater than or equal to about 2.2%, greater than or equal to about 2.6%, greater than or equal to about 2.8%, greater than or equal to about 3.2%, or greater than or equal to about 3.6%.

The semiconductor nanoparticle may further include selenium, and the content (e.g., molar content) of the halogen (or chlorine), based on the total mole number of selenium, may be less than or equal to about 10%, less than or equal to about 9.5%, less than or equal to about 9%, less than or equal to about 8.5%, less than or equal to about 8%, less than or equal to about 7.5%, less than or equal to about 7%, less than or equal to about 6.5%, less than or equal to about 6%, less than or equal to about 5.5%, less than or equal to about 5%, less than or equal to about 4.5%, less than or equal to about 4%, less than or equal to about 3.5%, less than or equal to about 3%, or less than or equal to about 2.5%.

In the semiconductor nanoparticle, the content (e.g., molar content) of the halogen (or chlorine), based on the total mole number of selenium, may be greater than or equal to about 0.1 %, greater than or equal to about 0.5%, greater than or equal to about 0.9%, greater than or equal to about 1.1%, greater than or equal to about 1.3%, greater than or equal to about 1.8%, greater than or equal to about 2%, greater than or equal to about 2.2%, greater than or equal to about 2.6%, greater than or equal to about 2.8%, greater than or equal to about 3.2%, or greater than or equal to about 3.6%.

In the semiconductor nanoparticle, a mole ratio of the halogen (or chlorine) to zinc may be greater than or equal to about 0.005:1, greater than or equal to about 0.01:1, greater than or equal to about 0.02:1, greater than or equal to about 0.03:1, greater than or equal to about 0.04:1, greater than or equal to about 0.05:1, greater than or equal to about 0.08:1, greater than or equal to about 0.1:1, greater than or equal to about 0.15:1, or greater than or equal to about 0.2:1. In the semiconductor nanoparticle, a mole ratio of the halogen (or chlorine), to zinc may be less than or equal to about 1:1, less than or equal to about 0.9:1, less than or equal to about 0.7:1, less than or equal to about 0.6:1, less than or equal to about 0.4:1, less than or equal to about 0.2:1, less than or equal to about 0.12:1, less than or equal to about 0.09:1, less than or equal to about 0.07:1, less than or equal to about 0.06:1, or less than or equal to about 0.05:1.

In the semiconductor nanoparticle, a mole ratio of carbon to zinc may be greater than or equal to about 0.005:1, greater than or equal to about 0.01:1, greater than or equal to about 0.05:1, greater than or equal to about 0.1:1, greater than or equal to about 0.15:1, greater than or equal to about 0.2:1, greater than or equal to about 0.25:1, greater than or equal to about 0.3:1, greater than or equal to about 0.35:1, greater than or equal to about 0.4:1, or greater than or equal to about 0.45:1. In the semiconductor nanoparticle, a mole ratio of carbon to zinc may be less than or equal to about 1:1, less than or equal to about 0.9:1, less than or equal to about 0.7:1, or less than or equal to about 0.5:1.

As used herein, mole ratios between elements may be determined by appropriate analytical methods (e.g., inductively coupled plasma atomic emission spectroscopy (ICP-AES), X-ray photoelectron spectroscopy (XPS), transmission electron microscopy-energy dispersive X-ray spectroscopy (TEM-EDX), scanning electron microscopy-energy dispersive X-ray spectroscopy (SEM-EDX), X-ray fluorescence (XRF), or the like).

The semiconductor nanoparticle may have a core-shell structure. The semiconductor nanoparticle or the core-shell structure may include a first semiconductor nanocrystal (e.g. a core including the same) and a shell disposed on the first semiconductor nanocrystal (or the core). The shell may include a semiconductor nanocrystal layer including zinc and sulfur (including a third semiconductor nanocrystal). The shell may further include a second semiconductor nanocrystal including zinc and selenium or an intermediate shell layer including the same. The intermediate shell layer may be

disposed between the first semiconductor nanocrystal (or core) and the semiconductor nanocrystal layer.

The semiconductor nanoparticle or the first semiconductor nanocrystal may include an indium phosphide, an indium zinc phosphide, a zinc selenide, a zinc telluride, a zinc tellurium selenide, a silver indium gallium sulfide, a silver indium sulfide, or a combination thereof.

The semiconductor nanoparticle or the shell may include a zinc selenide, a zinc selenide telluride, a zinc selenide sulfide, a zinc sulfide, or a combination thereof. The shell may include a first shell layer including the second semiconductor nanocrystal and a second shell layer (or semiconductor nanocrystal layer) including, for example, the third semiconductor nanocrystal and disposed on the first shell layer. The first shell layer or the second semiconductor nanocrystal may include a zinc selenide, a zinc selenide telluride, a zinc selenide sulfide, or a combination thereof. The semiconductor nanocrystal layer or the third semiconductor nanocrystal may include a zinc selenide sulfide, a zinc sulfide, or a combination thereof. In an embodiment, the core-shell type semiconductor nanoparticle may have a Type I, Type II, or quasi-Type II energy band alignment depending on the composition of the first semiconductor nanocrystal and the shell, and may be configured to emit light of a desired wavelength in response to voltage application or optical excitation.

In an embodiment, the semiconductor nanoparticle, the first semiconductor nanocrystal, or the shell (e.g., the second semiconductor nanocrystal or the third semiconductor nanocrystal) may each independently include a Group II-VI compound, a Group III-V compound, a Group IV-VI compound, a Group IV element or compound, a Group II-III-VI compound, a Group I-III-VI compound, a Group I-II-IV-VI compound, a metal halide perovskite compound, a metal chalcogenide perovskite compound, or a combination thereof.

The Group II-VI compound may include a binary compound such as CdS, CdSe, CdTe, CdO, ZnS, ZnSe, ZnTe, ZnO, HgS, HgSe, HgTe, MgSe, MgS, or a combination thereof; a ternary compound such as CdSeS, CdSeTe, CdSTe, ZnSeS, ZnSeTe, ZnSTe, HgSeS, HgSeTe, HgSTe, HgZnS, HgZnSe, HgZnTe, MgZnSe, MgZnS, or a combination thereof; a quaternary compound such as HgZnTeS, HgZnSeS, HgZnSeTe, HgZnSTe, or a combination thereof; or a combination thereof. The Group II-VI compound may further include a Group III metal.

The Group III-V compound may include a binary compound such asGaN, GaP, GaAs, GaSb, AlN, AlP, AlAs, AlSb, InN, InP, InAs, InSb, or a combination thereof; a ternary compound such as GaNP, GaNAs, GaNSb, GaPAs, GaPSb, AlNP, AlNAs, AlNSb, AlPAs, AlPSb, InNP, InNAs, InNSb, InPAs, InPSb, or a combination thereof; a quaternary compound selected from GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, or a combination thereof; or a combination thereof. The Group III-V compound may further include a Group II element. An example of such a semiconductor nanocrystal is InZnP.

The Group IV-VI compound may include a binary compound such as SnS, SnSe, SnTe, or a combination thereof; a ternary compound such as SnSeS, SnSeTe, SnSTe, or a combination thereof; a quaternary compound such as SnSSeTe, or a combination thereof; or a combination thereof.

Examples of the Group I-III-VI compound may include, but are not limited to, $CuInSe_2$, $CuInS_2$, CuInGaSe and CuInGaS.

Examples of the Group I-III-VI semiconductor compound may include a ternary compound such as AgInS, $AgInS_2$, $AgInSe_2$, AgGaS, $AgGaS_2$, $AgGaSe_2$, CuInS, $CuInS_2$, $CuInSe_2$, $CuGaS_2$, $CuGaSe_2$, $CuGaO_2$, $AgGaO_2$, $AgAlO_2$; or a combination thereof; a quaternary compound such as $AgInGaS_2$, $AgInGaSe_2$ or a combination thereof; or a combination thereof.

Examples of the Group I-II-IV-VI compound may include, but are not limited to, CuZnSnSe and CuZnSnS.

The Group IV element or compound may include a single elementsuch as Si, Ge, or a combination thereof; a binary compound such as SiC, SiGe, or a combination thereof; or a combination thereof.

Each element included in a multi-element compound such as a binary compound, a ternary compound, or a quaternary compound may be present within the particle at a uniform or non-uniform concentration. For example, the chemical formula described above represents the types of elements included in the compound, and the elemental ratio within the compound may vary. For instance, $AgInGaS_2$ may include $AgIn_xGa_{1-x}S_2$ (where x is a real number equal to or greater than 0 and equal to or less than 1), but is not limited thereto.

In an embodiment, the first semiconductor nanocrystal may include a metal selected from indium, zinc, or a combination thereof, and a non-metal selected from phosphorus, selenium, tellurium, sulfur, or a combination thereof. In an embodiment, the second semiconductor nanocrystal may include a metal selected from indium, zinc, or a combination thereof, and a non-metal element selected from phosphorus, selenium, tellurium, sulfur, or a combination thereof.

In an embodiment, the first semiconductor nanocrystal may include InP, InZnP, ZnSe, ZnSeS, ZnSeTe, or a combination thereof, and/or the second semiconductor nanocrystal may include ZnSe, ZnSeS, ZnS, ZnTeSe, or a combination thereof. In an embodiment, the semiconductor nanocrystal layer may include zinc, sulfur, and optionally selenium.

In an embodiment, the semiconductor nanoparticle may emit blue or green light and may have a core including ZnSeTe, ZnSe, or a combination thereof, and a shell including a zinc chalcogenide (e.g., ZnS, ZnSe, and/or ZnSeS). In the shell, the content of sulfur may increase or decrease in the radial direction (from the core toward the surface).

In an embodiment, the semiconductor nanoparticle may emit red or green light, and the core may include an

indium phosphide (InP), an indium zinc phosphide (InZnP), or a combination thereof, and the shell may include a Group II metal including zinc and a non-metal element including at least one of sulfur and selenium.

In an embodiment, when the semiconductor nanoparticles have a core-shell structure, an alloyed layer may or may not be present at the interface between the core and the shell. The alloyed layer may be a homogeneous alloy or a gradient alloy. In the gradient alloy, the concentration of elements present in the shell may vary in the radial direction (e.g., increasing or decreasing toward the center) and may have a concentration gradient.

In an embodiment, the shell may have a composition varying in the radial direction. In an embodiment, the shell may be a multilayer shell including two or more layers. In the multilayer shell, two adjacent layers may have different compositions. In the multilayer shell, one or more layers may each independently include semiconductor nanocrystals having a single composition. In the multilayer shell, one or more layers may each independently include alloyed semiconductor nanocrystals. In the multilayer shell, one or more layers may have a composition gradient in the radial direction in terms of the semiconductor nanocrystal composition.

In the semiconductor nanoparticle having a core-shell structure, the bandgap energy of the shell material may be greater than that of the core material, but is not limited thereto. The bandgap energy of the shell material may also be smaller than that of the core material. In the case of a multilayer shell, the outermost layer material may have a greater energy bandgap than the materials of the core and the inner shell layers (i.e., the layers closer to the core). In the multilayer shell, the bandgap of the semiconductor nanocrystal in each layer may be appropriately selected to effectively exhibit a quantum confinement effect.

In an embodiment, the semiconductor nanoparticle may be configured to control its absorption or emission wavelength, for example, by adjusting its composition, particle size, or a combination thereof. The semiconductor nanoparticle included in the emission layer 3 or 30 may be configured to emit light of a desired color. The semiconductor nanoparticle may include a blue light-emitting semiconductor nanoparticle, a green light-emitting semiconductor nanoparticle, or a red light-emitting semiconductor nanoparticle.

The semiconductor nanoparticle, the emission layer, or the electroluminescent device may emit a first light. A peak emission wavelength of the first light may fall within the ultraviolet to infrared range or greater. For example, the peak emission wavelength of the first light emitted from the semiconductor nanoparticle, the emission layer, or the electroluminescent device may be greater than or equal to about 300 nm, greater than or equal to about 500 nm, greater than or equal to about 510 nm, greater than or equal to about 520 nm, greater than or equal to about 530 nm, greater than or equal to about 540 nm, greater than or equal to about 550 nm, greater than or equal to about 560 nm, greater than or equal to about 570 nm, greater than or equal to about 580 nm, greater than or equal to about 590 nm, greater than or equal to about 600 nm, or greater than or equal to about 610 nm. The peak emission wavelength may be less than or equal to about 800 nm, less than or equal to about 650 nm, less than or equal to about 640 nm, less than or equal to about 630 nm, less than or equal to about 620 nm, less than or equal to about 610 nm, less than or equal to about 600 nm, less than or equal to about 590 nm, less than or equal to about 580 nm, less than or equal to about 570 nm, less than or equal to about 560 nm, less than or equal to about 550 nm, or less than or equal to about 540 nm. The peak emission wavelength may be in the range of 500 nm to 650 nm.

The semiconductor nanoparticle, the emission layer, or the electroluminescent device may emit the first light, e.g., green light (for example, on an application of a voltage or irradiation with light), and the peak emission wavelength of the first light or the green light may be greater than or equal to about 500 nm (e.g., greater than or equal to about 510 nm or greater than or equal to about 520 nm) and less than or equal to about 560 nm (e.g., less than or equal to about 540 nm or less than or equal to about 530 nm). The semiconductor nanoparticle, the emission layer, or the electroluminescent device may emit the first light, e.g., red light (for example, on an application of a voltage or irradiation with light), and the peak emission wavelength of the first light or the red light may be greater than or equal to about 600 nm (e.g., greater than or equal to about 610 nm) and less than or equal to about 650 nm (e.g., less than or equal to about 640 nm).

The semiconductor nanoparticle, the emission layer, or the electroluminescent device may emit the first light, e.g., blue light (for example, on an application of a voltage or irradiation with light), and the peak emission wavelength of the first light or the blue light may be as described herein. The peak emission wavelength of the blue light may be greater than or equal to about 440 nm (e.g., greater than or equal to about 450 nm, or greater than or equal to about 455 nm) and less than or equal to about 480 nm (e.g., less than or equal to about 470 nm, or less than or equal to about 465 nm).

The semiconductor nanoparticle, the emission layer, the electroluminescent device, or the first light may exhibit a photoluminescence or electroluminescence spectrum with a relatively narrow full width at half maximum (FWHM). In an embodiment, the semiconductor nanoparticle, the emission layer, the electroluminescent device, or the first light may have a FWHM of less than or equal to about 45 nm, less than or equal to about 44 nm, less than or equal to about 43 nm, less than or equal to about 42 nm, less than or equal to about 41 nm, less than or equal to about 40 nm, less than or equal to about 39 nm, less than or equal to about 38 nm, less than or equal to about 37 nm, less than or equal to about 36 nm, or less than or equal to about 35 nm in its emission spectrum.

The semiconductor nanoparticle may have a quantum yield (or absolute quantum yield) of greater than or equal to about 10%, greater than or equal to about 20%, greater than or equal to about 30%, greater than or equal to about 40%,

greater than or equal to about 50%, greater than or equal to about 60%, greater than or equal to about 70%, greater than or equal to about 80%, greater than or equal to about 90%, or even about 100%. In an embodiment, the semiconductor nanoparticle may have a quantum yield (or absolute quantum yield) greater than or equal to about 91%, greater than or equal to about 92%, greater than or equal to about 93%, greater than or equal to about 94%, greater than or equal to about 95%, greater than or equal to about 96%, or greater than or equal to about 97%.

In an embodiment, the semiconductor nanoparticle may include the first compound and the second compound as defined herein and may exhibit a relatively high quantum efficiency. In an embodiment, the semiconductor nanoparticle may include the first compound and the second compound and may exhibit an absolute quantum yield greater than or equal to about 80%, greater than or equal to about 83%, greater than or equal to about 85%, greater than or equal to about 87%, greater than or equal to about 89%, greater than or equal to about 90%, greater than or equal to about 91%, greater than or equal to about 93%, or greater than or equal to about 95%.

The semiconductor nanoparticle of an embodiment may have a size as described herein. The term "size" may refer to the individual size of a particle or the average size of particles. The size may be the diameter of a particle or an equivalent diameter calculated assuming a spherical shape. For example, the size may be a diameter or equivalent diameter converted by assuming a spherical shape from an electron microscope image when not spherical. The size may be calculated from a result of an inductively coupled plasma atomic emission spectroscopy (ICP-AES) analysis.

In an embodiment, the semiconductor nanoparticle may have an (average) size greater than or equal to about 8 nm, greater than or equal to about 8.5 nm, greater than or equal to about 9 nm, greater than or equal to about 9.5 nm, greater than or equal to about 10 nm, greater than or equal to about 10.5 nm, greater than or equal to about 11 nm, greater than or equal to about 11.5 nm, greater than or equal to about 12 nm, greater than or equal to about 12.5 nm, greater than or equal to about 12.8 nm, greater than or equal to about 13 nm, greater than or equal to about 13.5 nm, greater than or equal to about 14 nm, or greater than or equal to about 14.2 nm. The (average) size of the semiconductor nanoparticle(s) may be less than or equal to about 50 nm, for example, less than or equal to about 40 nm, less than or equal to about 35 nm, less than or equal to about 29 nm, less than or equal to about 28 nm, less than or equal to about 27 nm, less than or equal to about 26 nm, less than or equal to about 25 nm, less than or equal to about 24 nm, less than or equal to about 23 nm, less than or equal to about 22 nm, less than or equal to about 21 nm, less than or equal to about 20 nm, less than or equal to about 19 nm, less than or equal to about 18 nm, less than or equal to about 17.5 nm, less than or equal to about 17 nm, less than or equal to about 16.5 nm, less than or equal to about 16 nm, less than or equal to about 15.5 nm, less than or equal to about 15 nm, less than or equal to about 14.5 nm, less than or equal to about 14 nm, less than or equal to about 13.5 nm, less than or equal to about 13 nm, less than or equal to about 12.5 nm, less than or equal to about 12 nm, or less than or equal to about 11.5 nm. Here, the average may be a mean average. The average may also be a median. The numerical values described in this specification may include approximate values. The semiconductor nanoparticle may have a particle size of greater than or equal to about 9 nm, greater than or equal to about 10 nm, or greater than or equal to about 12 nm and less than or equal to about 50 nm.

The semiconductor nanoparticle of an embodiment may have a particle size distribution (or standard deviation of the particle size) that is less than or equal to about 15%, less than or equal to about 14%, less than or equal to about 13%, less than or equal to about 12%, or less than or equal to about 11% of the average. The particle size distribution may be greater than or equal to about 1%, greater than or equal to about 5%, or greater than or equal to about 7%.

The size of the particle may be readily and reproducibly obtained from images of the particles taken by electron microscopy (e.g., scanning electron microscopy or transmission electron microscopy) using a known or commercially available image analysis tool (e.g., ImageJ) according to a manufacturer-provided manual or the like. The image analysis tool and measurement conditions are not particularly limited.

In an embodiment, the semiconductor nanoparticle may be prepared according to the method described herein.

In an embodiment, a method of manufacturing the semiconductor nanoparticle includes preparing a first semiconductor nanocrystal or a particle including the same (e.g., a first particle); and heating a reaction medium including the first semiconductor nanocrystal, a zinc precursor, a sulfur precursor, a first compound, and a second compound in an organic solvent (e.g., to a reaction temperature) to form a semiconductor nanocrystal layer including zinc and sulfur on the first semiconductor nanocrystal (or on at least a portion of the surface of the nanocrystal or particle). The forming of the semiconductor nanocrystal layer may include reacting a first medium including the particle, the zinc precursor, the sulfur precursor, and the second compound at the reaction temperature; and adding the first compound to the first medium.

In an embodiment, the method of manufacturing the semiconductor nanoparticle includes obtaining a reaction medium (e.g., a first medium) including a first particle containing a first semiconductor nanocrystal, a second zinc precursor, and a sulfur precursor in an organic solvent; and heating the reaction medium to a reaction temperature to form a semiconductor nanocrystal layer including zinc and sulfur, wherein the second zinc precursor may include the second compound, and the method may further include adding the first compound to the reaction medium.

In an embodiment, the addition of the first compound may be performed at a temperature greater than or equal to about 180°C and less than the reaction temperature.

The first particle may include a second zinc chalcogenide including zinc, selenium, and optionally sulfur (or a

second semiconductor nanocrystal including the same). The second semiconductor nanocrystal or an intermediate shell layer including the same may be disposed on the first semiconductor nanocrystal or core. Details regarding the first semiconductor nanocrystal and the second semiconductor nanocrystal are as described herein.

The formation of the first particle is not particularly limited and may be appropriately selected. In an embodiment, the first semiconductor nanocrystal or the core including the same may be manufactured by a suitable method in consideration of its composition and the desired properties of the final nanoparticle, or it may be commercially available.

In an embodiment, the first semiconductor nanocrystal or the core including the same may include zinc and selenium, and optionally tellurium. In an embodiment, the first semiconductor nanocrystal or the core may include a zinc chalcogenide including zinc, selenium, and tellurium, and the first semiconductor nanocrystal or the core may be obtained by preparing a zinc precursor solution including a first zinc precursor and an organic ligand; preparing a selenium precursor and a tellurium precursor; heating the zinc precursor solution to a core formation reaction temperature; and adding the selenium precursor and the tellurium precursor, optionally together with an organic ligand, and carrying out the core formation reaction.

In an embodiment, the first semiconductor nanocrystal or a core including the same may be formed by a hot injection method in which a phosphorus precursor is injected into a solution containing a metal precursor such as an indium precursor and optionally a ligand, while the solution is heated to a high temperature (e.g., to a temperature greater than or equal to about 200°C). In an embodiment, the core may be prepared by a heating-up method in which the phosphorus precursor is injected at a predetermined temperature and the temperature of the reaction system is subsequently raised.

In the core formation reaction, the ratio between each precursor (e.g., the mole ratio of the tellurium precursor to the selenium precursor) or the reaction time may be appropriately selected in consideration of factors such as the emission wavelength of the final semiconductor nanoparticle, the reactivity of the precursors, and the reaction temperature. The core formation reaction temperature may be appropriately selected. The core formation reaction temperature may be greater than or equal to about 240°C, greater than or equal to about 250°C, greater than or equal to about 260°C, greater than or equal to about 270°C, greater than or equal to about 280°C, or, for example, greater than or equal to about 290°C. The reaction temperature for core formation may be in the range of about 280°C to about 340°C, for example, about 290°C to about 330°C, or about 300°C to about 320°C. The reaction time for core formation may be adjusted in consideration of the desired core size and the reactivity of the precursors, and is not particularly limited. For example, the reaction time may be greater than or equal to about 5 minutes, greater than or equal to about 30 minutes, or greater than or equal to about 50 minutes, but is not limited thereto. For example, the reaction time may be less than or equal to about 2 hours, but is not limited thereto. The formed core may be separated or may not be separated from the reaction system (e.g., by nonsolvent precipitation). The separated core may be subjected to washing, optionally, and then added to a subsequent reaction.

In an embodiment, the first particle may further include a second semiconductor nanocrystal or an intermediate shell layer including the same on the core or the first semiconductor nanocrystal. The method for forming the second semiconductor nanocrystal or the intermediate shell layer including the same is not particularly limited and may be appropriately selected.

In the method of an embodiment, forming the second semiconductor nanocrystal (or the intermediate shell layer including the same) on the first semiconductor nanocrystal includes contacting (reacting) a first zinc precursor and a chalcogen precursor (e.g., a selenium precursor and optionally a sulfur precursor) at a reaction temperature in the presence of an organic solvent and the first semiconductor nanocrystal.

The organic solvent may include a primary amine having C6 to C22 carbon atoms, such as hexadecylamine; a secondary amine having C6 to C22 carbon atoms, such as dioctylamine; a tertiary amine having C6 to C40 carbon atoms, such as trioctylamine; a nitrogen-containing heterocyclic compound such as pyridine; an olefin having C6 to C40 carbon atoms, such as octadecene; an aliphatic hydrocarbon having C6 to C40 carbon atoms, such as hexadecane, octadecane, or squalane; an aromatic hydrocarbon substituted with an alkyl group having C6 to C30 carbon atoms, such as phenyldodecane, phenyltetradecane, or phenylhexadecane; a primary, secondary, or tertiary phosphine substituted with at least one (e.g., one, two, or three) C6 to C22 alkyl groups (e.g., trioctylphosphine); a phosphine oxide substituted with one, two, or three C6 to C22 alkyl groups (e.g., trioctylphosphine oxide); an aromatic ether having C12 to C22 carbon atoms, such as phenyl ether or benzyl ether; or a combination thereof.

The organic ligand may coordinate to the surface of the resulting semiconductor nanoparticle and allow the semiconductor nanoparticle to be well dispersed in a solution. The organic ligand may include RCOOH, $RNH_2$, $R_2NH$, $R_3N$, RSH, $RH_2PO$, $R_2HPO$, $R_3PO$, $RH_2P$, $R_2HP$, $R_3P$, ROH, RCOOR', $RPO(OH)_2$, or $R_2POOH$ (wherein R and R' are each independently a substituted or unsubstituted aliphatic hydrocarbon having greater than or equal to about C1, greater than or equal to about C6, or greater than or equal to about C10 and less than or equal to about C40, less than or equal to about C35, or less than or equal to about C25, or a substituted or unsubstituted aromatic hydrocarbon having C6 to C40 carbon atoms, or a combination thereof), or a combination thereof. The ligand may be used alone or as a combination of two or more compounds.

Examples of the organic ligand may include a thiol compound such as methanethiol, ethanethiol, propanethiol, butanethiol, pentanethiol, hexanethiol, octanethiol, dodecanethiol, hexadecanethiol, octadecanethiol, and benzylthiol;

amines such as methane amine, ethane amine, propan amine, butane amine, pentyl amine, hexyl amine, octyl amine, nonyl amine, decyl amine, dodecyl amine, hexadecyl amine, octadecyl amine, dimethyl amine, diethyl amine, dipropyl amine, tributyl amine, and trioctyl amine; a carboxylic acid compound such as methanoic acid, ethanoic acid, propanoic acid, butanoic acid, pentanoic acid, hexanoic acid, heptanoic acid, octanoic acid, dodecanoic acid, hexadecanoic acid, octadecanoic acid, oleic acid, myristic acid, stearic acid, lauric acid, and benzoic acid; a phosphine compound such as methyl phosphine, ethyl phosphine, propyl phosphine, butyl phosphine, pentyl phosphine, octylphosphine, dioctyl phosphine, tributylphosphine, and trioctylphosphine; a phosphine compound such as methyl phosphine oxide, ethyl phosphine oxide, propyl phosphine oxide, butyl phosphine oxide, pentyl phosphine oxide, tributylphosphine oxide, octylphosphine oxide, dioctyl phosphine oxide, trioctylphosphine oxide, and diphenylphosphine (DPP) or an oxide compound thereof; diphenylphosphine; a triphenylphosphine compound, or an oxide compound thereof; a C5 to C20 alkyl phosphinic acid such as hexylphosphinic acid, octylphosphinic acid, dodecanephosphinic acid, tetradecanephosphinic acid, hexadecanephosphinic acid, or octadecanephosphinic acid; a C5 to C20 alkyl phosphonic acid; or the like, but embodiments are not limited thereto.

The first zinc precursor may include Zn metal powder, ZnO, an alkylated Zn compound (e.g., a C2 to C30 dialkylzinc such as diethylzinc), Zn alkoxide (e.g., zinc ethoxide), Zn carboxylate (e.g., zinc acetate), Zn nitrate, Zn perchlorate, Zn sulfate, Zn acetylacetonate, Zn halide (e.g., zinc chloride), Zn cyanide, Zn hydroxide, zinc carbonate, zinc peroxide, or a combination thereof. Examples of the zinc precursor may be dimethyl zinc, diethyl zinc, zinc acetate, zinc acetylacetonate, zinc iodide, zinc bromide, zinc chloride, zinc fluoride, zinc carbonate, zinc cyanide, zinc nitrate, zinc oxide, zinc peroxide, zinc perchlorate, zinc sulfate, or a combination thereof.

A type of indium precursor is not particularly limited and may be appropriately selected. The indium precursor may be indium powder, an alkylated indium compound, an indium alkoxide, an indium carboxylate, indium nitrate, indium perchlorate, indium sulfate, indium acetylacetonate, an indium halide, indium cyanide, indium hydroxide, indium oxide, indium peroxide, indium carbonate, or a combination thereof. The indium precursor may include indium carboxylates such as indium oleate or indium myristate, indium acetate, indium hydroxide, indium chloride, indium bromide, and indium iodide. The formation of the indium precursor may be performed under vacuum at a temperature greater than or equal to about 100°C, greater than or equal to about 120°C, and less than or equal to about 200°C.

A type of phosphorus precursor is not particularly limited and may be appropriately selected. The phosphorus precursor may include tris(trimethylsilyl) phosphine, tris(dimethylamino) phosphine, triethylphosphine, tributylphosphine, trioctylphosphine, triphenylphosphine, tricyclohexylphosphine, dimethylaminophosphine, diethylaminophosphine, or a combination thereof.

The selenium precursor may include selenium-trioctylphosphine (Se-TOP), selenium-tributylphosphine (Se-TBP), selenium-triphenylphosphine (Se-TPP), selenium-diphenylphosphine (Se-DPP), or a combination thereof, but is not limited thereto.

The tellurium precursor may include tellurium-tributylphosphine (Te-TBP), tellurium-triphenylphosphine (Te-TPP), tellurium-diphenylphosphine (Te-DPP), or a combination thereof, but is not limited thereto.

The sulfur precursor may include hexanethiol, octanethiol, decanethiol, dodecanethiol, hexadecanethiol, mercaptopropylsilane, sulfur-trioctylphosphine (STOP), sulfur-tributylphosphine (S-TBP), sulfur-triphenylphosphine (S-TPP), sulfur-trioctylamine (S-TOA), bistrialkylsilyl sulfide, bistrialkylsilylalkyl sulfide (e.g., bistrimethylsilylmethyl sulfide), ammonium sulfide, sodium sulfide, or a combination thereof.

The first particle including the first semiconductor nanocrystal and optionally the second semiconductor nanocrystal may be separated and washed, according to the methods described herein, after synthesis and before being used in a subsequent reaction (e.g., a reaction for forming a semiconductor nanocrystal shell including zinc and sulfur). The separated and washed particle may be dispersed in an appropriate organic solvent (e.g., an aromatic solvent such as toluene or an aliphatic hydrocarbon solvent such as octane) and then added to the subsequent reaction.

In an embodiment of the method, a reaction medium including the first particle, a second zinc precursor, and a sulfur precursor in an organic solvent may be heated to a reaction temperature to form a semiconductor nanocrystal layer including zinc and sulfur, and the first compound is added to the reaction medium. The first compound may be added before, during, or after the formation of the semiconductor nanocrystal layer. The second zinc precursor may include the second compound. Detailed descriptions of the first compound and the second compound are as described herein. Details regarding the first particle, the sulfur precursor, the organic ligand, and the organic solvent are also as described herein.

In an embodiment, the first compound may further include a metal ion, and the metal ion-containing metal compound (e.g., a metal acetate) and the first compound (e.g., the first compound in the form of a carboxylic acid) may be reacted at a predetermined temperature (e.g., greater than or equal to about 50°C, greater than or equal to about 100°C, greater than or equal to about 150°C and less than or equal to about 300°C, less than or equal to about 200°C, or less than or equal to about 180°C), for example under vacuum, to prepare the first compound.

The reaction temperature may be appropriately selected. In an embodiment, the vacuum-treated reaction medium may be first heated to a first temperature, followed by the addition of the first particle, the second zinc precursor, and the sulfur precursor, after which the reaction medium is further heated to the reaction temperature. The first

temperature may be lower than the reaction temperature. The temperature difference between the first temperature and the reaction temperature may be in the range of 10°C to 200°C, 30°C to 190°C, 50°C to 185°C, 70°C to 180°C, 80°C to 180°C, 90°C to 180°C, 100°C to 180°C, 120°C to 180°C, 140°C to 160°C, or a combination thereof.

In an embodiment, the first compound may be added to the reaction medium at a second temperature during or after the formation of the semiconductor nanocrystal layer having a desired thickness by heating the reaction medium to the reaction temperature. The reaction medium containing the first compound may be stirred for a predetermined time to complete the reaction.

The second temperature for the addition of the first compound may be greater than or equal to about 150°C, greater than or equal to about 170°C, greater than or equal to about 180°C, and less than or equal to the reaction temperature.

Surprisingly, the present inventors have found that, in the formation of a shell layer including zinc and sulfur, the semiconductor nanoparticle prepared by the method described herein may include the first compound and the second compound in the manner disclosed herein, and may provide improved properties and lifetime within an electroluminescent device, while exhibiting desired dispersibility for a subsequent emission layer formation process.

In a typically known ligand exchange reaction, it may be difficult for the first compound to achieve a desired degree of exchange due to, for example, excessive reaction. Surprisingly, the present inventors have found that the first compound, when introduced into the reaction medium during or after the formation of the semiconductor nanocrystal but before the completion of the reaction in the synthesis step of the semiconductor nanoparticle, can compete with the second compound for binding to the surface of the semiconductor nanoparticle and reach equilibrium. As a result, the semiconductor nanoparticle prepared by the method of an embodiment may include the first compound and the second compound in a stabilized state, and was confirmed to exhibit the desired dispersibility not only in conventional organic solvents, but also in high-boiling-point solvents or solvent mixtures for inkjet printing ink compositions, with a Hansen solubility parameter distance as described herein. The semiconductor nanoparticle of an embodiment, prepared according to the method described herein, includes the first compound and the second compound (e.g., at a desired ratio stably connected to the semiconductor nanocrystal layer), and thus was confirmed to be capable of forming a stable ink composition and an emission layer of improved quality.

The reaction temperature may be greater than or equal to about 250°C, greater than or equal to about 260°C, greater than or equal to about 270°C, greater than or equal to about 280°C, greater than or equal to about 300°C, greater than or equal to about 320°C, greater than or equal to about 340°C, or greater than or equal to about 350°C. The reaction temperature may be less than or equal to about 400°C, less than or equal to about 390°C, less than or equal to about 380°C, less than or equal to about 370°C, less than or equal to about 360°C, less than or equal to about 350°C, less than or equal to about 345°C, less than or equal to about 340°C, less than or equal to about 330°C, less than or equal to about 320°C, less than or equal to about 310°C, less than or equal to about 290°C, less than or equal to about 280°C, less than or equal to about 270°C, or less than or equal to about 250°C. In an embodiment of the method, the reaction temperature may vary in the range of about 250°C to about 340°C.

The temperature difference between the second temperature and the reaction temperature may be in the range of about 20°C to about 100°C, about 30°C to about 90°C, about 40°C to about 80°C, about 50°C to about 70°C, or about 55°C to about 65°C.

In an embodiment, the second temperature may be greater than or equal to about 155°C, greater than or equal to about 175°C, greater than or equal to about 185°C, greater than or equal to about 190°C, greater than or equal to about 195°C, greater than or equal to about 200°C, greater than or equal to about 205°C, greater than or equal to about 210°C, greater than or equal to about 220°C, greater than or equal to about 230°C, greater than or equal to about 240°C, greater than or equal to about 250°C, greater than or equal to about 260°C, greater than or equal to about 270°C, greater than or equal to about 280°C, greater than or equal to about 290°C, or greater than or equal to about 300°C. The second temperature may be less than or equal to about 380°C, less than or equal to about 360°C, less than or equal to about 340°C, less than or equal to about 320°C, less than or equal to about 300°C, less than or equal to about 295°C, less than or equal to about 285°C, less than or equal to about 275°C, less than or equal to about 265°C, less than or equal to about 255°C, or less than or equal to about 245°C.

The predetermined time is not particularly limited and may be appropriately selected. The predetermined time may be greater than or equal to about 1 minute, greater than or equal to about 3 minutes, greater than or equal to about 5 minutes, greater than or equal to about 7 minutes, or greater than or equal to about 10 minutes. The predetermined time may be less than or equal to about 2 hours, less than or equal to about 90 minutes, less than or equal to about 1 hour, less than or equal to about 50 minutes, less than or equal to about 40 minutes, less than or equal to about 30 minutes, or less than or equal to about 20 minutes.

The total reaction time for forming the semiconductor nanocrystal layer may be appropriately selected in consideration of the type of precursors, the reaction temperature, and the desired thickness of the ZnS shell layer in the final semiconductor nanoparticle. The total reaction time may be greater than or equal to about 10 minutes, greater than or equal to about 15 minutes, greater than or equal to about 20 minutes, greater than or equal to about 25 minutes,

greater than or equal to about 30 minutes, greater than or equal to about 35 minutes, or greater than or equal to about 40 minutes. The total reaction time may be less than or equal to about 200 minutes, less than or equal to about 180 minutes, less than or equal to about 160 minutes, less than or equal to about 140 minutes, less than or equal to about 120 minutes, less than or equal to about 100 minutes, less than or equal to about 90 minutes, or less than or equal to about 80 minutes.

The mole ratio between the first compound and the zinc precursor (or the second compound) may be appropriately selected in consideration of the reactivity of the compounds, the desired thickness of the semiconductor nanocrystal layer, and the desired ratio between the compounds.

In an embodiment, the amount of the first compound may be greater than or equal to about 0.1 mol, greater than or equal to about 0.2 mol, greater than or equal to about 0.24 mol, greater than or equal to about 0.3 mol, greater than or equal to about 0.4 mol, greater than or equal to about 0.45 mol, greater than or equal to about 0.5 mol, greater than or equal to about 0.55 mol, greater than or equal to about 0.6 mol, greater than or equal to about 0.65 mol, greater than or equal to about 0.7 mol, greater than or equal to about 0.75 mol, greater than or equal to about 0.8 mol, greater than or equal to about 0.85 mol, greater than or equal to about 0.9 mol, greater than or equal to about 0.95 mol, or greater than or equal to about 1 mol per 1 mol of zinc precursor (second zinc precursor). The amount of the first compound may be less than or equal to about 5 mol, less than or equal to about 3 mol, less than or equal to about 2 mol, less than or equal to about 1.9 mol, less than or equal to about 1.7 mol, less than or equal to about 1.5 mol, less than or equal to about 1.3 mol, less than or equal to about 1.1 mol, or less than or equal to about 0.9 mol per 1 mol of zinc precursor. The mole ratios among the precursors in the reaction may be appropriately selected in consideration of the reactivity of the precursors, the reaction temperature, the desired thickness of the semiconductor nanocrystal layer, etc., and are not particularly limited.

After the completion of the reaction, the first semiconductor nanocrystal, the first particle, or the resulting semiconductor nanoparticle may be recovered by pouring an excess amount of a non-solvent to remove excess organic materials uncoordinated to the surface, and subjecting the resulting mixture to centrifugation. For example, after the reaction is completed, if a nonsolvent is added to the reaction product, the semiconductor nanoparticles coordinated with the ligand compound may be separated. The nonsolvent may be a polar solvent that is miscible with the solvent used in the core formation and/or shell formation reactions and is not capable of dispersing the produced nanocrystal. The nonsolvent may be selected depending on the solvent used in the reaction and may include, for example, acetone, ethanol, butanol, isopropanol, ethanediol, water, tetrahydrofuran (THF), dimethylsulfoxide (DMSO), diethylether, formaldehyde, acetaldehyde, ethylene glycol, a solvent having a similar solubility parameter to the foregoing solvents, or a combination thereof. The separation may be performed through centrifugation, sedimentation, chromatography, or distillation. The separated nanocrystal may be added to a washing solvent and washed, if needed. The washing solvent has no particular limit and may have a similar solubility parameter to that of the ligand and may, for example, include hexane, heptane, octane, chloroform, toluene, benzene, and the like.

The semiconductor nanoparticle of an embodiment may be non-dispersible or water-insoluble in water, the aforementioned nonsolvent, or a combination thereof. The semiconductor nanoparticle of an embodiment may be dispersed in the aforementioned organic solvent. In an embodiment, the semiconductor nanoparticle may be dispersed in C6 to C40 aliphatic hydrocarbon, C6 to C40 substituted or unsubstituted aromatic hydrocarbon, or a combination thereof.

The obtained semiconductor nanoparticle may exhibit the property described herein.

The semiconductor nanoparticle of an embodiment may be used for forming a composition (ink) for an inkjet printing process and provide a light emitting layer pattern through the inkjet printing process. A composition for an inkjet process may include semiconductor nanoparticle and a liquid vehicle, in an embodiment. The semiconductor nanoparticle of an embodiment may form a colloidal dispersion within the liquid vehicle. At least a portion of the liquid vehicle may be removed from the light emitting layer after the inkjet process. The liquid vehicle may include an organic solvent. The organic solvent may include a dispersing solvent as described herein. The organic solvent may be an organic solvent having a relatively high boiling point at normal or atmospheric pressure. The boiling point of the organic solvent or liquid vehicle may be greater than or equal to about 120 °C, greater than or equal to about 130 °C, greater than or equal to about 140 °C, greater than or equal to about 150 °C, greater than or equal to about 160 °C, greater than or equal to about 170 °C, or greater than or equal to about 180 °C. The boiling point of the organic solvent may be less than or equal to about 300 °C, less than or equal to about 280 °C, less than or equal to about 270 °C, less than or equal to about 250 °C, or less than or equal to about 200 °C. The organic solvent may include a substituted or unsubstituted aromatic solvent such as cyclohexylbenzene, a substituted or unsubstituted C6 to C15 aliphatic hydrocarbon solvent such as hexane, octane, decane, or a combination thereof. When using a mixed solvent, the mixing ratio can be adjusted considering a condition for the inkjet process (e.g., boiling point, viscosity, or the like). The mixed solvent may include at least one (e.g., at least two) aromatic solvent, at least one (e.g., at least two) aliphatic solvent, or at least one (e.g., at least two) aromatic solvent and at least one (e.g., at least two) aliphatic solvent. In the mixed solvent of an embodiment, a ratio between the solvents, e.g., the aromatic solvents, the aliphatic solvents, or the aromatic solvent and the aliphatic solvent may be adjusted to about 1:0.1 to about 1:10, about 1:0.3 to about 1:3, about 1:0.5 to about 1:2 (volume:volume), but is not limited thereto.

The ink composition including the semiconductor nanoparticle may exhibit a viscosity required in an inkjet

printing process. A viscosity may range from about 0.5 centipoise (cPs) to about 30 cPs, about 1 cPs to about 15 cPs, about 1.5 cPs to about 10 cPs, about 2 cPs to about 8 cPs, about 2.5 cPs to about 5 cPs, about 2.8 cPs to about 3.5 cPs, or a combination thereof.

The composition for inkjet printing process may exhibit surface tension or wettability with respect to a common layer, for example, a hole auxiliary layer or an electron auxiliary layer. The surface tension may range from about 10 milliNewton per meter (mN/m) to about 100 mN/m, about 15 mN/m to about 80 mN/m, about 20 mN/m to about 50 mN/m, about 25 mN/m to about 45 mN/m, about 30 mN/m to about 40 mN/m, about 33 mN/m to about 38 mN/m, or a combination thereof.

Forming a light emitting layer by inkjet printing may include placing or accommodating an ink composition including the semiconductor nanoparticle in a device equipped with an inkjet printing nozzle, and ejecting/depositing a droplet of the composition from the nozzle toward a desired location (e.g., a hole transport layer or electron transport layer surface defined by a partition wall or bank such as a pixel defining layer (PDL). (See FIG. 4 and FIG. 5)

In the electroluminescent device of an embodiment, a thickness of the light emitting layer can be appropriately selected. In an embodiment, the light emitting layer 3 or 30 may include a monolayer(s) of semiconductor nanoparticles. In another embodiment, the light emitting layer 3 or 30 may include one or more monolayers of semiconductor nanoparticles, for example, two or more layers, three or more layers, or four or more layers, and 20 layers or less, 10 layers or less, 9 layers or less, 8 layers or less, 7 layers or less, or 6 layers or less. The light emitting layer 3 or 30 may have a thickness of greater than or equal to about 5 nm, for example, greater than or equal to about 10 nm, greater than or equal to about 20 nm, or greater than or equal to about 30 nm and less than or equal to about 200 nm, for example, less than or equal to about 150 nm, less than or equal to about 100 nm, less than or equal to about 90 nm, less than or equal to about 80 nm, less than or equal to about 70 nm, less than or equal to about 60 nm, or less than or equal to about 50 nm. The light emitting layer may have a thickness of, for example about 10 nm to about 150 nm, for example about 20 nm to about 100 nm, for example about 30 nm to about 50 nm, or a combination thereof.

The formation of the light emitting layer including the semiconductor nanoparticle may be performed by obtaining a composition including the semiconductor nanoparticle and an organic solvent and applying or depositing it on a substrate or a charge auxiliary layer by an appropriate method (e.g., by spin coating, inkjet printing, or the like). The forming of the light emitting layer may further include heat-treating the applied or deposited semiconductor nanoparticle layer. The heat-treating temperature is not particularly limited and may be appropriately selected considering the boiling point of the organic solvent, or the like. For example, the heat-treating temperature may be greater than or equal to about 60 °C, for example, greater than or equal to about 70 °C and less than or equal to about 250 °C, or less than or equal to about 180 °C. The type of the organic solvent is not particularly limited and may be appropriately selected. In an embodiment, the organic solvent may include a (substituted or unsubstituted) aliphatic hydrocarbon organic solvent, a (substituted or unsubstituted) aromatic hydrocarbon organic solvent, an acetate solvent, or a combination thereof.

The light emitting layer may have a single layer or a multilayer structure in which two or more layers are stacked. Adjacent layers in a multilayer structure (e.g., the first emitting layer and the second emitting layer) may be configured to emit the light of the same color (green light, blue light, or red light). In a multilayer structure, adjacent layers (e.g., a first light emitting layer and a second light emitting layer) may have the same or different compositions and/or ligands from each other.

The electroluminescent device may include a charge (hole or electron) auxiliary layer between the first electrode and the second electrode (e.g., the first electrode 10 and the second electrode 50). For example, the electroluminescent display device may include a hole auxiliary layer (HTL) 20 or an electron auxiliary layer (ETL) 40 between the first electrode 10 and the light emitting layer 30 and/or between the second electrode 50 and the light emitting layer 30 (Refer to FIGS. 2 and 3).

The light emitting device according to an embodiment may further include a hole auxiliary layer. The hole auxiliary layer 20 may be disposed between the first electrode 10 and the light emitting layer 30. The hole auxiliary layer 20 may include a hole injection layer, a hole transport layer, and/or an electron (or hole) blocking layer. The hole auxiliary layer 20 may be a layer of a single component or a multilayer structure in which adjacent layers include different components.

The hole auxiliary layer 20 may have a HOMO energy level that can be matched with the HOMO energy level of the light emitting layer 30 (e.g., 30R, 30G, or 30B) in order to enhance mobility of holes transferred from the hole auxiliary layer 20 to the light emitting layer 30. In an embodiment, the hole auxiliary layer 20 may include a hole injection layer close to the first electrode 10 and a hole transport layer close to the light emitting layer 30.

The material included in the hole auxiliary layer 20 (e.g., a hole transport layer, a hole injection layer, or an electron blocking layer) is not particularly limited, and may include at least one of, for example, poly(9,9-dioctyl-fluorene-co-N-(4-butylphenyl)-diphenylamine) (TFB), polyarylamine, poly(N-vinylcarbazole), poly(3,4-ethylenedioxythiophene) (PEDOT), poly(3,4-ethylenedioxythiophene) : polystyrene sulfonate (PEDOT:PSS), polyaniline, polypyrrole, a fluorene aryl amine compound, N,N,N',N'-tetrakis(4-methoxyphenyl)-benzidine (TPD), 4,4'-bis[N-(1-naphthyl)-N-phenyl-amino]biphenyl (α-NPD), m-MTDATA (4,4',4"-Tris[phenyl(m-tolyl)amino]triphenylamine), 4,4',4"-tris(N-carbazolyl)-triphenylamine (TCTA), 1,1-bis[di(4-toyl)aminophenyl]cyclohexane (TAPC), a p-type metal oxide (e.g., NiO, $WO_3$, $MoO_3$, or the like), a carbon-containing material such as graphene oxide, or a combination thereof, but is not limited thereto.

In the hole auxiliary layer(s), the thickness of each layer may be appropriately selected. For example, the thickness of each layer may be greater than or equal to about 5 nm, greater than or equal to about 10 nm, greater than or equal to about 15 nm, or greater than or equal to about 20 nm and less than or equal to about 100 nm, less than or equal to about 90 nm, less than or equal to about 80 nm, less than or equal to about 70 nm, less than or equal to about 60 nm, less than or equal to about 50 nm, less than or equal to about 40 nm, less than or equal to about 35 nm, or less than or equal to about 30 nm, but is not limited thereto.

The electronic auxiliary layer 40 may be disposed between the light emitting layer 30 and the second electrode 50. The electron auxiliary layer 40 may include, for example, an electron injection layer, an electron transport layer, and/or a hole (or electron) blocking layer. The electron auxiliary layer may include, for example, an electron injection layer (EIL) to facilitate electron injection, an electron transport layer (ETL) to facilitate electron transport, a hole blocking layer (HBL) to inhibit hole transport, or a combination thereof.

In an embodiment, the electron injection layer may be disposed between the electron transport layer and the second electrode. For example, the hole blocking layer may be disposed between the emission layer and the electron transport (injection) layer, but is not limited thereto. A thickness of each layer may be appropriately selected. For example, a thickness of each layer may be greater than or equal to about 1 nm and less than or equal to about 500 nm, but is not limited thereto. The electron injection layer may be an organic layer formed by deposition. The electron transport layer may include an inorganic oxide nanoparticle or may be an organic layer formed by deposition.

The electron transport layer (ETL), electron injection layer (EIL), and/or hole blocking layer may include, for example 1,4,5,8-naphthalene-tetracarboxylic dianhydride (NTCDA), bathocuproine (BCP), tris[3-(3-pyridyl)-mesityl]borane (3TPYMB), LiF, tris(8-hydroxyquinoline)aluminum ($Alq_3$), tris(8-hydroxyquinoline)gallium ($Gaq_3$), tris-(8-hydroxyquinoline)indium ($Inq_3$), bis(8-hydroxyquinoline)zinc ($Znq_2$), bis(2-(2-hydroxyphenyl)benzothiazolate)zinc ($Zn(BTZ)_2$), bis(10-hydroxybenzo[h]quinolinato)beryllium ($BeBq_2$), 8-(4-(4,6-di(naphthalen-2-yl)-1,3,5-triazin-2-yl)phenyl)quinolone (ET204), 8-hydroxyquinolinato lithium (Liq), n-type metal oxide (e.g., ZnO, $HfO_2$, or the like), and a combination thereof, but is not limited thereto.

The electron auxiliary layer 40 may include an electron transport layer. The electron transport layer may include a plurality of nanoparticles. The plurality of nanoparticles may include a metal oxide including zinc.

The metal oxide may include zinc oxide, zinc magnesium oxide, or a combination thereof. The metal oxide may include $Zn_{1-x}M_xO$ (wherein, M is Mg, Ca, Zr, W, Li, Ti, Y, Al, or a combination thereof and $0 \leq x \leq 0.5$). In an embodiment, M in $Zn_{1-x}M_xO$ may be magnesium (Mg). In an embodiment, x in $Zn_{1-x}M_xO$ may be greater than or equal to about 0.01 and less than or equal to about 0.3, for example, less than or equal to about 0.25, less than or equal to about 0.2, or less than or equal to about 0.15.

The absolute value of the LUMO of the aforementioned nanoparticles included in the emitting layer may be greater or smaller than the absolute value of the LUMO of the metal oxide. The average size of the nanoparticle may be greater than or equal to about 1 nm, greater than or equal to about 1.5 nm, greater than or equal to about 2 nm, greater than or equal to about 2.5 nm, or greater than or equal to about 3 nm and less than or equal to about 10 nm, less than or equal to about 9 nm, less than or equal to about 8 nm, less than or equal to about 7 nm, less than or equal to about 6 nm, or less than or equal to about 5 nm.

In an embodiment, the thickness of each of the electron auxiliary layers 40 (e.g., electron injection layer, electron transport layer, or hole blocking layer) may be greater than or equal to about 5 nm, greater than or equal to about 6 nm, greater than or equal to about 7 nm, greater than or equal to about 8 nm, greater than or equal to about 9 nm, greater than or equal to about 10 nm, greater than or equal to about 11 nm, greater than or equal to about 12 nm, greater than or equal to about 13 nm, greater than or equal to about 14 nm, greater than or equal to about 15 nm, greater than or equal to about 16 nm, greater than or equal to about 17 nm, greater than or equal to about 18 nm, greater than or equal to about 19 nm, or greater than or equal to about 20 nm, and less than or equal to about 120 nm, less than or equal to about 110 nm, less than or equal to about 100 nm, less than or equal to about 90 nm, less than or equal to about 80 nm, less than or equal to about 70 nm, less than or equal to about 60 nm, less than or equal to about 50 nm, less than or equal to about 40 nm, less than or equal to about 30 nm, or less than or equal to about 25 nm, but is not limited thereto.

A device according to an embodiment may have a normal structure. In an embodiment, in the device, the first electrode 10 disposed on the transparent substrate 100 may include a metal oxide-containing transparent electrode (e.g., an indium tin oxide (ITO) electrode), and the second electrode (cathode) 50 facing the first electrode 10 may include a conductive metal (e.g., having a relatively low work function, Mg, Al, or the like). The hole auxiliary layer 20 (e.g., a hole injection layer such as poly(3,4-ethylenedioxythiophene) :polystyrene sulfonate (PEDOT:PSS) and/or p-type metal oxide and/or a hole transport layer such as 2-(trifluoromethyl)benzimidazole (TFB) and/or polyvinylcarbazole (PVK) may be provided between the first electrode 10 and the light emitting layer 30. The hole injection layer may be disposed close to the transparent electrode and the hole transport layer may be disposed close to the light emitting layer. The electron auxiliary layer 40 such as an electron injection/transport layer may be disposed between the light emitting layer 30 and the second electrode 50. (See FIG. 2)

A device according to another embodiment may have an inverted structure. As used herein, the second electrode 50 disposed on the transparent substrate 100 may include a metal oxide-containing transparent electrode (e.g., ITO), and the first electrode 10 facing the second electrode 50 may include a metal (e.g., having a relatively high work function, Au, Ag, or the like). For example, an (optionally doped) n-type metal oxide (crystalline Zn metal oxide) or the like may be disposed as an electron auxiliary layer 40 (e.g., an electron transport layer) between the second electrode 50 and the light emitting layer 30. $MoO_3$ or other p-type metal oxide may be disposed as a hole auxiliary layer 20 (e.g., a hole transport layer including TFB and/or PVK and/or a hole injection layer including $MoO_3$ or other p-type metal oxide) between the first electrode 10 and the light emitting layer 30. (Refer to FIG. 3)

The aforementioned device may be manufactured by an appropriate method. For example, the electroluminescent device may be manufactured by optionally forming a hole auxiliary layer (e.g., by deposition or coating) on a substrate on which an electrode is provided, forming a light emitting layer including nanoparticles (e.g., a pattern of the aforementioned semiconductor nanoparticles), and forming (optionally, an electron auxiliary layer and) an electrode (e.g., by vapor deposition or coating) on the light emitting layer. A method of forming the electrode/hole auxiliary layer/electron auxiliary layer may be appropriately selected and is not particularly limited. In an embodiment, each layer included in the hole transport region, each layer included in the light emitting layer, and each layer included in the electron transport region may be formed in a predetermined region using various methods, such as a vacuum deposition method, a spin coating method, a casting method, a Langmuir-Blodgett (LB) method, an inkjet printing method, a laser printing method, a laser induced thermal imaging (LITI) method, or the like For example, the light emitting layer may be formed by an inkjet printing method. The inkjet process is as described herein.

In an embodiment, each layer included in the hole transport region, the light emitting layer, and each layer included in the electron transport region are formed by a vacuum deposition method, and the deposition condition may be appropriately selected. For example, a deposition temperature may be about 100 °C to about 500 °C, a vacuum degree may be about $10^{-8}$ to about $10^{-3}$ torr, a deposition rate may be in the range of about 0.01 to about 100 angstrom/sec (Å/sec). The deposition condition may be selected by considering the material to be included in the layer to be formed and the structure of the layer to be formed.

The electroluminescent device may be configured to emit blue light. A wavelength range of the blue light is as described above. The electroluminescent device may be configured to emit green light. A wavelength range of green light is as described above. The electroluminescent device may be configured to emit red light. A wavelength range of red light is as described above.

The electroluminescent device may have a maximum external quantum efficiency of greater than or equal to about 4%, greater than or equal to about 5%, greater than or equal to about 5.3%, greater than or equal to about 5.4%, greater than or equal to about 6%, greater than or equal to about 7%, greater than or equal to about 8%, greater than or equal to about 9%, greater than or equal to about 10%, greater than or equal to about 10.5%, greater than or equal to about 11%, greater than or equal to about 11.5%, greater than or equal to about 12%, greater than or equal to about 12.5%, greater than or equal to about 13%, greater than or equal to about 13.5%, or greater than or equal to about 14%. The electroluminescent device may have a maximum external quantum efficiency of less than or equal to about 50%, less than or equal to about 40%, less than or equal to about 30%, or less than or equal to about 20%.

The electroluminescent device may have a maximum luminance of greater than or equal to about 1000 nit ($cd/m^2$), greater than or equal to about 3000 nit, greater than or equal to about 10,000 nit, greater than or equal to about 40,000 nit, greater than or equal to about 50,000 nit, greater than or equal to about 60,000 nit, greater than or equal to about 70,000 nit, greater than or equal to about 80,000 nit, greater than or equal to about 90,000 nit, greater than or equal to about 95,000 nit, greater than or equal to about 100,000 nit, greater than or equal to about 105,000 nit, greater than or equal to about 110,000 nit, greater than or equal to about 115,000 nit, greater than or equal to about 120,000 nit, or greater than or equal to about 125,000 nit. The maximum luminance may be about 3000 nit to about 500,000 nit.

The electroluminescent device can exhibit improved life-span. In an embodiment, the life-span of the electroluminescent device can be measured while driving at a predetermined initial luminance (e.g., about 146 nit or about 650 nit).

The life-span T50 of the electroluminescent device may be greater than or equal to about 10 hours, greater than or equal to about 50 hours, greater than or equal to about 80 hours, greater than or equal to about 100 hours, greater than or equal to about 120 hours, greater than or equal to about 130 hours, greater than or equal to about 150 hours, greater than or equal to about 160 hours, greater than or equal to about 200 hours, greater than or equal to about 250 hours, greater than or equal to about 260 hours, greater than or equal to about 270 hours, greater than or equal to about 300 hours, greater than or equal to about 308 hours, greater than or equal to about 310 hours, greater than or equal to about 320 hours, greater than or equal to about 350 hours, greater than or equal to about 380 hours, greater than or equal to about 400 hours, greater than or equal to about 450 hours, greater than or equal to about 500 hours, greater than or equal to about 600 hours, greater than or equal to about 700 hours, greater than or equal to about 800 hours, greater than or equal to about 900 hours, greater than or equal to about 1000 hours, greater than or equal to about 1500 hours or more.

The life-span T90 of the electroluminescent device may be greater than or equal to about 10 hours, greater than

or equal to about 15 hours, greater than or equal to about 20 hours, greater than or equal to about 25 hours, greater than or equal to about 30 hours, greater than or equal to about 33 hours, greater than or equal to about 35 hours, greater than or equal to about 40 hours, greater than or equal to about 45 hours, greater than or equal to about 50 hours, greater than or equal to about 75 hours, greater than or equal to about 100 hours, greater than or equal to about 125 hours, greater than or equal to about 150 hours, greater than or equal to about 175 hours, greater than or equal to about 180 hours, greater than or equal to about 200 hours, greater than or equal to about 210 hours, greater than or equal to about 300 hours, greater than or equal to about 310 hours, greater than or equal to about 350 hours, greater than or equal to about 380 hours, greater than or equal to about 400 hours, greater than or equal to about 450 hours, greater than or equal to about 500 hours, greater than or equal to about 600 hours, greater than or equal to about 700 hours, greater than or equal to about 800 hours, greater than or equal to about 900 hours, greater than or equal to about 1000 hours, greater than or equal to about 1500 hours, or more.

In an embodiment, T50 may be about 150 hours to about 5000 hours, about 400 hours to about 4000 hours, about 500 hours to about 3500 hours, about 750 hours to about 2000 hours, about 1000 hours to about 1500 hours, or a combination thereof.

In an embodiment, T90 may be in a range of about 13 hours to about 5000 hours, about 15 hours to about 2800 hours, about 18 hours to about 1200 hours, about 22 hours to about 1000 hours, about 31 hours to about 800 hours, about 50 hours to about 700 hours, about 60 hours to about 500 hours, about 80 hours to about 400 hours, or a combination thereof.

In an embodiment, a display device (e.g., a display panel) includes the electroluminescent device described herein.

The display device (e.g., a display panel) may include a first pixel and a second pixel configured to emit light of a different color from the first pixel. In an embodiment, the first light from the light emitting layer may be extracted (e.g., in the z direction) through the second electrode (Refer to FIG. 4 or FIG. 5). In an embodiment, the first light may be extracted through the (transparent) first electrode and optionally the substrate 100 (Refer to FIG. 3). The light emitting layer may be arranged within a pixel (or subpixel) in a display device (display panel) described later. (Refer to FIG. 4 or FIG. 5)

Referring to FIG. 6, a display panel 1000 according to an embodiment may include a display area 1000D for displaying an image and, optionally, a non-display area 1000P located around the display area 1000D and having a bonding material disposed thereon.

The display area 1000D may include a plurality of pixels PX arranged along rows (e.g., in the x direction) and/or columns (e.g., in the y direction), and each pixel PX may include a plurality of subpixels $PX_1$, $PX_2$, and $PX_3$ that display different colors. Here, as an example, a configuration in which three subpixels $PX_1$, $PX_2$, and $PX_3$ form one pixel is illustrated, but the present disclosure is not limited thereto and may further include additional subpixels such as a white subpixel, or may further include one or more subpixels displaying the same color. The plurality of subpixels $PX_1$, $PX_2$, and $PX_3$ may be arranged in, for example, a Bayer matrix, a PenTile matrix, and/or a diamond matrix, but is not limited thereto.

Each subpixel $PX_1$, $PX_2$, and $PX_3$ may display a color of three primary colors or a combination of three primary colors, for example, red, green, blue, or a combination thereof. For example, a first subpixel $PX_1$ may display red, a second subpixel $PX_2$ may display green, and a third subpixel $PX_3$ may display blue.

Although the drawing illustrates an example in which all subpixels have the same size, the present disclosure is not limited thereto, and at least one of the subpixels may be larger or smaller than the other subpixels. Although the drawing illustrates an example in which all subpixels have the same shape, the present disclosure is not limited thereto, and at least one of the subpixels may have a different shape from the other subpixels.

In an embodiment, the display panel may include a light emitting panel (refer to FIG. 7) including a substrate 110, a buffer layer 111, a thin film transistor TFT, and a light emitting device 180. The display panel may include circuit elements for switching and/or driving each light emitting device.

Referring to FIG. 7, in the light emitting panel, light emitting devices 180 may be arranged in each subpixel $PX_1$, $PX_2$, and $PX_3$, and the light emitting devices 180 arranged in the subpixels $PX_1$, $PX_2$, and $PX_3$ may be driven independently. The subpixel may include a blue pixel, a red pixel, or a green pixel. At least one of the light emitting devices 180 may be an electroluminescent device according to an embodiment.

The substrate 110 is as described above. The buffer layer 111 may include an organic, inorganic, or organic-inorganic material, and may include, for example, an oxide, a nitride or an oxynitride, and may include, for example, silicon oxide, silicon nitride, silicon oxynitride, or a combination thereof, but is not limited thereto. The buffer layer 111 may have one layer or two or more layers and may cover the entire surface of the substrate 110. The buffer layer 111 may be omitted.

The thin film transistor TFT may be a three-terminal device for switching and/or driving a light emitting device 180, and one or more thin film transistors TFT may be included for each subpixel. The thin film transistor TFT includes a gate electrode 124, a semiconductor layer 154 overlapped with the gate electrode 124, a gate insulating film 140 between the gate electrode 124 and the semiconductor layer 154, and a source electrode 173 and a drain electrode 175 electrically connected to the semiconductor layer 154. A coplanar top gate structure is shown as an example, but is not limited thereto and the thin film transistor TFT may have various structures.

The gate electrode 124 is electrically connected to a gate line (not shown) and may include a low-resistance metal

such as aluminum (Al), molybdenum (Mo), copper (Cu), titanium (Ti), silver (Ag), gold (Au), alloys thereof, or a combination thereof, but is not limited thereto.

The semiconductor layer 154 may be an inorganic semiconductor such as amorphous silicon, polycrystalline silicon, an oxide semiconductor; an organic semiconductor; an organic-inorganic semiconductor; or a combination thereof. For example, the semiconductor layer 154 may include an oxide semiconductor including at least one of indium (In), zinc (Zn), tin (Sn), and gallium (Ga), and the oxide semiconductor may include, for example, indium-gallium-zinc oxide, zinc-tin oxide, or a combination thereof, but is not limited thereto. The semiconductor layer 154 may include a channel region and a doped region disposed on both sides of the channel region and electrically connected to the source electrode 173 and the drain electrode 175, respectively.

The gate insulating film 140 may include an organic, inorganic, or organic-inorganic material, and may include, for example, an oxide, a nitride or an oxynitride, and may include, for example, silicon oxide, silicon nitride, silicon oxynitride, or a combination thereof, but is not limited thereto. The drawing shows an example in which the gate insulating film 140 is formed on the entire surface of the substrate 110, but is not limited thereto and the gate insulating film 140 may be selectively formed between the gate electrode 124 and the semiconductor layer 154. The gate insulating film 140 may have one layer or two or more layers.

The source electrode 173 and the drain electrode 175 may include a low-resistance metal such as aluminum (Al), molybdenum (Mo), copper (Cu), titanium (Ti), silver (Ag), gold (Au), alloys thereof, or a combination thereof, but is not limited thereto. The source electrode 173 and the drain electrode 175 may each be electrically connected to the doping region of the semiconductor layer 154. The source electrode 173 may be electrically connected to a data line (not shown), and the drain electrode 175 is electrically connected to a light emitting device 180 described later.

An interlayer insulating film 145 may be additionally formed between the gate electrode 124 and the source/drain electrodes 173 and 175. The interlayer insulating film 145 may include an organic, inorganic, or organic-inorganic material, and may include, for example, an oxide, a nitride or an oxynitride, and may include, for example, silicon oxide, silicon nitride, silicon oxynitride, or a combination thereof, but is not limited thereto. The interlayer insulating film 145 may have one layer or two or more layers.

In an embodiment, a protective film 160 may be formed on a thin film transistor TFT. The protective film 160 may be, for example, a passivation film, but is not limited thereto. The protective film 160 may include an organic, inorganic, or organic-inorganic material, and may include polyacrylic acid, polyimide, polyamide, polyamideimide, or a combination thereof, but is not limited thereto. The protective film 160 may have one or more layers.

In an embodiment, one of the first electrodes 1 and 10 and the second electrodes 5 and 50 may be a pixel electrode connected to the thin film transistor TFT and the other may be a common electrode.

The electroluminescent device of an embodiment or the display device including the same may be used in a top emission manner, a bottom emission manner, a double-sided emission manner, or a combination thereof.

In an embodiment, the first electrode 1, 10 may be a light transmitting electrode and the second electrode 5, 50 may be a reflective electrode, and the display panel may be a bottom emission type display panel that emits light toward the first electrode 10 and, if present, the substrate 110. In an embodiment, the first electrode 1, 10 may be a reflective electrode and the second electrode 5, 50 may be a light transmitting electrode, and the display panel may be a top emission type display panel that emits light opposite the first electrode 10 and, if present, the substrate 100. In an embodiment, both the first electrode and the second electrode may be light transmitting electrodes, and the display panel 1000 may be a both side emission type display panel that emits light to the substrate 110 side and the opposite side of the substrate 110.

The display device may include or may be a device or apparatus such as a virtual reality / augmented reality (VR/AR) device, a wearable device, a portable terminal device, a monitor, a computer, a laptop, a sensor, a television, an electronic display board, a camera, or an electrical component (for example, for an automobile).

Hereinafter, specific examples are illustrated. However, these examples are exemplary, and the present disclosure is not limited thereto.

## Examples

### Analysis Methods

#### 1. Photoluminescence (PL) Analysis and TRPL Analysis

The photoluminescence spectrum and absolute quantum yield (QY) of the nanoparticles were obtained at room temperature with an excitation wavelength of 372 nm using a Hitachi F-7000 spectrophotometer or a Hamamatsu QY instrument (Quantaurus-QY Absolute PL quantum yield spectrophotometer C11347-11).

2. GC Analysis

Gas chromatography analysis was performed using an Agilent GC-MS 7890B/5977A. No standard substances were used.

After separating the crude containing the manufactured semiconductor nanoparticles twice with ethanol (EtOH) and vacuum drying, 0.1 milligrams (mg) of the manufactured semiconductor nanoparticles + 1 microliter (μL) of TMAH (tetramethylammonium hydroxide) were mixed and left in the hood for 2 minutes before performing py-GC/MS measurement.

Pyrolyzer temperature: 450°C
Column: 30m×0.25mm×0.25 mm (UA5)
Flow phase: $He_2$ (1 milliliters per minute (mL/min))
Inlet temperature: 300°C
Oven temperature: 50°C (held for 2 min), increases up to 320°C at 20°C/min (held for 10 min)
Analyzer: quadrupole (range: 10 to 550 m/z)

3. TGA

A thermogravimetric analysis was performed using a Trios V3.2 system (TA Instruments) under nitrogen gas at a heating rate of 10°C/min from 20°C to 600°C. The weight loss from 200°C to 550°C was measured as the organic content.

4. Electroluminescence Measurement and Lifespan

A current according to an applied voltage is measured with a Keithley 2635B source meter, and a CS2000 spectrometer is used to measure electroluminescent properties (e.g., luminance and EQE) of a light-emitting device.

T90(hr): The time (hours) it takes for the luminance to reach 90% of the initial luminance when driven at a predetermined luminance (e.g., 650 nits or 146 nits) was measured.

T50(hr): The time (hours) it takes for the luminance to reach 50% of the initial luminance when driven at a predetermined luminance (e.g., 650 nits or 146 nits) was measured.

The following synthesis is performed under an inert gas atmosphere (e.g., under nitrogen) unless otherwise specified. A precursor content is provided as a molar content, unless otherwise specified.

Reference Example 1: Synthesis of ZnMgO Nanoparticle

Zinc acetate dihydrate and magnesium acetate tetrahydrate were added to a reactor containing dimethylsulfoxide and then, heated to 60 °C in the air. Subsequently, an ethanol solution of tetramethylammonium hydroxide pentahydrate was added to the reactor. After stirring the mixture for 1 hour, precipitates were centrifuged and then dispersed in ethanol to obtain a $Zn_{1-x}Mg_xO$ nanoparticle (x = 0.15).

The obtained nanoparticles were subjected to transmission electron microscope analysis. As a result, the nanoparticles were confirmed to have an average size of about 3 nm.

Reference Example 2: Production of First Particle

Selenium (Se), sulfur (S), and tellurium (Te) were dispersed in trioctylphosphine (TOP) to obtain 2 molar (M) Se/TOP stock solution, 1 M S/TOP stock solution, and 0.1 M Te/TOP stock solution.

4.5 millimoles (mmol) of zinc acetate was added with oleic acid (OA) to a 300 milliliters (mL) reaction flask containing trioctylamine (TOA) and then, heated to 120 °C under vacuum, and after 1 hour, an atmosphere inside the reactor was converted to an inert gas.

After heating the flask to 240 °C to 300 °C, the prepared Se/TOP and Te/TOP stock solutions were rapidly injected thereinto at a Te/Se ratio = 1/15. A reaction proceeded for 40 minutes. When the reaction was completed, after rapidly cooling the reaction solution to room temperature, ethanol was added thereto and then, centrifuged to obtain ZnTeSe semiconductor nanocrystals. The obtained precipitates were dispersed in hexane to obtain ZnSeTe cores. The cores had an average size of about 3 nm.

Zinc acetate was added with oleic acid to a 300 mL reaction flask containing TOA and then, vacuum-treated at 120 °C. The atmosphere inside flask was substituted with nitrogen ($N_2$). The reaction flask was heated to a reaction temperature of 340 °C. After rapidly adding the hexane dispersion of the ZnSeTe cores to the reaction flask, the Se/TOP stock solution was subsequently added thereto to proceed with a reaction. To form a ZnSe shell, the selenium precursor was used in an amount of 0.67 mole per 1 mole of the zinc precursor.

After the reaction was completed, the reactor was cooled to room temperature, and ethanol was added to the reaction solution to precipitate first particle including first semiconductor nanocrystals (ZnTeSe) and second semiconductor nanocrystals (ZnSe). The precipitates, which were recovered through centrifugation.

Preparation Example 1:

Zinc acetate and oleic acid were respectively added to trioctylamine and then, heated at 120 °C for 1 hour under vacuum to prepare a second zinc precursor.

After adding trioctylamine to a 300 mL reaction flask, the flask was heated to 120 °C for 1 hour under vacuum and then, the atmosphere thereinside was substituted with nitrogen ($N_2$). While raising the flask temperature to the reaction temperature (340°C), a hexane dispersion of the first particle prepared in Reference Example 2 was added. Subsequently, the second zinc precursor and dodecanethiol (sulfur precursor) were each added to the reaction system in two separate portions.

After 40 minutes, the reaction temperature was lowered to 280°C, and 4-phenylbutanoic acid (4PhBA) having the following chemical formula (CAS No. 1821-12-1, manufactured by Sigma-Aldrich) was injected into the reaction system, and the reaction was continued:

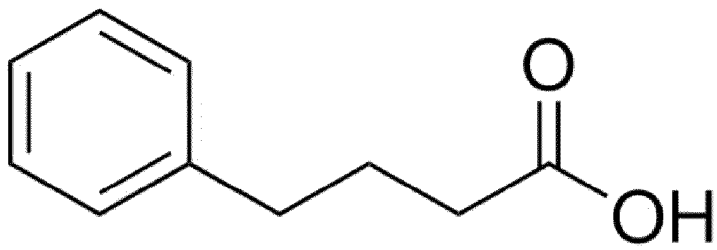

The total reaction time was 70 minutes.

The mole ratio between the second zinc precursor and the sulfur precursor was 2.5:1.4. The mole ratio between the second zinc precursor and phenylbutanoic acid was 2.5:0.6.

After cooling the reactor to room temperature, ethanol was added to the reaction solution to promote precipitation of the semiconductor nanoparticles, which were then recovered by centrifugation. The obtained semiconductor nanoparticles were dispersed in octane.

Photoluminescence spectroscopy analysis and thermogravimetric analysis (TGA) were performed on the obtained semiconductor nanoparticles, and the results are summarized in Table 1.

A gas chromatography (GC) analysis was conducted on the obtained semiconductor nanoparticles, and the results are summarized in Table 2.

According to GC-MS analysis, a first peak was identified at a retention time of 9.05 minutes corresponding to a phenylbutanoic acid ester moiety, and a second peak was identified at a retention time of 13.13 minutes corresponding to an oleic acid ester moiety.

Preparation Example 2:

A semiconductor nanoparticle was produced in the same manner as in Preparation Example 1, except that 6-phenylhexanoic acid (6PhHA) represented by the following chemical formula (phenyl hexanoic acid, CAS No. 5581-75-9, manufactured by Sigma Aldrich) was used instead of 4-phenylbutanoic acid:

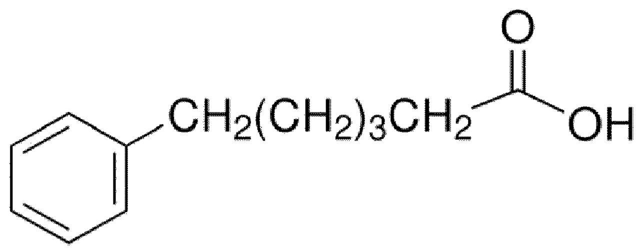

The reactor was cooled to room temperature, and ethanol was added to the reaction solution to promote precipitation of the semiconductor nanoparticles, which were recovered by centrifugation. The obtained semiconductor nanoparticles were dispersed in octane.

Photoluminescence spectroscopy analysis and TGA were performed on the obtained semiconductor nanoparticles, and the results are summarized in Table 1.

A GC analysis was performed on the obtained semiconductor nanoparticle, and the results are summarized in Table 2. According to the GC-MS analysis, a first peak assigned to a phenylhexanoate moiety was observed at a retention time of 10.41 minutes, and a second peak assigned to an oleate moiety was observed at a retention time of 13.13 minutes.

Preparation Examples 3-1 and 3-2:

A semiconductor nanoparticle was prepared in the same manner as in Preparation Example 2, except that the amount of 6-phenylhexanoic acid (phenyl hexanoic acid, CAS No. 5581-75-9, manufactured by Sigma Aldrich) was doubled (Preparation Example 3-1) or quadrupled (Preparation Example 3-2).

The reactor was cooled to room temperature, and ethanol was added to the reaction solution to promote precipitation of the semiconductor nanoparticles, which were recovered by centrifugation. The obtained semiconductor nanoparticles were dispersed in octane.

Photoluminescence spectroscopy analysis and TGA were performed on the obtained semiconductor nanoparticles, and the results are summarized in Table 1.

A GC analysis was performed on the obtained semiconductor nanoparticles, and the results are summarized in Table 2. According to the GC-MS analysis, a first peak assigned to a phenylhexanoate moiety was observed at a retention time of 10.44 minutes, and a second peak assigned to an oleate moiety was observed at a retention time of 13.06 minutes.

Preparation Example 4:

A semiconductor nanoparticle was produced in the same manner as in Preparation Example 1 except for using 9-decenoic acid (9DeA) having the following chemical formula (9-Decenoic acid, CAS No. 14436-32-9, manufactured by Sigma Aldrich) instead of 4-phenylbutanoic acid.

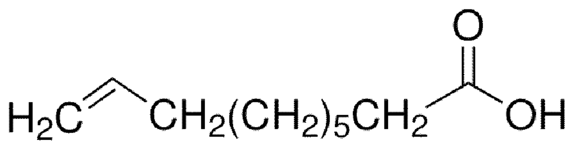

Photoluminescence spectroscopy analysis and TGA were performed on the obtained semiconductor nanoparticles, and the results were summarized in Table 1. GC analysis was performed on the obtained semiconductor nanoparticles, and the results were summarized in Table 2.

Comparative Preparation Example 1:

A semiconductor nanoparticle was prepared in the same manner as in Preparation Example 1, except that 4-phenylbutanoic acid (a first compound) was not used.

Photoluminescence spectroscopy analysis and TGA were performed on the obtained semiconductor nanoparticles, and the results were summarized in Table 1.

A GC analysis was performed on the obtained semiconductor nanoparticles, and the results were summarized in Table 2.

Comparative Preparation Example 2:

A semiconductor nanoparticle was produced in the same manner as in Preparation Example 1 except for using benzoic acid (BzA) having the following chemical formula (CAS No. 65-85-0, manufactured by Sigma Aldrich) instead of 4-phenylbutanoic acid:

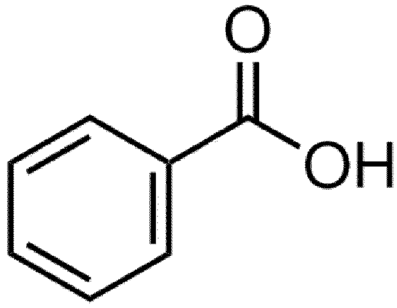

.

Photoluminescence spectroscopy analysis and TGA were performed on the obtained semiconductor nanoparticles, and the results were summarized in Table 1.
A GC analysis was performed on the obtained semiconductor nanoparticles, and the results were summarized in Table 2.

Comparative Preparation Example 3-1:

[1] A semiconductor nanoparticle was obtained in the same manner as in Preparation Example 1, except that 4-phenylbutanoic acid was not used.
[2] Surface Ligand Exchange (LE)

The semiconductor nanoparticle obtained above was dispersed in an organic solvent to obtain an organic dispersion of semiconductor nanocrystals. A solution containing benzoic acid (concentration: 10 wt%) was added to the organic dispersion of the prepared semiconductor nanocrystals, and surface exchange reaction was carried out by stirring at 60 °C for 30 minutes. After the reaction, ethanol was added to induce precipitation, and the semiconductor nanocrystals were recovered by centrifugation. The recovered semiconductor nanocrystals underwent the same surface exchange reaction again to obtain surface-exchanged semiconductor nanocrystals (semiconductor nanoparticles) including chloride and benzoate on the surface.
Photoluminescence spectroscopy analysis and TGA were performed on the obtained semiconductor nanoparticles, and the results were summarized in Table 1.
A GC-MS analysis was performed on the obtained semiconductor nanoparticles. It was confirmed that the mole ratio of benzoic acid-derived compounds to oleic acid-derived compounds in the obtained semiconductor nanoparticles was greater than about 3.2:1.

Comparative Preparation Example 3-2:

Zinc chloride was dissolved in ethanol to prepare a zinc chloride solution having a concentration of 10 wt%. The zinc chloride solution was added to the organic dispersion of the previously prepared semiconductor nanocrystals, and surface exchange reaction was carried out by stirring at 60 °C for 30 minutes. After the reaction, ethanol was added to induce precipitation, and the semiconductor nanocrystals were recovered by centrifugation. The recovered semiconductor nanocrystals underwent the same surface exchange reaction again to obtain chloride-treated semiconductor nanocrystals.
Subsequently, the chloride-treated semiconductor nanocrystals were dispersed in toluene to obtain an organic dispersion of semiconductor nanocrystals.
A solution containing benzoic acid (concentration: 10 wt%) was added to the organic dispersion of the prepared semiconductor nanocrystals, and surface exchange reaction was carried out by stirring at 60 °C for 30 minutes. After the reaction, ethanol was added to induce precipitation, and the semiconductor nanocrystals were recovered by centrifugation. The recovered semiconductor nanocrystals underwent the same surface exchange reaction again to obtain surface-exchanged semiconductor nanocrystals (semiconductor nanoparticles) including chloride and benzoate on the surface.
It was confirmed that the mole ratio of benzoic acid-derived compounds to oleic acid-derived compounds in the obtained semiconductor nanoparticles was greater than 3.2:1 (for example, greater than or equal to about 4:1).

Table 1

| | PWL (nm) | FWHM (nm) | QY(%) | Organic Content (wt%) | Residue content at 550°C (wt%) |
|---|---|---|---|---|---|
| Preparation Example 1 (4PhBA 0.6) | 459 | 40 | 96 | 12.3 | 87.3 |
| Preparation Example 2 (6PhHA 0.6) | 460 | 40 | 94 | 12.3 | 87.3 |
| Preparation Example 3-1 (6PhHA 1.2) | 459 | 40 | 92 | 12.5 | 87.1 |
| Preparation Example 3-2 (6PhHA 2.4) | 460 | 39 | 92 | 12.2 | 87.6 |
| Preparation Example 4 (9DeA 0.6) | 464 | 43 | 96 | 11.0 | 88.1 |
| Comp. Preparation Example 1 (not using, Ref.) OA only | 462 | 42 | 92 | 13.5 | 85.9 |
| Comp. Preparation Example 2 (BzA) | 462 | 42 | 92 | 11.5 | 88.0 |
| Comp. Preparation Example 3 (BzA surface exchange) | 461 | 42 | 58 | 9.4 | 90.0 |
| PWL: Emission Peak Wavelength<br>FWHM: Full Width at Half Maximum<br>QY: Absolute Quantum Yield | | | | | |

According to Table 1, the semiconductor nanoparticles of the examples exhibited desirable dispersibility while showing a lower organic content compared to Comparative Preparation Example 1. According to Table 1, it was confirmed that the semiconductor nanoparticles of the examples exhibited quantum efficiency comparable to or higher than those of Comparative Preparation Example 1 and Comparative Preparation Example 2. It was confirmed that the ligand-exchanged semiconductor nanoparticles of Comparative Preparation Example 3 exhibited significantly reduced luminescent properties compared to Comparative Preparation Example 1.

Table 2

| | Peak area of the second compound | Peak area of the first compound | Peak area of the first compound / Peak area of the second compound | A mole ratio of the first compound to the second compound |
|---|---|---|---|---|
| Preparation Example 1 (4PhBA 0.6) | 100 | 27.04 | 0.2704 | 0.45 |
| Preparation Example 2 (6PhHA 0.6) | 100 | 33.25 | 0.3325 | 0.47 |
| Preparation Example 3-1 (6PhHA 1.2) | 100 | 53.47 | 0.5347 | 0.77 |
| Preparation Example 3-2 (6PhHA 2.4) | 70.26 | 100 | 1.4232 | 2.02 |
| Preparation Example 4 (9DeA 0.6) | 100 | 26.52 | 0.2652 | 0.43 |
| Comp. Preparation Example 1 (not using, Ref.) | 100 | 0 | 0 | 0 |
| Comp. Preparation Example 2 (BzA) | 100 | 9 | 0.09 | 0.19 |

The mole ratio of the first compound to the second compound was calculated based on the organic content obtained from TGA, the area ratio (weight ratio) of the chromatogram obtained from GC-MS results, and the molecular weights (g/mol) of the first and second compounds.

Experimental Example 1

Using HSPiP (Hansen Solubility Parameters in Practice), Hansen solubility parameters (i.e., dispersion solubility parameter, polar solubility parameter, and hydrogen bonding parameter) were obtained for the moiety excluding the COO group from the first compound, phenylhexanoic acid (hereinafter referred to as the first moiety), and for the moiety excluding the COO group from the second compound, oleic acid (hereinafter referred to as the second moiety).

For a predetermined solvent, cyclohexylbenzene, Hansen solubility parameters were also calculated using

HSPiP. The Hansen solubility parameter distance between the moieties (excluding the COO groups) of the first and second compounds and cyclohexylbenzene was calculated while varying the mole fraction of the first moiety relative to the total amount of the first and second moieties to 0%, 20%, 40%, 60%, 80%, and 100%. The results were shown in FIG. 9A.

Hansen solubility parameters were obtained for a mixed solvent comprising cyclohexylbenzene, hexadecane, and octylbenzene. The Hansen solubility parameter distance between the moieties excluding the COO groups of the first and second compounds and the mixed solvent was calculated while varying the mole fraction of the first moiety relative to the total amount of the first and second moieties to 0%, 20%, 40%, 60%, 80%, and 100%. The results were shown in FIG. 9B.

From FIGs. 9A and 9B, it was confirmed that the Hansen solubility parameter distance (Ra) between the first and second moieties (or semiconductor nanoparticles containing them) and the solvent could be controlled to be less than about 4.

## Device Examples

### Example 1

An electroluminescent device having a structure of ITO/PEDOT:PSS (300 Å)/TFB (250 Å)/semiconductor nanoparticle emission layer (360 Å)/ZnMgO (240 Å)/Al was fabricated using the semiconductor nanoparticles prepared in Preparation Example 1, and its electroluminescent properties were measured as follows:

On a glass substrate on which an ITO electrode (a first electrode) was deposited, PEDOT:PSS and TFB layers were formed by spin coating as a hole injection layer and a hole transport layer, respectively. On the formed TFB layer (25 nm), a semiconductor nanoparticle solution prepared in Preparation Example 1 was spin-coated to form an emission layer. On the emission layer, a zinc magnesium oxide nanoparticle layer was formed as the electron auxiliary layer, and then an Al electrode was deposited to fabricate the electroluminescent device.

The electroluminescent properties and lifetime of the fabricated device were measured. The lifetime characteristics are summarized in Table 3.

### Example 2

An electroluminescent device was manufactured in the same manner as in Example 1 except that the semiconductor nanoparticle of Preparation Example 2 was used. The electroluminescent properties and lifetime of the fabricated device were measured. The lifetime characteristics are summarized in Table 3 below.

### Example 3

An electroluminescent device was manufactured in the same manner as in Example 1, except that the semiconductor nanoparticle produced in Preparation Example 3 was used. The electroluminescent properties and lifetime of the fabricated device were measured. The lifetime characteristics are summarized in Table 3 below.

### Example 4

An electroluminescent device was manufactured in the same manner as in Example 1, except that the semiconductor nanoparticle produced in Preparation Example 4 wase used. The electroluminescent properties and lifetime of the fabricated device were measured. The lifetime characteristics are summarized in Table 3 below.

### Comparative Example 1

An electroluminescent device was manufactured in the same manner as in Example 1, except that the semiconductor nanoparticle produced in Comparative Preparation Example 1 was used. The electroluminescent properties and lifetime of the fabricated device were measured. The lifetime characteristics are summarized in Table 3 below.

### Comparative Example 2

An electroluminescent device was manufactured in the same manner as in Example 1, except that the semiconductor nanoparticle produced in Comparative Preparation Example 2 was used. The electroluminescent properties and lifetime of the fabricated device were measured. The lifetime characteristics are summarized in Table 3 below.

Comparative Example 3-1

An electroluminescent device was manufactured in the same manner as in Example 1, except that the semiconductor nanoparticle produced in Comparative Preparation Example 3 was used. The electroluminescent properties and lifetime of the fabricated device were measured. The lifetime characteristics are summarized in Table 3 below.

Comparative Example 3-2

An electroluminescent device was manufactured in the same manner as in Example 1, except that the semiconductor nanoparticle produced in Comparative Preparation Example 3-2 was used. The electroluminescent properties and lifetime of the fabricated device were measured. The lifetime characteristics are summarized in Table 3 below

Table 3

| | Relative Max. T90 |
|---|---|
| Example 1 | 225% |
| Example 2 | 300% |
| Example 3 | 440% |
| Example 4 | 250% |
| Comp. Example 1 (Ref.) | 100% |
| Comp. Example 2 (BzA) | 50% |
| Comp. Example 3-1 (BzA post treatment) | 75% |
| Comp. Example 3-2 (Cl-BzA post treatment) | 150% |
| Relative T90: T90 (in hours) of the device operated at an initial luminance of 146 nit / the T90 of the device of Comparative Example 1. | |

From the results in Table 1 and Table 3, it was confirmed that the electroluminescent devices of the examples could exhibit improved electroluminescent properties and extended lifetime compared to the devices of the comparative examples.

Regarding electroluminescent properties, it was confirmed that the devices of Examples 1 to 3 could exhibit similar or equivalent or higher electroluminescent performance (EQE and luminance) compared to the device of Comparative Example 1. The device of Comparative Example 2 was confirmed to exhibit clearly reduced EQE and luminance compared to the device of Comparative Example 1 despite that the semiconductor nanoparticle prepared in Comparative preparation Example 2 exhibit substantially the same QY as that of Comparative preparation Example 1.

Experimental Example 2 (Hole Only Device, HOD fabrication)

HOD 1, HOD 3, and HOD 4 (Ref.) were fabricated in the same manner as Examples 1, 3, and Comparative Example 1, respectively, except that a small molecule organic hole transport material (e.g., LG101) was used to form a hole auxiliary layer instead of the electron transport layer, and the thickness of the semiconductor nanoparticle emission layer was set to 40 nm. A voltage ranging from 0 V to 8 V was applied three times to the fabricated devices, and the hole transport ability (current density at 5 V during the third sweep, in $mA/cm^2$) was measured. The results were summarized in FIG. 10.

It was confirmed that HOD 1 and HOD 3, which include the semiconductor nanoparticles from Preparation Examples 1 and 3, respectively, exhibited significantly improved hole transport characteristics compared to HOD 4 (Ref.), which includes the semiconductor nanoparticles from Comparative Preparation Example 1.

Experimental Example 3

Semiconductor nanoparticles obtained from Comparative Preparation Example 1 were dispersed in cyclohexylbenzene to prepare an ink composition. Except for using the obtained ink composition, an emission layer was formed in the same manner as in Example 1. It was confirmed that significant aggregation occurred in the formed emission layer.

Semiconductor nanoparticles obtained from Comparative Preparation Example 3-2 were dispersed in cyclohexylbenzene to prepare an ink composition. Except for using the obtained ink composition, an emission layer was formed

in the same manner as in Example 1. It was confirmed that the emission layer was formed without substantial aggregation.

While this disclosure has been described in connection with what is presently considered to be practical embodiments, it is to be understood that the invention is not limited to the disclosed embodiments. On the contrary, it is intended to cover various modifications and equivalent arrangements included within the scope of the appended claims.

## Claims

**1.** A semiconductor nanoparticle,

wherein the semiconductor nanoparticle is configured to emit light in response to an external stimulus,
wherein the semiconductor nanoparticle includes a semiconductor nanocrystal comprising zinc and selenium; and a semiconductor nanocrystal layer comprising zinc and sulfur and on the semiconductor nanocrystal,
wherein the semiconductor nanoparticle further comprises a first compound and a second compound,
wherein the first compound includes a first functional group; and an aromatic hydrocarbon group or an aliphatic hydrocarbon group, the aliphatic hydrocarbon group having a terminal double bond,
wherein the second compound includes a second functional group and an aliphatic hydrocarbon group,
wherein the first functional group and the second functional group each independently comprise a carboxylic acid or an anion of the carboxylic acid,
wherein in gas chromatography-mass spectrometry of the semiconductor nanoparticle, the first compound and the second compound exhibit a first peak and a second peak, respectively,
a retention time of the second peak is greater than a retention time of the first peak, and
a ratio of an area of the first peak to an area of the second peak is greater than or equal to 0.1:1 and less than or equal to 3:1

**2.** The semiconductor nanoparticle of Claim 1, wherein
the semiconductor nanocrystal comprises a zinc selenide, a zinc tellurium selenide, or a combination thereof.

**3.** The semiconductor nanoparticle of Claims 1 or 2, wherein a molecular weight of the second compound is greater than a molecular weight of the first compound; and/or
wherein a difference in molecular weight between the first compound and the second compound is greater than or equal to 90 grams per mole and less than or equal to 150 grams per mole.

**4.** The semiconductor nanoparticle of any of Claims 1-3, wherein the first compound has a molecular weight greater than or equal to 150 grams per mole and less than or equal to 500 grams per mole, and the second compound has a molecular weight greater than or equal to 180 grams per mole and less than or equal to 600 grams per mole;
preferably wherein the first compound has a molecular weight greater than or equal to 165 grams per mole and less than or equal to 400 grams per mole, and the second compound has a molecular weight greater than or equal to 260 grams per mole and less than or equal to 550 grams per mole.

**5.** The semiconductor nanoparticle of any of Claims 1-4, wherein

the first compound further comprises a linker connecting the first functional group and the aromatic hydrocarbon group,
and the linker comprises a substituted or unsubstituted hydrocarbon group having greater than or equal to C3 and less than or equal to C19 carbon atoms.

**6.** The semiconductor nanoparticle of any of Claims 1-5, wherein

the first compound includes a substituted or unsubstituted phenylhexanoic acid, a substituted or unsubstituted phenylhexanoate, a substituted or unsubstituted phenylpentanoic acid, a substituted or unsubstituted phenylpentanoate, a substituted or unsubstituted phenylbutanoic acid, a substituted or unsubstituted phenylbutanoate, a substituted or unsubstituted phenylisopropanoic acid, a substituted or unsubstituted phenylisopropanoate, a substituted or unsubstituted phenylpropanoic acid, a substituted or unsubstituted phenylpropanoate, a substituted or unsubstituted 9-decenoic acid, a substituted or unsubstituted 9-decenoate, a substituted or unsubstituted 10-undecenoic acid, a substituted or unsubstituted 10-undecenoate, a substituted or unsubstituted 11-dodecenoic acid, a substituted or unsubstituted 11-dodecenoate, or a combination thereof,
and the second compound includes an oleic acid, an oleate, a myristic acid, a myristate, a stearic acid, a stearate,

a lauric acid, a laurate, or a combination thereof.

**7.** The semiconductor nanoparticle of any of Claims 1-6, wherein
in gas chromatography-mass spectrometry of the semiconductor nanoparticle, a ratio of an area of the first peak to an area of the second peak is greater than or equal to 0.5:1 and less than or equal to 1.45:1.

**8.** The semiconductor nanoparticle of any of Claims 1-7, wherein the semiconductor nanoparticle has an organic content that is greater than or equal to 9.5 weight percent and less than or equal to 13 weight percent, as determined by thermogravimetric analysis; and/or
wherein the semiconductor nanoparticle has an absolute quantum yield that is greater than or equal to 80%, and the semiconductor nanoparticle has a chlorine content that is less than or equal to 10% based on a total mole number of sulfur.

**9.** An ink composition comprising the semiconductor nanoparticle of any of Claims 1-8 and a solvent,

wherein, in the semiconductor nanoparticle, a Hansen solubility parameter distance (Ra) of the first compound and the second compound with respect to the solvent is greater than 0 and less than 4,
and the Ra satisfies the following equation:

$$Ra^2 = 4\,(\delta D_1 - \delta D_2)^2 + (\delta P_1 - \delta P_2)^2 + (\delta H_1 - \delta H_2)^2$$

Ra: Hansen solubility parameter distance
$\delta D_1$: dispersion solubility parameter of moieties, excluding a COO group, of the first compound and the second compound
$\delta D_2$: the dispersion solubility parameter of the solvent
$\delta P_1$: polar solubility parameter of moieties excluding a COO group of the first compound and the second compound
$\delta P_2$: polar solubility parameter of the solvent
$\delta H_1$: hydrogen bond parameter of moieties, excluding a COO group, of the first compound and the second compound
$\delta H_2$: hydrogen bond parameter of the solvent.
preferably wherein
the solvent is a substituted or unsubstituted C5-C40 cycloaliphatic hydrocarbon solvent, a substituted or unsubstituted C5-C40 aliphatic hydrocarbon solvent, a substituted or unsubstituted C5-C40 alicyclic hydrocarbon solvent, a substituted or unsubstituted C6-C50 aromatic hydrocarbon solvent, a substituted or unsubstituted C5-C40 aliphatic ester solvent, or a combination thereof,
and optionally, the solvent has a boiling point of greater than or equal to 200°C and less than or equal to 350°C.

**10.** A method for manufacturing a semiconductor nanoparticle of any of Claims 1-8, which comprises:

preparing the semiconductor nanocrystal; and
heating a reaction medium including the semiconductor nanocrystal, a zinc precursor, a sulfur precursor, the first compound, and the second compound in an organic solvent to form the semiconductor nanocrystal layer including zinc and sulfur on the semiconductor nanocrystal.

**11.** The method of Claim 10, wherein
forming of the semiconductor nanocrystal layer comprises:

reacting a first medium including the semiconductor nanocrystal, the zinc precursor, the sulfur precursor, and the second compound at a reaction temperature; and
adding the first compound to the first medium;
preferably wherein:

the addition of the first compound is performed at a temperature greater than or equal to 180°C and less than the reaction temperature; and/or
the second compound is included in the zinc precursor, and/or a mole ratio of the first compound to the zinc

precursor is greater than or equal to 0.1:1 and less than or equal to 5:1.

**12.** The method of Claims 10 or 11, wherein

the first compound includes a substituted or unsubstituted phenylhexanoic acid, a substituted or unsubstituted phenylhexanoate, a substituted or unsubstituted phenylpentanoic acid, a substituted or unsubstituted phenylpentanoate, a substituted or unsubstituted phenylbutanoic acid, a substituted or unsubstituted phenylbutanoate, a substituted or unsubstituted phenylisopropanoic acid, a substituted or unsubstituted phenylisopropanoate, a substituted or unsubstituted phenylpropanoic acid, a substituted or unsubstituted phenylpropanoate, a substituted or unsubstituted 9-decenoic acid, a substituted or unsubstituted 9-decenoate, a substituted or unsubstituted 10-undecenoic acid, a substituted or unsubstituted 10-undecenoate, a substituted or unsubstituted 11-dodecenoic acid, a substituted or unsubstituted 11-dodecenoate, or a combination thereof,
and the second compound includes an oleic acid, an oleate, a myristic acid, a myristate, a stearic acid, a stearate, a lauric acid, a laurate, or a combination thereof.

**13.** An electroluminescent device,

wherein the electroluminescent device includes a hole transport layer and an electron transport layer, and an emission layer disposed between the hole transport layer and the electron transport layer,
wherein the emission layer includes the semiconductor nanoparticle of any of Claims 1-8.

**14.** The electroluminescent device of Claim 13,

wherein the hole transport layer comprises poly(9,9-dioctylfluorene-co-N-(4-butylphenyl)diphenylamine) (TFB), polyarylamine, poly(N-vinylcarbazole), poly(3,4-ethylenedioxythiophene) : polystyrene sulfonate (PEDOT:PSS), polyaniline, polypyrrole, a fluorene aryl amine compound, N,N,N',N'-tetrakis(4-methoxyphenyl)benzidine, 4,4'-bis[N-(1-naphthyl)-N-phenyl-amino]biphenyl ($\alpha$-NPD), 4,4',4"-tris[phenyl(m-tolyl)amino]triphenylamine (m-MTDATA), 4,4',4"-tris(N-carbazolyl)-triphenylamine (TCTA), 1,1-bis[di(4-tolyl)aminophenyl]cyclohexane (TAPC), NiO, $WO_3$, $MoO_3$, graphene oxide, or a combination thereof,
and the electron transport layer comprises 1,4,5,8-naphthalene-tetracarboxylic dianhydride (NTCDA), bathocuproine (BCP), tris[3-(3-pyridyl)mesityl]borane (3TPYMB), LiF, tris(8-hydroxyquinoline)aluminum ($Alq_3$), tris(8-hydroxyquinoline)gallium ($Gaq_3$), tris(8-hydroxyquinoline)indium ($Inq_3$), bis(8-hydroxyquinoline)zinc ($Znq_2$), bis(2-(2-hydroxyphenyl)benzothiazolate)zinc ($Zn(BTZ)_2$), bis(10-hydroxybenzo[h]quinolinato)beryllium ($BeBq_2$), 8-(4-(4,6-di(naphthalen-2-yl)-1,3,5-triazin-2-yl)phenyl)quinolone (ET204), 8-hydroxyquinolinato lithium (Liq), a zinc oxide nanoparticle, n-type doped zinc metal oxide nanoparticles, hafnium oxide nanoparticles, or a combination thereof.

**15.** The electroluminescent device of Claims 13 or 14,
wherein the semiconductor nanoparticle has a chlorine content that is less than or equal to 10% based on a total mole number of sulfur.

FIG. 1

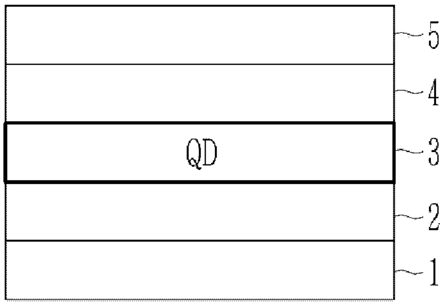


FIG. 2

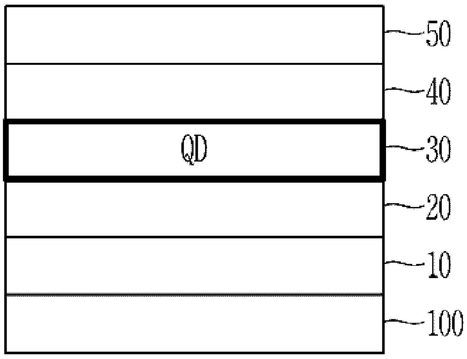


FIG. 3

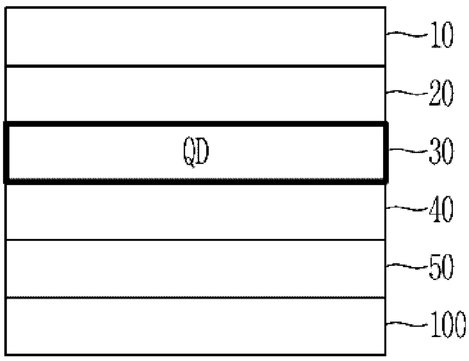

FIG. 4

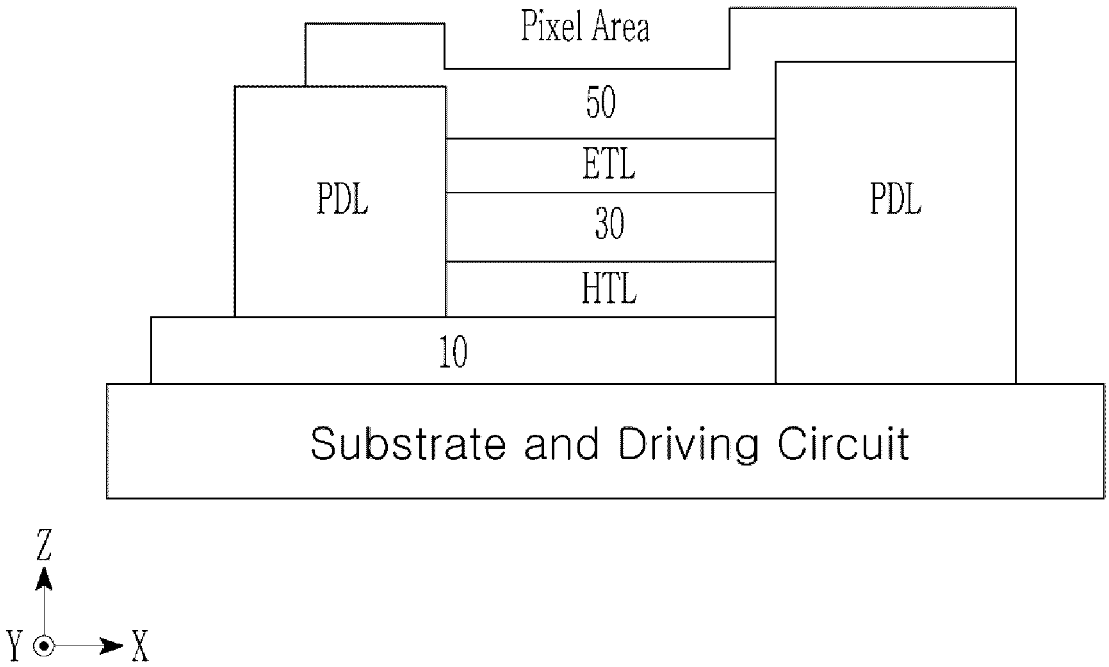
Pixel Area
50
ETL
PDL
30
PDL
HTL
10
Substrate and Driving Circuit
Z
Y
X

FIG. 5

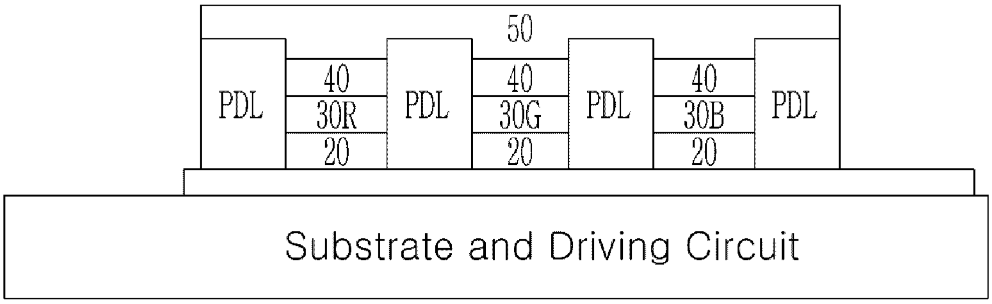
50
PDL
40
30R
20
PDL
40
30G
20
PDL
40
30B
20
PDL
Substrate and Driving Circuit

FIG. 6

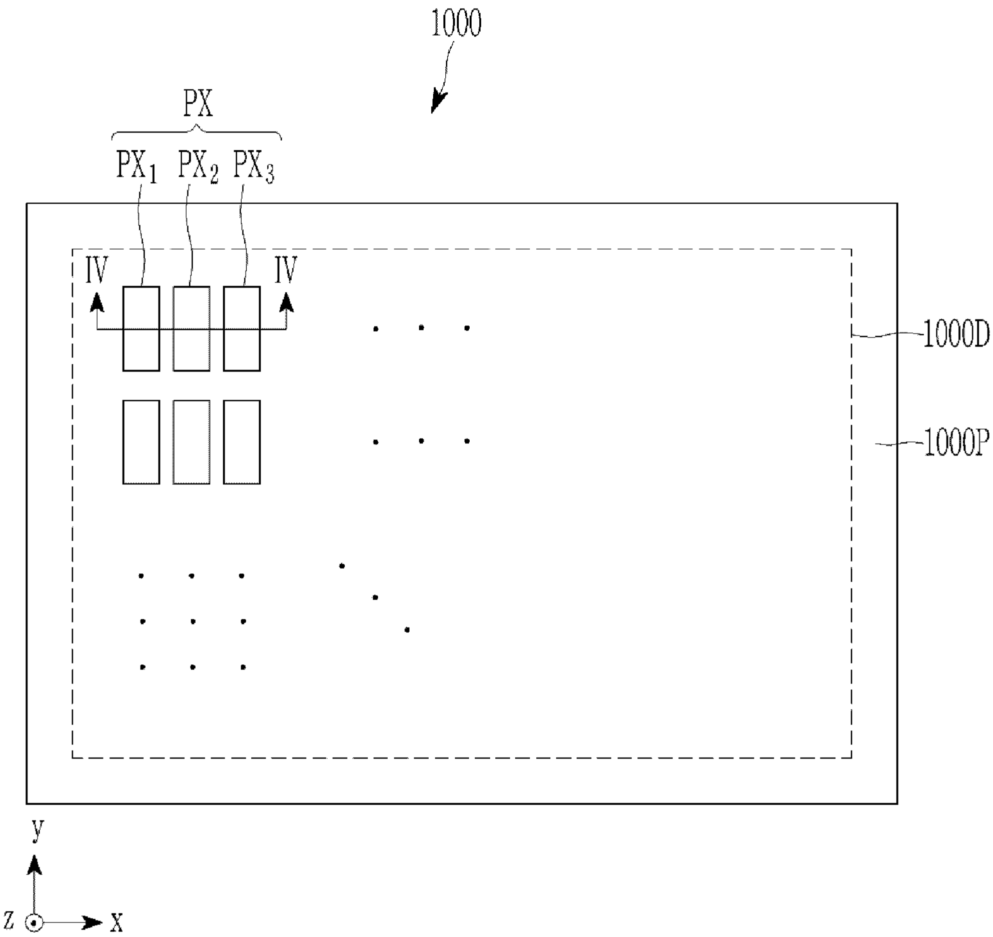

FIG. 7

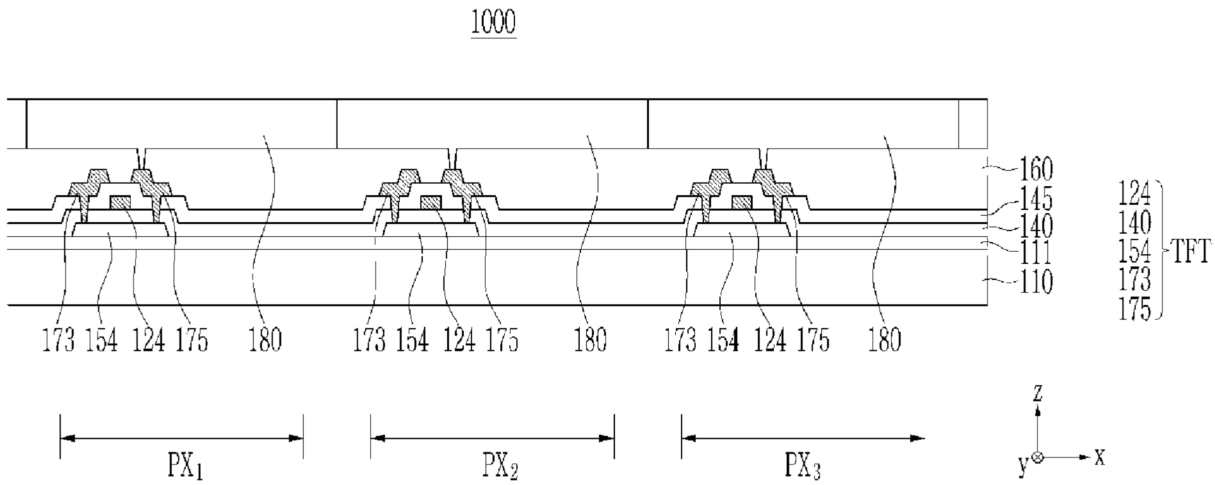
1000
160
145
140
111
110
124
140
154
173
175
TFT
173 154 124 175
180
173 154 124 175
180
173 154 124 175
180
PX1
PX2
PX3
z
y
x

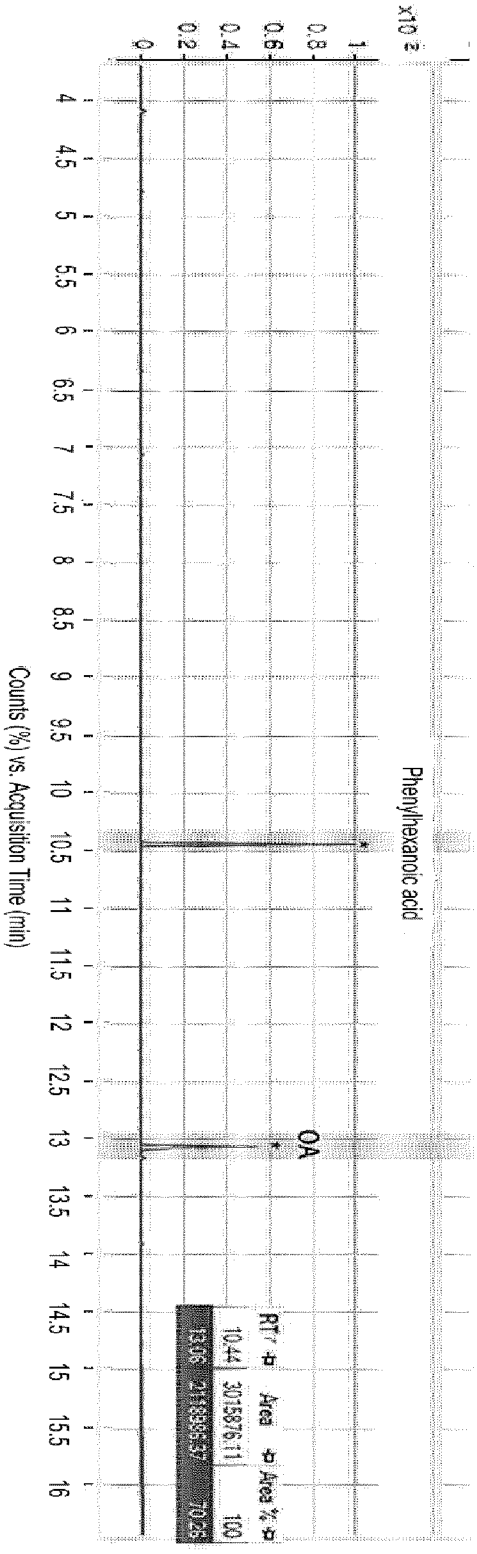
x10 2
1
0.8
0.6
0.4
0.2
0
Phenylhexanoic acid
OA
RT Area Area %
10.44 3015876.11 100
4 4.5 5 5.5 6 6.5 7 7.5 8 8.5 9 9.5 10 10.5 11 11.5 12 12.5 13 13.5 14 14.5 15 15.5 16
Counts (%) vs. Acquisition Time (min)

FIG. 8

FIG. 9A

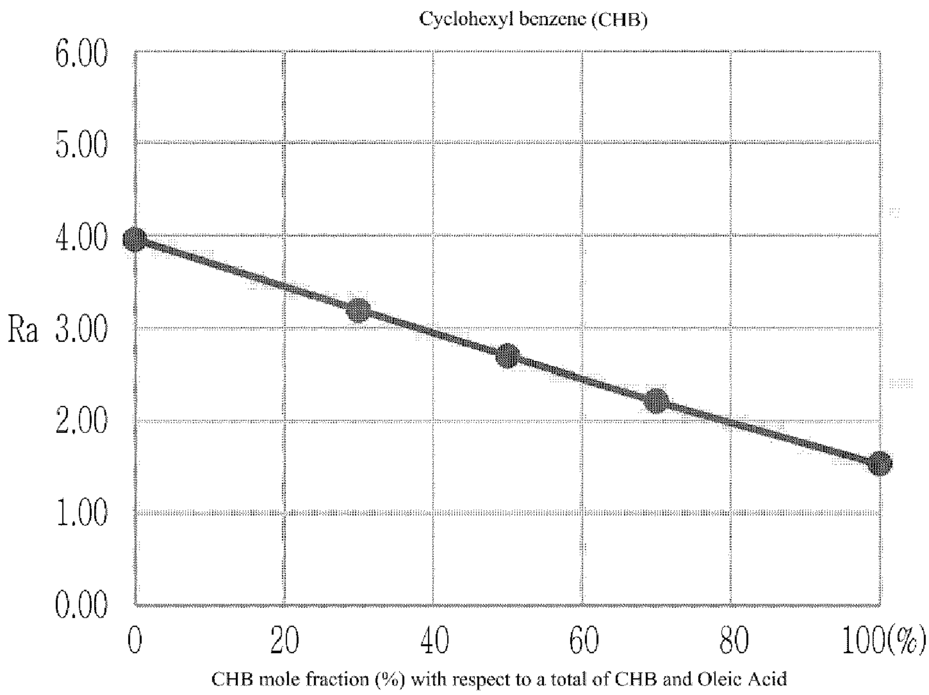
Cyclohexyl benzene (CHB)
6.00
5.00
4.00
Ra 3.00
2.00
1.00
0.00
0
20
40
60
80
100(%)
CHB mole fraction (%) with respect to a total of CHB and Oleic Acid

FIG. 9B

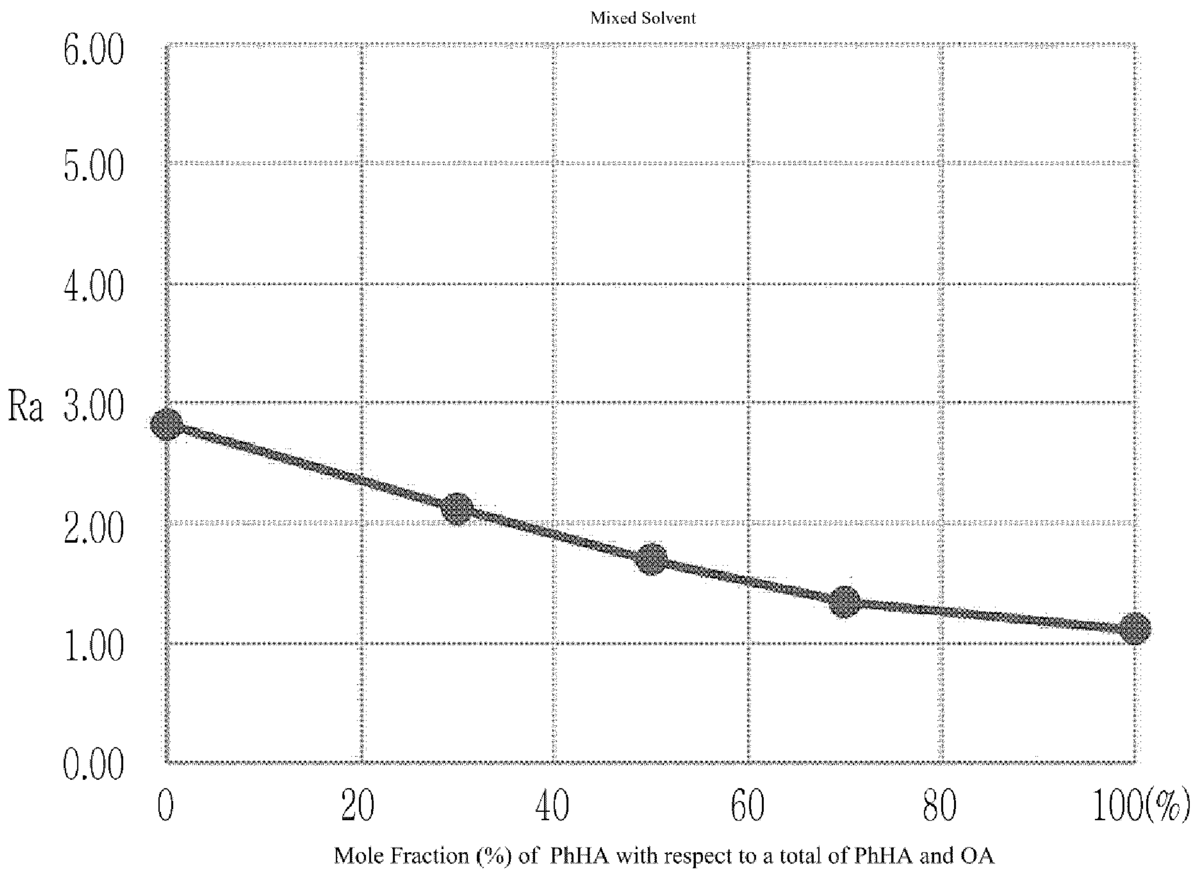
Mixed Solvent
6.00
5.00
4.00
Ra 3.00
2.00
1.00
0.00
0
20
40
60
80
100(%)
Mole Fraction (%) of PhHA with respect to a total of PhHA and OA

FIG. 10

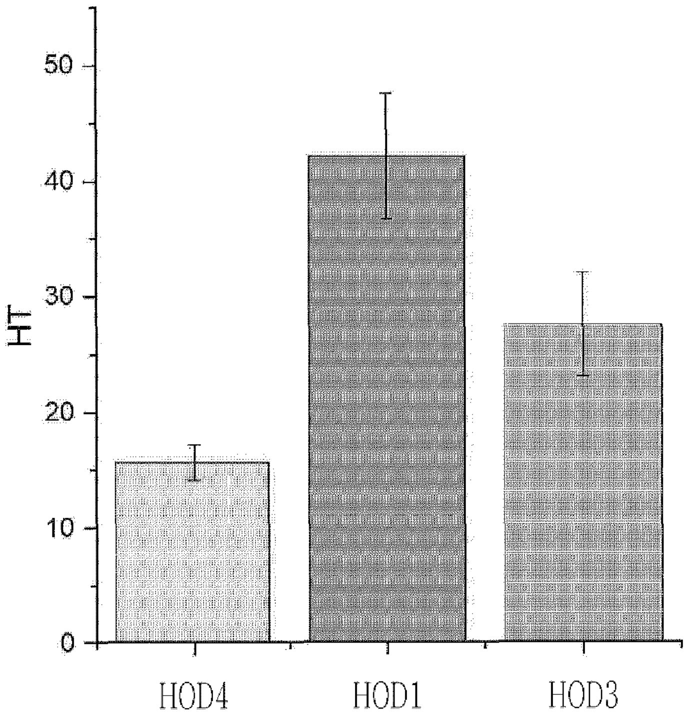

Europäisches Patentamt
European Patent Office
Office européen des brevets

# EUROPEAN SEARCH REPORT

Application Number
EP 25 19 1015

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CHOI HYUNG-SEOK ET AL: "Enhanced Electroluminescence via a Nanohybrid Material Consisting of Aromatic Ligand-Modified InP Quantum Dots and an Electron-Blocking Polymer as the Single Active Layer in Quantum Dot-LEDs", NANOMATERIALS, vol. 12, no. 3, 1 February 2022 (2022-02-01), page 408, XP093175656, ISSN: 2079-4991, DOI: 10.3390/nano12030408 * figure 2, figure 4; InP/ZnSe/ZnS QDs * ----- | 1-15 | INV. C09K11/02 C09K11/08 C09K11/88 H05B33/10 H05B33/18 |
| A | US 2021/269715 A1 (MIN JIHYUN [KR] ET AL) 2 September 2021 (2021-09-02) * table 4; example 2: Znse/ZnS * * 112: butanoic acid * * the whole document * ----- | 1-15 | |
| A | US 2021/115333 A1 (MIN JIHYUN [KR] ET AL) 22 April 2021 (2021-04-22) * example 2: ZnTeSe/ZnS 147: butanoic acid * * the whole document * ----- | 1-15 | TECHNICAL FIELDS SEARCHED (IPC) C09K H05B |
| A | US 2017/066965 A1 (TRUSKIER JONATHAN [US] ET AL) 9 March 2017 (2017-03-09) * example 1: ZnSe/ZnS core/shell QDs * * the whole document * ----- | 1-15 | |
| A | CN 116 694 328 A (UNIV NANJING SCIENCE & TECH) 5 September 2023 (2023-09-05) * example 1: ZnSe-ZnTe0.8Se0.2-ZnSe-ZnS * * the whole document * ----- -/-- | 1-15 | |

The present search report has been drawn up for all claims

1

| Place of search | Date of completion of the search | Examiner |
|---|---|---|
| The Hague | 14 November 2025 | Ziegler, Jan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

page 1 of 2

Europäisches Patentamt
European Patent Office
Office européen des brevets

# EUROPEAN SEARCH REPORT

Application Number
EP 25 19 1015

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JP 7 483645 B2 (DONGWOO FINE CHEM CO LTD) 15 May 2024 (2024-05-15)<br>* claims; InP/ZnSe/ZnS, InP/ZnSeTe/ZnS *<br>* the whole document *<br>----- | 1-15 | |

TECHNICAL FIELDS SEARCHED (IPC)

The present search report has been drawn up for all claims

1

| Place of search | Date of completion of the search | Examiner |
|---|---|---|
| The Hague | 14 November 2025 | Ziegler, Jan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO.

EP 25 19 1015

This annex lists the patent family members relating to the patent documents cited in the above-mentioned European search report. The members are as contained in the European Patent Office EDP file on
The European Patent Office is in no way liable for these particulars which are merely given for the purpose of information.

14-11-2025

| Patent document cited in search report | Publication date | Patent family member(s) | Publication date |
|---|---|---|---|
| US 2021269715 A1 | 02-09-2021 | KR 20210110232 A | 07-09-2021 |
| | | US 2021269715 A1 | 02-09-2021 |
| | | US 2023303924 A1 | 28-09-2023 |
| US 2021115333 A1 | 22-04-2021 | CN 112680210 A | 20-04-2021 |
| | | EP 3809480 A1 | 21-04-2021 |
| | | KR 20210045949 A | 27-04-2021 |
| | | US 2021115333 A1 | 22-04-2021 |
| | | US 2023220279 A1 | 13-07-2023 |
| US 2017066965 A1 | 09-03-2017 | EP 3347433 A1 | 18-07-2018 |
| | | KR 20180052679 A | 18-05-2018 |
| | | US 2017066965 A1 | 09-03-2017 |
| | | WO 2017044597 A1 | 16-03-2017 |
| CN 116694328 A | 05-09-2023 | NONE | |
| JP 7483645 B2 | 15-05-2024 | JP 7482810 B2 | 14-05-2024 |
| | | JP 7483645 B2 | 15-05-2024 |
| | | JP 2021128341 A | 02-09-2021 |
| | | JP 2021128342 A | 02-09-2021 |
| | | KR 20210102828 A | 20-08-2021 |
| | | KR 20210102841 A | 20-08-2021 |

EPO FORM P0459

For more details about this annex : see Official Journal of the European Patent Office, No. 12/82